# EUROPEAN PATENT APPLICATION

(11) **EP 4 212 592 A1**
(43) Date of publication of application: **19.07.2023**
(21) Application number: 21866571.9
(22) Date of filing: 27.08.2021
(51) Int. Cl.: C09B 47/08, G03F 7/004, G02B 5/20, C09B 67/20

(54) **COLORED RESIN COMPOSITION**

(30) Priority: 08.09.2020 JP 2020150532
(71) Applicant: SUMITOMO CHEMICAL COMPANY, LIMITED, Tokyo 103-6020 (JP)
(72) Inventor: KUROGI, Takahiro, Osaka-shi, Osaka 554-8558 (JP); AOKI, Takuma, Osaka-shi, Osaka 554-8558 (JP); NAKAYAMA, Tomohiro, Osaka-shi, Osaka 554-8558 (JP); AKASAKA, Tetsuo, Osaka-shi, Osaka 554-8558 (JP); TOGAI, Manabu, Osaka-shi, Osaka 554-8558 (JP)
(74) Representative: Vossius & Partner Patentanwälte Rechtsanwälte mbB
(86) International application number: PCT/JP2021/031583
(87) International publication number: WO 2022/054612

(57) **Abstract**

The object of the present invention is to provide a colored resin composition containing an aluminum phthalocyanine pigment capable of forming a colored coating film with no foreign matter (preferably a colored coating film with no foreign matter and good adhesion). The colored resin composition of the present invention contains a colorant, a compound represented by formula (DA), a resin, and a solvent, wherein the colorant contains an aluminum phthalocyanine pigment. 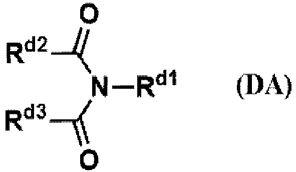 [In formula (DA), R^{d1} represents a hydrocarbon group having 1 to 12 carbon atoms and optionally having a substituent. When the hydrocarbon group has 2 to 12 carbon atoms and the hydrocarbon group has -CH₂-, -CH₂- may be substituted with -O-, -S-, or -CO-. R^{d2} and R^{d3} each independently represent a hydrogen atom or a hydrocarbon group having 1 to 12 carbon atoms and optionally having a substituent, or R^{d2} and R^{d3} are combined to form a ring together with -CO-NR^{d1}-CO-.]

## Description

### TECHNICAL FIELD

The present invention relates to a colored resin composition, a color filter, a display device and a solid-state image sensor.

### BACKGROUND ART

An optical filter used for display devices such as a liquid crystal display device, an electroluminescence display device, and a plasma display, and solid-state image sensors such as a CCD and a CMOS sensor is produced from a colored resin composition. An aluminum phthalocyanine pigment is known as a colorant for such a colored resin composition. Patent Document 1 discloses a colored composition for a color filter containing an aluminum phthalocyanine pigment.

On the other hand, Patent Document 2 describes that an additive having a specific structure represented by general formula (1) is applied to improve the flow characteristics of a colored composition in which nanomaterials such as nano organic pigments and dyes are dispersed, to achieve a dispersion state with low viscosity, low thixotropic properties, and stability over time, and to obtain a high-quality colored composition with little influence or change in electrical resistance value.

### PRIOR ART DOCUMENT

### PATENT DOCUMENT

Patent Document 1: JP 2016-075837 (A)
Patent Document 2: JP 2018-150498 (A)

### SUMMARY OF THE INVENTION

### PROBLEMS TO BE SOLVED BY THE INVENTION

The inventors have examined a colored resin composition containing an aluminum phthalocyanine pigment, and have found that foreign matter tends to be generated when colored coating films are formed. Also, the colored coating film formed has been found to be easily peeled off.

Therefore, the object of the present invention is to provide a colored resin composition containing an aluminum phthalocyanine pigment capable of forming a colored coating film without generation of foreign matter (preferably a colored coating film with no generation of foreign matter and good adhesion).

### SOLUTIONS TO THE PROBLEMS

The present invention includes the following inventions.
[1] A colored resin composition comprising a colorant, a compound represented by formula (DA), a resin, and a solvent, wherein the colorant comprises an aluminum phthalocyanine pigment. 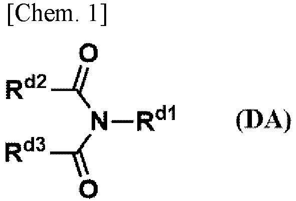 [In formula (DA),
   R^{d1} represents a hydrocarbon group having 1 to 12 carbon atoms and optionally having a substituent. When the hydrocarbon group has 2 to 12 carbon atoms and the hydrocarbon group has -CH₂-, -CH₂- may be substituted with -O-, -S- or -CO-.
   R^{d2} and R^{d3} each independently represent a hydrogen atom or a hydrocarbon group having 1 to 12 carbon atoms and optionally having a substituent, or R^{d2} and R^{d3} are combined to form a ring together with -CO-NR^{d1}-CO-.]
[2] The colored resin composition according to the above [1], wherein the aluminum phthalocyanine pigment is a compound represented by formula (Xa) or formula (Xb). 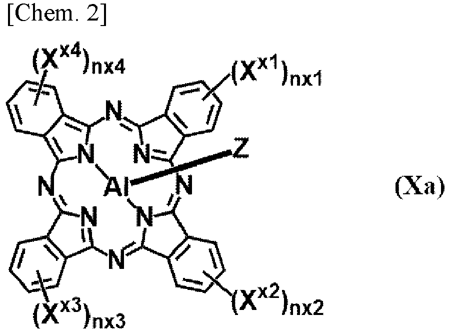 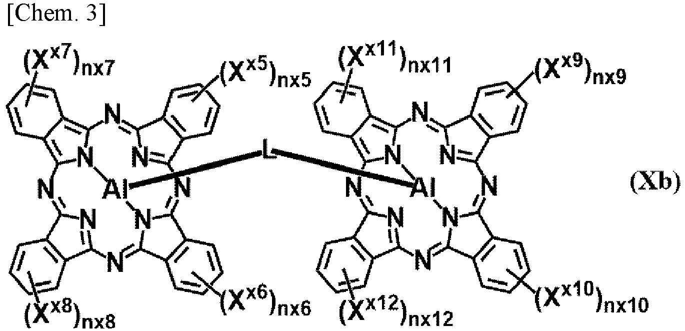
   [In formula (Xa),
      Z represents a hydroxy group, a chlorine atom, -OP(=O)R^{a1}R^{a2}, or -O-SiR^{a3}R^{a4}R^{a5}.
      R^{a1} to R^{a5} each independently represent a hydrogen atom, a hydroxy group, a hydrocarbon group having 1 to 21 carbon atoms and optionally having a substituent, and any two of R^{a1} and R^{a2} or R^{a3} to R^{a5} may be combined with each other to form a ring. When the hydrocarbon group has 2 to 21 carbon atoms and the hydrocarbon group has -CH₂-, -CH₂- may be substituted with -O-, -S- or -CO-.
      X^{x1} to X^{x4} each independently represent -R^{x4}, -OR^{x4}, -SR^{x4}, a halogen atom, a nitro group, or a sulfamoyl group optionally having a substituent.
      R^{x4} represents a hydrocarbon group having 1 to 20 carbon atoms and optionally having a substituent, and when the hydrocarbon group has 2 to 21 carbon atoms and the hydrocarbon group has -CH₂-, -CH₂- may be substituted with -O-, -S- or -CO-.
      nx1 to nx4 independently represent an integer from 0 to 4.
   In formula (Xb),
      L represents -O-SiR^{a6}R^{a7}-O-, -O-SiR^{a8}R^{a9}-O- SiR^{a10}R^{a11}-O-, or -O-P(=O)R^{a12}-O-.
      R^{a6} to R^{a12} each independently represent a hydrogen atom, a hydroxy group, a hydrocarbon group having 1 to 21 carbon atoms and optionally having a substituent, and R^{a6} and R^{a7}, R^{a8} and R^{a9}, or R^{a10} and R^{a11} may be combined with each other to form a ring. When the hydrocarbon group has 2 to 21 carbon atoms and the hydrocarbon group has -CH₂-, -CH₂- may be substituted with -O-, -S- or -CO-.
      X^{x5} to x^{x12} each independently represent -R^{x5}, -OR^{x5}, -SR^{x5}, a halogen atom, a nitro group, or a sulfamoyl group optionally having a substituent.
      R^{x5} represents a hydrocarbon group having 1 to 20 carbon atoms and optionally having a substituent.
      nx5 to nx12 each independently represent an integer from 0 to 4.]
[3] The colored resin composition according to the above [2], wherein the compound represented by formula (Xa) is a compound represented by formula (XI) and the compound represented by formula (Xb) is a compound represented by formula (XII). 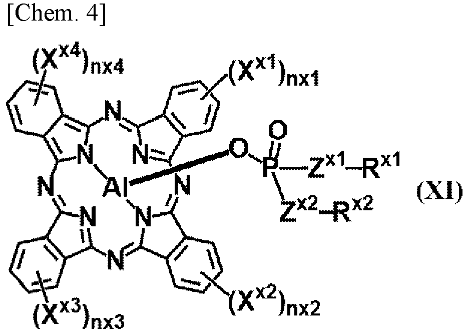 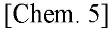 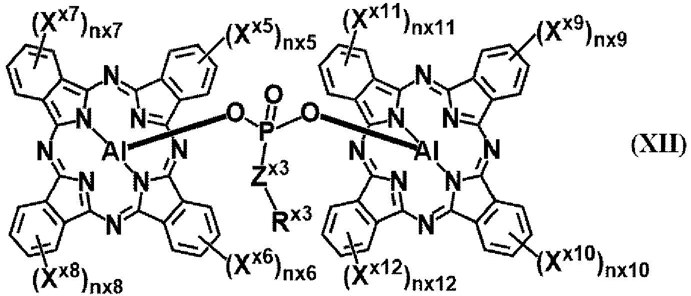
   [In formula (XI),
      R^{x1} represents an unsaturated hydrocarbon group having 2 to 20 carbon atoms and optionally having a substituent or an aromatic hydrocarbon group having 6 to 20 carbon atoms and optionally having a substituent, and R^{x2} represents a hydrogen atom, a hydrocarbon group having 1 to 20 carbon atoms and optionally having a substituent or a single bond linking Z^{x2} and R^{x1}.
      Z^{x1} and Z^{x2} each independently represent a single bond or an oxygen atom.
      X^{x1} to X^{x4} and nx1 to nx4 are the same as above.
   In formula (XII),
      R^{x3} represents an unsaturated hydrocarbon group having 2 to 20 carbon atoms and optionally having a substituent or an aromatic hydrocarbon group having 6 to 20 carbon atoms and optionally having a substituent.
      Z^{x3} represents a single bond or an oxygen atom.
      X^{x5} to x^{x12} and nx5 to nx12 are the same as above.]
[4] The colored resin composition according to the above [1], wherein the aluminum phthalocyanine pigment is a compound represented by formula (YI) or formula (YII). 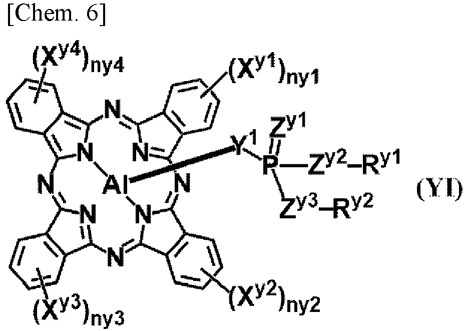 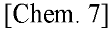 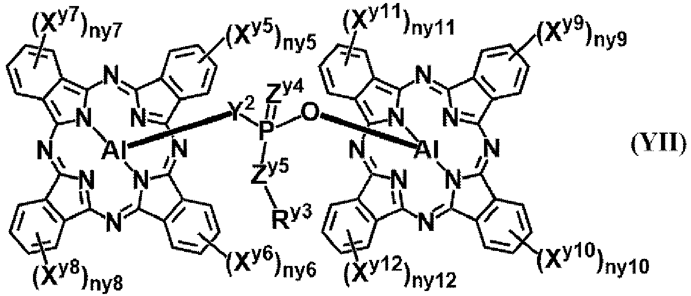
   [In formula (YI),
      R^{y1} represents a hydrogen atom or a hydrocarbon group having from 1 to 20 carbon atoms and optionally having a substituent.
      R^{y2} represents a hydrogen atom, a hydrocarbon group having 1 to 20 carbon atoms and optionally having a substituent, or a single bond linking Z^{y3} and R^{y1}.
      Y¹ and Z^{y1} each independently represent an oxygen atom or a sulfur atom.
      Z^{y2} and Z^{y3} each independently represent a single bond, an oxygen atom or a sulfur atom.
      At least one of Y¹, Z^{y1}, Z^{y2} and Z^{y3} represents a sulfur atom.
      X^{y1} to X^{y4} each independently represent -R^{y4}, -OR^{y4}, -SR^{y4}, a halogen atom, a nitro group or a sulfamoyl group optionally having a substituent.
      R^{y4} represents a hydrocarbon group having 1 to 20 carbon atoms and optionally having a substituent.
      ny1 to ny4 each independently represent an integer from 0 to 4.
   In formula (YII),
      R^{y3} represents a hydrogen atom or a hydrocarbon group having 1 to 20 carbon atoms and optionally having a substituent.
      Y² and Z^{y4} each independently represent an oxygen atom or a sulfur atom.
      Z^{y5} represents a single bond, an oxygen atom or a sulfur atom.
      At least one of Y², Z^{y4} and Z^{y5} represents a sulfur atom.
      X^{y5} to X^{y12} independently represent -R^{y5}, -OR^{y5}, -SR^{y5}, a halogen atom, a nitro group or a sulfamoyl group optionally having a substituent.
      R^{y5} represents a hydrocarbon group having 1 to 20 carbon atoms and optionally having a substituent.
      ny5 to ny12 each independently represent an integer from 0 to 4.]
[5] The colored resin composition according to any one of the above [1] to [4] further comprising a polymerizable compound and a polymerization initiator.
[6] A color filter formed from the colored resin composition according to any one of the above [1] to [5].
[7] A display device comprising the color filter according to the above [6].
[8] A solid-state image sensor comprising the color filter according to the above [6].

### EFFECT OF THE INVENTION

According to the colored resin compositions of the present invention, the colored coating films without generation of foreign matter (preferably the colored coating film with no generation of foreign matter and good adhesion) are formed.

### MODE FOR CARRYING OUT THE INVENTION

### «Colored Resin Composition»

The present invention includes a colored resin composition containing a colorant (hereinafter, sometimes referred to as a colorant (A)), a compound represented by formula (DA), a resin (hereinafter, sometimes referred to as a resin (B)), and a solvent (hereinafter, sometimes referred to as a solvent (E)), wherein the colorant contains an aluminum phthalocyanine pigment.

The present invention also includes a colored resin composition further containing a polymerizable compound (hereinafter, sometimes referred to as a polymerizable compound (C)) and a polymerization initiator (hereinafter, sometimes referred to as a polymerization initiator (D)).

The colored resin composition of the present invention may contain a leveling agent (hereinafter, sometimes referred to as a leveling agent (F)).

Herein, compounds exemplified as each component may be used singly or in combination of a plurality thereof unless otherwise noted.

According to the colored resin composition of the present invention, a colored coating film with no generation of foreign matter is formed. Furthermore, the obtained colored coating film also has good adhesion to a substrate. Moreover, according to the colored resin composition of the present invention, exposure sensitivity, development speed, residue after development, a residual film ratio, and a pattern shape can also be expected to be improved.

### <Colorant (A)>

The colored resin composition according to the present invention contains an aluminum phthalocyanine pigment as a colorant. Specifically, the aluminum phthalocyanine pigment refers to a pigment having a phthalocyanine skeleton to form a complex with aluminum.

Specifically, the aluminum phthalocyanine pigment is preferably a compound represented by formula (Xa) or formula (Xb). Hereinafter, the present invention will be described more specifically by mentioning the partial structure of the compound represented by formula (Xa) or formula (Xb). Definitions common to formula (XI) or formula (XII) will be described later.

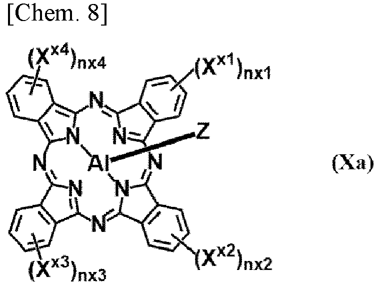

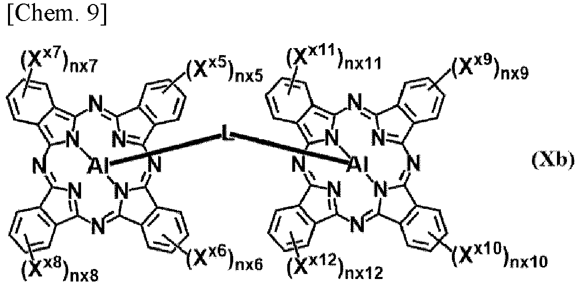

[In formula (Xa),
   Z represents a hydroxy group, a chlorine atom, -OP(=O)R^{a1}R^{a2}, or -O-SiR^{a3}R^{a4}R^{a5}.
   R^{a1} to R^{a5} each independently represent a hydrogen atom, a hydroxy group, or a hydrocarbon group having 1 to 21 carbon atoms and optionally having a substituent, and R^{a1} and R^{a2} or any two of R^{a3} to R^{a5} may be combined with each other to form a ring. When the hydrocarbon group has 2 to 21 carbon atoms and the hydrocarbon group has -CH₂-,-CH₂- may be substituted with -O-, -S-, or -CO-.
   X^{x1} to X^{x4} each independently represent -R^{x4}, -OR^{x4}, -SR^{x4}, a halogen atom, a nitro group, or a sulfamoyl group optionally having a substituent.
   R^{x4} represents a hydrocarbon group having 1 to 20 carbon atoms and optionally having a substituent, and when the hydrocarbon group has 2 to 21 carbon atoms and the hydrocarbon group has -CH₂-, -CH₂- may be substituted with -O-, -S-, or -CO-.
   nx1 to nx4 each independently represent an integer from 0 to 4.
In formula (Xb),
   L represents -O-SiR^{a6}R^{a7}-O-, -O-SiR^{a8}R^{a9}-O-SiR^{a10}R^{a11}-O-, or -O-P(=O)R^{a12}-O-.
   R^{a6} to R^{a12} each independently represent a hydrogen atom, a hydroxy group, or a hydrocarbon group having 1 to 21 carbon atoms and optionally having a substituent, and R^{a6} and R^{a7}, R^{a8} and R^{a9}, or R^{a10} and R^{a11} may be combined with each other to form a ring. When the hydrocarbon group has 2 to 21 carbon atoms and the hydrocarbon group has -CH₂-, -CH₂- may be substituted with -O-, -S-, or -CO-.
   X^{x5} to x^{x12} each independently represent -R^{x5}, -OR^{x5}, -SR^{x5}, a halogen atom, a nitro group, or a sulfamoyl group optionally having a substituent.
   R^{x5} represents a hydrocarbon group having 1 to 20 carbon atoms and optionally having a substituent.
   nx5 to nx12 each independently represent an integer from 0 to 4.]

R^{a1} to R^{a12} each represent a hydrocarbon group having 1 to 21 carbon atoms and optionally having a substituent.

R^{a1} and R^{a2}, any two of R^{a3} to R^{a5}, R^{a6} and R^{a7}, R^{a8} and R^{a9}, or R^{a10} and R^{a11} may be combined with each other to form a ring.

When the hydrocarbon group has 2 to 21 carbon atoms and the hydrocarbon group has - CH₂-, -CH₂- may be substituted with -O-, -S-, or -CO-. In the hydrocarbon group having 2 to 21 carbon atoms, adjacent -CH₂- groups are not substituted with -O- and/or -S- at the same time, and terminal -CH₂- groups are not substituted with -O-, -S-, or -CO-.

When -CH₂- in the hydrocarbon group having 1 to 21 carbon atoms and optionally having a substituent is substituted with -O-, -S-, or -CO-, the number of carbon atoms of the group substituted with -O-, -S-, or -CO- means the number of carbon atoms in the hydrocarbon group before being substituted with -O-, -S-, or -CO-. For example, a ^{∗}-O-CH₂-CH₂-CH₃ group is a group obtained by substituting -CH₂- in a hydrocarbon group having 4 carbon atoms (^{∗}-CH₂-CH₂-CH₂-C_{H3}) with -O-.

If a plurality of substitutable -CH₂- groups exist in the hydrocarbon group having 1 to 21 carbon atoms, the number of substituted -CH₂- groups is not limited to one. For example, two - CH₂- groups in a hydrocarbon group having 4 carbon atoms (^{∗}-CH₂-CH₂-CH₂-CH₃) can also be substituted with -O- to form ^{∗}-O-CH₂-O-CH₃. That is, a group in which two or more -CH₂-groups are substituted with -O-, -S-, or -CO- as in ^{∗}-O-CH₂-O-CH₃ is also included in the "group obtained by substituting -CH₂- in the hydrocarbon group having 1 to 21 carbon atoms and optionally having a substituent with -O-, -S-, or -CO-".

In formula (Xa),
Z is preferably -OP(=O)R^{a1}R^{a2}.
R^{a1} is preferably -R^{b1}, -O-R^{b1}, -S-R^{b1}, or -CO-R^{b1}.
R^{a2} is preferably -R^{b2}, -O-R^{b2}, -S-R^{b2}, or -CO-R^{b2}.
R^{b1} and R^{b2} each represent a hydrocarbon group having 1 to 20 carbon atoms and optionally having a substituent, and R^{b1} and R^{b2} may be combined with each other to form a ring.

In formula (Xb),
L is preferably -O-P(=O)R^{a12}-O-.
R^{a12} is preferably -R^{b3}, -O-R^{b3}, -S-R^{b3}, or -CO-R^{b3}.
R^{b3} represents a hydrocarbon group having 1 to 20 carbon atoms and optionally having a substituent.

The compound represented by the above formula (Xa) is preferably a compound represented by formula (XI). In addition, the compound represented by the above formula (Xb) is preferably a compound represented by formula (XII). Hereinafter, the present invention will be described more specifically by mentioning the partial structure of the compound represented by formula (XI) or formula (XII).

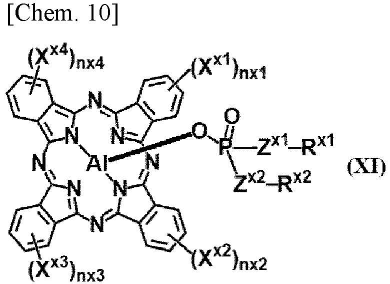

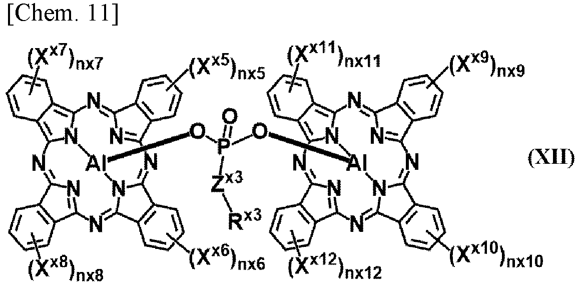

[In formula (XI),
   R^{x1} represents an unsaturated hydrocarbon group having 2 to 20 carbon atoms and optionally having a substituent or an aromatic hydrocarbon group having 6 to 20 carbon atoms and optionally having a substituent, and R^{x2} represents a hydrogen atom, a hydrocarbon group having 1 to 20 carbon atoms and optionally having a substituent, or a single bond linking Z^{x2} and R^{x1}.
   Z^{x1} and Z^{x2} each independently represent a single bond or an oxygen atom.
   X^{x1} to X^{x4} and nx1 to nx4 are the same as above.
In formula (XII),
   R^{x3} represents an unsaturated hydrocarbon group having 2 to 20 carbon atoms and optionally having a substituent or an aromatic hydrocarbon group having 6 to 20 carbon atoms and optionally having a substituent.
   Z^{x3} represents a single bond or an oxygen atom.
   X^{x5} to x^{x12} and nx5 to nx12 are the same as above.]

The aluminum phthalocyanine pigment is also preferably a compound represented by formula (YI) or formula (YII). Hereinafter, the present invention will be described more specifically by mentioning the partial structure of the compound represented by formula (YI) or formula (YII).

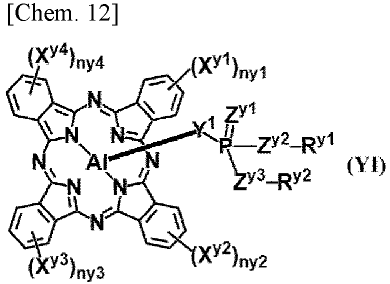

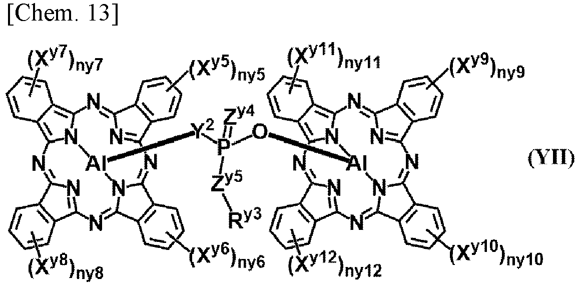

[In formula (YI),
   R^{y1} represents a hydrogen atom or a hydrocarbon group having 1 to 20 carbon atoms and optionally having a substituent.
   R^{y2} represents a hydrogen atom, a hydrocarbon group having 1 to 20 carbon atoms and optionally having a substituent, or a single bond linking Z^{y3} and R^{y1}.
   Y¹ and Z^{y1} each independently represent an oxygen atom or a sulfur atom.
   Z^{y2} and Z^{y3} each independently represent a single bond, an oxygen atom, or a sulfur atom.
   At least one of Y¹, Z^{y1}, Z^{y2}, and Z^{y3} represents a sulfur atom.
   X^{y1} to X^{y4} each independently represent -R^{y4}, -OR^{y4}, -SR^{y4}, a halogen atom, a nitro group, or a sulfamoyl group optionally having a substituent.
   R^{y4} represents a hydrocarbon group having 1 to 20 carbon atoms and optionally having a substituent.
   ny1 to ny4 each independently represent an integer from 0 to 4.
In formula (YII),
   R^{y3} represents a hydrogen atom or a hydrocarbon group having 1 to 20 carbon atoms and optionally having a substituent.
   Y² and Z^{y4} each independently represent an oxygen atom or a sulfur atom.
   Z^{y5} represents a single bond, an oxygen atom, or a sulfur atom.
   At least one of Y², Z^{y4}, and Z^{y5} represents a sulfur atom.
   X^{y5} to X^{y12} each independently represent -R^{y5}, -OR^{y5}, -SR^{y5}, a halogen atom, a nitro group, or a sulfamoyl group optionally having a substituent.
   R^{y5} represents a hydrocarbon group having 1 to 20 carbon atoms and optionally having a substituent.
   ny5 to ny12 each independently represent an integer from 0 to 4.]

Compounds represented by formula (YI) include compounds represented by formula (YIa) and having a resonance structure or compounds represented by formula (YIb) and having an equilibrium relationship, and compounds represented by formula (YII) include compounds represented by formula (YIIa) and having a resonance structure or compounds represented by formula (YIIb) and having an equilibrium relationship.

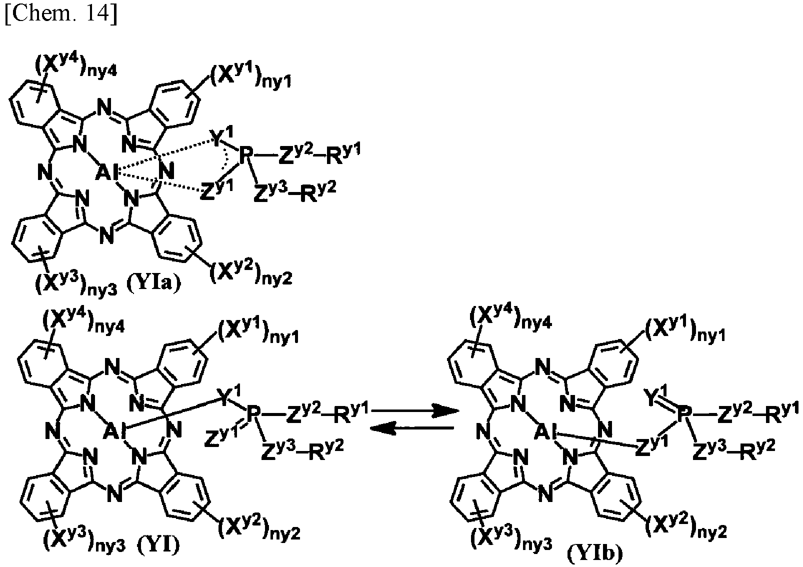

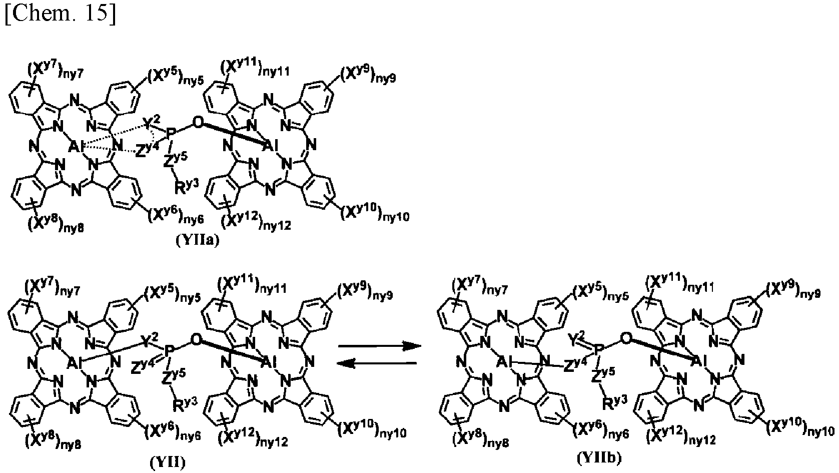

[In formula (YI), formula (YIa) and formula (YIb),
   R^{y1} represents a hydrogen atom or a hydrocarbon group having 1 to 20 carbon atoms and optionally having a substituent;
   R^{y2} represents a hydrogen atom, a hydrocarbon group having 1 to 20 carbon atoms and optionally having a substituent, or a single bond connecting Z^{y3} and R^{y1};
   Y¹ and Z^{y1} each independently represent an oxygen atom or a sulfur atom;
   Z^{y2} and Z^{y3} each independently represent a single bond, an oxygen atom or a sulfur atom;
   At least one of Y¹, Z^{y1}, Z^{y2}, and Z^{y3} represents a sulfur atom;
   X^{y1} to X^{y4} each independently represent -R^{y4}, -OR^{y4}, -SR^{y4}, a halogen atom, a nitro group, or a sulfamoyl group optionally having a substituent;
   R^{y4} represents a hydrocarbon group having 1 to 20 carbon atoms and optionally having a substituent; and
   ny1 to ny4 each independently represent an integer of 0 to 4.
In formula (YII), formula (YIIa), and formula (YIIb),
   R^{y3} represents a hydrogen atom or a hydrocarbon group having 1 to 20 carbon atoms and optionally having a substituent;
   Y² and Z^{y4} each independently represent an oxygen atom or a sulfur atom;
   Z^{y5} represents a single bond, an oxygen atom or a sulfur atom;
   At least one of Y², Z^{y4}, and Z^{y5} represents a sulfur atom;
   X^{y5} to X^{y12} each independently represent -R^{y5}, -OR^{y5}, -SR^{y5}, a halogen atom, a nitro group, or a sulfamoyl group optionally having a substituent;
   R^{y5} represents a hydrocarbon group having 1 to 20 carbon atoms and optionally having a substituent; and
   ny5 to ny12 each independently represent an integer of 0 to 4.]

The unsaturated hydrocarbon group represented by R^{x1} and R^{x3} has preferably 2 to 20 carbon atoms, more preferably 2 to 10 carbon atoms, further preferably 2 to 7 carbon atoms, and particularly preferably 2 to 5 carbon atoms.

The unsaturated hydrocarbon group represented by R^{x1} and R^{x3} may be chain or cyclic (alicyclic hydrocarbon group).

The unsaturated chain hydrocarbon group represented by R^{x1} and R^{x3} include alkenyl groups such as ethenyl (vinyl), propenyl (for example, 1-propenyl and 2-propenyl (allyl)), 1-methylethenyl, butenyl (for example, 1-butenyl, 2-butenyl, and 3-butenyl), 3-methyl-1-butenyl, 1-methyl-1-butenyl, 3-methyl-2-butenyl, 1,3-butadienyl, 3-methyl-1,2-butadienyl, 1-(2-propenyl)ethenyl, 1-(1-methylethenyl)ethenyl, 1,1-dimethyl-2-propenyl, 1,2-dimethyl-1-propenyl, 1-ethyl-2-propenyl, pentenyl (for example, 1-pentenyl, 2-pentenyl, 3-pentenyl, and 4-pentenyl), 1-(1,1-dimethylethyl)ethenyl, 1,3-dimethyl-1-butenyl, hexenyl (for example, 1-hexenyl and 5-hexenyl), heptenyl (for example, 1-heptenyl and 6-heptenyl), octenyl (for example, 1-octenyl and 7-octenyl), nonenyl (for example, 1-nonenyl and 8-nonenyl), decenyl (for example, 1-decenyl and 9-decenyl), undecenyl, dodecenyl, tridecenyl, tetradecenyl, pentadecenyl, hexadecenyl, heptadecenyl, octadecenyl, nonadecenyl, and icosenyl; and
alkynyl groups such as ethynyl, propynyl (for example, 1-propynyl and 2-propynyl), butynyl (for example, 1-butynyl, 2-butynyl, and 3-butynyl), pentynyl, hexynyl, heptynyl, octynyl (for example, 1-octynyl and 7-octynyl), nonynyl, decynyl, undecynyl, dodecynyl, tridecynyl, tetradecynyl, pentadecynyl, hexadecynyl, heptadecynyl, octadecynyl, nonadecynyl, and icosynyl.

Examples of the unsaturated alicyclic hydrocarbon group represented by R^{x1} and R^{x3} include cycloalkenyl groups such as cyclohexenyl (for example, cyclohex-1-en-1-yl, cyclohex-2-en-1-yl, and cyclohex-3-en-1-yl), cycloheptenyl, and cyclooctenyl; and unsaturated polycyclic hydrocarbon groups such as norbornenyl.

The C2-C20 unsaturated hydrocarbon group represented by R^{x1} and R^{x3} optionally has a substituent.

Examples of the substituent of the C2-C20 unsaturated hydrocarbon group represented by R^{x1} and R^{x3} include an aromatic hydrocarbon group having 6 to 20 carbon atoms and optionally having a substituent, a heterocyclic group optionally having a substituent, a halogen atom, a nitro group, a cyano group, -OR^{xa1}, -CO₂R^{xa1}, -SR^{xa1}, -SO₂R^{xa1}, -SO₃R^{xa1}, -SO₂NR^{xa1}R^{xa2}, and - NR^{xa1}R^{xa2}.

R^{xa1} and R^{xa2} each independently represent a hydrogen atom or a hydrocarbon group having 1 to 20 carbon atoms. The C1-C20 hydrocarbon group represented by R^{xa1} and R^{xa2} is the same as the C1-C20 hydrocarbon group represented by R^{b1} to R^{b3}, R^{x2}, R^{x4}, R^{x5} and R^{y1} to R^{y5} described later.

Examples of the C6-C20 aromatic hydrocarbon group used as the substituent of the C2-C20 unsaturated hydrocarbon group represented by R^{x1} and R^{x3} include an aromatic hydrocarbon group such as phenyl, o-tolyl, m-tolyl, p-tolyl, 2-ethylphenyl, 3-ethylphenyl, 4-ethylphenyl, 2,3-dimethylphenyl, 2,4-dimethylphenyl, 2,5-dimethylphenyl, 2,6-dimethylphenyl, 3,4-dimethylphenyl, 3,5-dimethylphenyl, 4-vinylphenyl, o-isopropylphenyl, m-isopropylphenyl, p-isopropylphenyl, o-tert-butylphenyl, m-tert-butylphenyl, p-tert-butylphenyl, 3,5-di(tert-butyl)phenyl, 3,5-di(tert-butyl)-4-methylphenyl, 4-butylphenyl, 4-pentylphenyl, 2,6-bis(1-methylethyl)phenyl, 2,4,6-tris(1-methylethyl)phenyl, 4-cyclohexylphenyl, 2,4,6-trimethylphenyl, 4-octylphenyl, 4-(1,1,3,3-tetramethylbutyl)phenyl, 1-naphthyl, 2-naphthyl, 6-methyl-2-naphthyl, 5,6,7,8-tetrahydro-1-naphthyl, 5,6,7,8-tetrahydro-2-naphthyl, fluorenyl, phenanthryl, anthryl, 2-dodecylphenyl, 3-dodecylphenyl, 4-dodecylphenyl, perylenyl, chrysenyl, and pyrenyl.

The aromatic hydrocarbon group preferably has 6 to 10 carbon atoms, and more preferably 6 to 8 carbon atoms.

The aromatic hydrocarbon group optionally has a substituent. Examples of the substituent include a halogen atom, a nitro group, a cyano group, -OR^{xa1}, -CO₂R^{xa1}, -SR^{xa1}, - SO₂R^{xa1}, -SO₃R^{xa1}, -SO₂NR^{xa1}R^{xa2}, and -NR^{xa1}R^{xa2}, wherein R^{xa1} and R^{xa2} are the same as mentioned above.

The heterocyclic group used as the substituent of the C2-C20 unsaturated hydrocarbon group represented by R^{x1} and R^{x3} may be monocyclic or polycyclic, and is preferably a heterocycle containing a heteroatom as a constituent element of its ring. Examples of the heteroatom include a nitrogen atom, an oxygen atom, and a sulfur atom.

Examples of a heterocycle containing only nitrogen atom(s) as the heteroatom include monocyclic saturated heterocycles such as aziridine, azetidine, pyrrolidine, piperidine, and piperazine; 5-membered unsaturated heterocycles such as pyrrole, pyrazole, imidazole, 1,2,3-triazole, and 1,2,4-triazole; 6-membered unsaturated heterocycles such as pyridine, pyridazine, pyrimidine, pyrazine, and 1,3,5-triazine; fused bicyclic heterocycles such as indazole, indoline, isoindoline, isoindoline-1,3-dione, indole, indolizine, benzimidazole, quinoline, isoquinoline, quinoxaline, quinazoline, cinnoline, phthalazine, naphthyridine, purine, pteridine, benzopyrazole, and benzopiperidine; and fused tricyclic heterocycles such as carbazole, acridine, and phenazine.

Examples of a heterocycle containing only oxygen atom(s) as the heteroatom include monocyclic saturated heterocycles such as oxirane, oxetane, tetrahydrofuran, tetrahydropyran, 1,3-dioxane, and 1,4-dioxane; bicyclic saturated heterocycles such as 1,4-dioxaspiro[4.5]decane and 1,4-dioxaspiro[4.5]nonane; lactone heterocycles such as α-acetolactone, β-propiolactone, γ-butyrolactone, and δ-valerolactone; 5-membered unsaturated heterocycles such as furan; 6-membered unsaturated heterocycles such as 2H-pyran and 4H-pyran; fused bicyclic heterocycles such as 1-benzofuran, benzopyran, benzodioxole, chroman, and isochroman; and fused tricyclic heterocycles such as xanthene and dibenzofuran.

Examples of a heterocycle containing only sulfur atom(s) as the heteroatom include 5-membered saturated heterocycles such as dithiolane; 6-membered saturated heterocycles such as thiane and 1,3-dithiane; 5-membered unsaturated heterocycles such as thiophene; 6-membered unsaturated heterocycles such as 4H-thiopyran; fused bicyclic heterocycles such as benzothiopyran including benzotetrahydrothiopyran and the like, and benzothiophene; and fused tricyclic heterocycles such as thianthrene and dibenzothiophene.

Examples of a heterocycle containing nitrogen atom(s) and oxygen atom(s) as heteroatoms include monocyclic saturated heterocycles such as morpholine, 2-pyrrolidone, and 2-piperidone; monocyclic unsaturated heterocycles such as oxazole and isoxazole; fused bicyclic heterocycles such as benzoxazole, benzoisoxazole, benzoxazine, benzodioxane, and benzimidazoline; and fused tricyclic heterocycles such as phenoxazine.

Examples of a heterocycle containing nitrogen atom(s) and sulfur atom(s) as heteroatoms include monocyclic heterocycles such as thiazole; fused bicyclic heterocycles such as benzothiazole; and fused tricyclic heterocycles such as phenothiazine.

The heterocyclic group preferably has 2 to 30 carbon atoms, more preferably 3 to 22 carbon atoms, and further preferably 3 to 20 carbon atoms.

The heterocyclic group optionally has a substituent. Examples of the substituent include a halogen atom, a nitro group, a cyano group, -OR^{xa1}, -CO₂R^{xa1}, -SR^{xa1}, -SO₂R^{xa1}, -SO₃R^{xa1}, - SO₂NR^{xa1}R^{xa2}, and -NR^{xa1}R^{xa2}, wherein R ^{xa1} and R^{xa2} are the same as mentioned above.

The bonding position of the heterocycle is at a portion where any hydrogen atom contained in each ring is eliminated.

Examples of the halogen atom used as the substituent of the C2-C20 unsaturated hydrocarbon group represented by R^{x1} and R^{x3} include a fluorine atom, a chlorine atom, a bromine atom, and an iodine atom.

The aromatic hydrocarbon group represented by R^{x1} and R^{x3} has preferably 6 to 20 carbon atoms, more preferably 6 to 10 carbon atoms, further preferably 6 to 8 carbon atoms, and particularly preferably 6 carbon atoms.

Examples of the aromatic hydrocarbon group represented by R^{x1} and R^{x3} include an aromatic hydrocarbon group such as phenyl, o-tolyl, m-tolyl, p-tolyl, 2-ethylphenyl, 3-ethylphenyl, 4-ethylphenyl, 2,3-dimethylphenyl, 2,4-dimethylphenyl, 2,5-dimethylphenyl, 2,6-dimethylphenyl, 3,4-dimethylphenyl, 3,5-dimethylphenyl, 4-vinylphenyl, o-isopropylphenyl, m-isopropylphenyl, p-isopropylphenyl, o-tert-butylphenyl, m-tert-butylphenyl, p-tert-butylphenyl, 3,5-di(tert-butyl)phenyl, 3,5-di(tert-butyl)-4-methylphenyl, 4-butylphenyl, 4-pentylphenyl, 2,6-bis(1-methylethyl)phenyl, 2,4,6-tris(1-methylethyl)phenyl, 4-cyclohexylphenyl, 2,4,6-trimethylphenyl, 4-octylphenyl, 4-(1,1,3,3-tetramethylbutyl)phenyl, 1-naphthyl, 2-naphthyl, 6-methyl-2-naphthyl, 5,6,7,8-tetrahydro-1-naphthyl, 5,6,7,8-tetrahydro-2-naphthyl, fluorenyl, phenanthryl, anthryl, 2-dodecylphenyl, 3-dodecylphenyl, 4-dodecylphenyl, perylenyl, chrysenyl, and pyrenyl.

The C6-C20 aromatic hydrocarbon group represented by R^{x1} and R^{x3} optionally has a substituent. Examples of the substituent of the C6-C20 aromatic hydrocarbon group represented by R^{x1} and R^{x3} include a halogen atom such as a fluorine atom, a chlorine atom, a bromine atom, and an iodine atom, a nitro group, a cyano group, -OR^{xa1}, -CO₂R^{xa1}, -SR^{xa1}, -SO₂R^{xa1}, -SO₃R^{xa1}, - SO₂NR^{xa1}R^{xa2}, and -NR^{xa1}R^{xa2}, wherein R^{xa1} and R^{xa2} are the same as mentioned above.

The hydrocarbon groups represented by R^{a1} to R^{a12} have preferably 1 to 21 carbon atoms, and more preferably 1 to 15 carbon atoms.

The hydrocarbon groups represented by R^{b1} to R^{b3}, R^{x2}, R^{x4}, R^{x5} and R^{y1} to R^{y5} have preferably 1 to 20 carbon atoms, and more preferably 1 to 15 carbon atoms.

The hydrocarbon groups having 1 to 21 carbon atoms represented by R^{a1} to R^{a12} and the hydrocarbon groups having 1 to 20 carbon atoms represented by R^{b1} to R^{b3}, R^{x2}, R^{x4}, R^{x5} and R^{y1} to R^{y5} may be aliphatic hydrocarbon groups and aromatic hydrocarbon groups. The aliphatic hydrocarbon group may be saturated or unsaturated and chain or cyclic (alicyclic hydrocarbon group).

The saturated or unsaturated chain hydrocarbon groups represented by R^{a1} to R^{a12}, R^{b1} to R^{b3}, R^{x2}, R^{x4}, R^{x5} and R^{y1} to R^{y5} include straight-chain alkyl groups such as methyl, ethyl, propyl, butyl, pentyl, hexyl, heptyl, octyl, nonyl, decyl, undecyl, dodecyl, tridecyl, tetradecyl, pentadecyl, hexadecyl, heptadecyl, octadecyl, nonadecyl, and icosyl;
branched-chain alkyl groups such as isopropyl, isobutyl, sec-butyl, tert-butyl, 2-ethylbutyl, 3,3-dimethylbutyl, 1,1,3,3-tetramethylbutyl, 1-methylbutyl, 1-ethylpropyl, 3-methylbutyl, neopentyl, 1,1-dimethylpropyl, 2-methylpentyl, 3-ethylpentyl, 1,3-dimethylbutyl, 2-propylpentyl, 1-ethyl-1,2-dimethylpropyl, 1-methylpentyl, 4-methylpentyl, 4-methylhexyl, 5-methylhexyl, 2-ethylhexyl, 1-methylhexyl, 1-ethylpentyl, 1-propylbutyl, 3-ethylheptyl, 2,2-dimethylheptyl, 1-methylheptyl, 1-ethylhexyl, 1-propylpentyl, 1-methyloctyl, 1-ethylheptyl, 1-propylhexyl, 1-butylpentyl, 1-methylnonyl, 1-ethyloctyl, 1-propylheptyl, and 1-butylhexyl;
alkenyl groups such as ethenyl (vinyl), propenyl (for example, 1-propenyl and 2-propenyl (allyl)), 1-methylethenyl, butenyl (for example, 1-butenyl, 2-butenyl, and 3-butenyl), 3-methyl-1-butenyl, 1-methyl-1-butenyl, 3-methyl-2-butenyl, 1,3-butadienyl, 3-methyl-1,2-butadienyl, 1-(2-propenyl)ethenyl, 1-(1-methylethenyl)ethenyl, 1,1-dimethyl-2-propenyl, 1,2-dimethyl-1-propenyl, 1-ethyl-2-propenyl, pentenyl (for example, 1-pentenyl, 2-pentenyl, 3-pentenyl, and 4-pentenyl), 1-(1,1-dimethylethyl)ethenyl, 1,3-dimethyl-1-butenyl, hexenyl (for example, 1-hexenyl and 5-hexenyl), heptenyl (for example, 1-heptenyl and 6-heptenyl), octenyl (for example, 1-octenyl and 7-octenyl), nonenyl (for example, 1-nonenyl and 8-nonenyl), decenyl (for example, 1-decenyl and 9-decenyl), undecenyl, dodecenyl, tridecenyl, tetradecenyl, pentadecenyl, hexadecenyl, heptadecenyl, octadecenyl, nonadecenyl, and icosenyl; and
alkynyl groups such as ethynyl, propynyl (for example, 1-propynyl and 2-propynyl), butynyl (for example, 1-butynyl, 2-butynyl, and 3-butynyl), pentynyl, hexynyl, heptynyl, octynyl (for example, 1-octynyl and 7-octynyl), nonynyl, decynyl, undecynyl, dodecynyl, tridecynyl, tetradecynyl, pentadecynyl, hexadecynyl, heptadecynyl, octadecynyl, nonadecynyl, and icosynyl.

The saturated chain hydrocarbon groups represented by R^{a1} to R^{a12}, R^{b1} to R^{b3}, R^{x2}, R^{x4}, R^{x5} and R^{y1} to R^{y5} have preferably 1 to 10 carbon atoms, more preferably 1 to 7 carbon atoms and further preferably 1 to 5 carbon atoms.

The unsaturated chain hydrocarbon groups represented by R^{a1} to R^{a12}, R^{b1} to R^{b3}, R^{x2}, R^{x4}, R^{x5} and R^{y1} to R^{y5} have preferably 2 to 10 carbon atoms, more preferably 2 to 7 carbon atoms, and further preferably 2 to 5 carbon atoms.

The saturated or unsaturated alicyclic hydrocarbon groups represented by R^{a1} to R^{a12}, R^{b1} to R^{b3}, R^{x2}, R^{x4}, R^{x5} and R^{y1} to R^{y5} include cycloalkyl groups such as cyclopropyl, 1-methylcyclopropyl, cyclobutyl, cyclopentyl, cyclohexyl, cycloheptyl, 1-methylcyclohexyl, 2-methylcyclohexyl, 3-methylcyclohexyl, 4-methylcyclohexyl, 1,2-dimethylcyclohexyl, 1,3-dimethylcyclohexyl, 1,4-dimethylcyclohexyl, 2,3-dimethylcyclohexyl, 2,4-dimethylcyclohexyl, 2,5-dimethylcyclohexyl, 2,6-dimethylcyclohexyl, 3,4-dimethylcyclohexyl, 3,5-dimethylcyclohexyl, 2,2-dimethylcyclohexyl, 3,3-dimethylcyclohexyl, 4,4-dimethylcyclohexyl, cyclooctyl, 2,4,6-trimethylcyclohexyl, 2,2,6,6-tetramethylcyclohexyl, 3,3,5,5-tetramethylcyclohexyl, 4-pentylcyclohexyl, 4-octylcyclohexyl, and 4-cyclohexylcyclohexyl;
cycloalkenyl groups such as cyclohexenyl (for example, cyclohex-1-en-1-yl, cyclohex-2-en-1-yl, and cyclohex-3-en-1-yl), cycloheptenyl, and cyclooctenyl; and
saturated or unsaturated polycyclic hydrocarbon groups such as norbornyl, norbornenyl, adamantly, and bicyclo[2.2.2]octyl.

The saturated or unsaturated alicyclic hydrocarbon group represented by R^{a1} to R^{a12}, R^{b1} to R^{b3}, R^{x2}, R^{x4}, R^{x5} and R^{y1} to R^{y5} preferably has 3 to 10 carbon atoms.

Examples of the aromatic hydrocarbon group represented by R^{a1} to R^{a12}, R^{b1} to R^{b3}, R^{x2}, R^{x4}, R^{x1} and R^{y1} to R^{y5} include phenyl, o-tolyl, m-tolyl, p-tolyl, 2-ethylphenyl, 3-ethylphenyl, 4-ethylphenyl, 2,3-dimethylphenyl, 2,4-dimethylphenyl, 2,5-dimethylphenyl, 2,6-dimethylphenyl, 3,4-dimethylphenyl, 3,5-dimethylphenyl, 4-vinylphenyl, o-isopropylphenyl, m-isopropylphenyl, p-isopropylphenyl, o-tert-butylphenyl, m-tert-butylphenyl, p-tert-butylphenyl, 3,5-di(tert-butyl)phenyl, 3,5-di(tert-butyl)-4-methylphenyl, 4-butylphenyl, 4-pentylphenyl, 2,6-bis(1-methylethyl)phenyl, 2,4,6-tris(1-methylethyl)phenyl, 4-cyclohexylphenyl, 2,4,6-trimethylphenyl, 4-octylphenyl, 4-(1,1,3,3-tetramethylbutyl)phenyl, 1-naphthyl, 2-naphthyl, 6-methyl-2-naphthyl, 5,6,7,8-tetrahydro-1-naphthyl, 5,6,7,8-tetrahydro-2-naphthyl, fluorenyl, phenanthryl, anthryl, 2-dodecylphenyl, 3-dodecylphenyl, 4-dodecylphenyl, perylenyl, chrysenyl, and pyrenyl.

The aromatic hydrocarbon group represented by R^{a1} to R^{a12}, R^{b1} to R^{b3}, R^{x2}, R^{x4}, R^{x5} and R^{y1} to R^{y5} preferably has 6 to 20 carbon atoms, more preferably 6 to 10 carbon atoms, and further preferably 6 to 8 carbon atoms.

The hydrocarbon group represented by R^{a1} to R^{a12}, R^{b1} to R^{b3}, R^{x2}, R^{x4}, R^{x5} and R^{y1} to R^{y5} may be a group in which the above-mentioned hydrocarbon groups (for example, an aromatic hydrocarbon group and at least one of a chain hydrocarbon group and an alicyclic hydrocarbon group) are combined. Examples of thereof include aralkyl groups such as benzyl, (2-methylphenyl)methyl, (3-methylphenyl)methyl, (4-methylphenyl)methyl, (2-ethylphenyl)methyl, (3-ethylphenyl)methyl, (4-ethylphenyl)methyl, (2-(tert-butyl)phenyl)methyl, (3-(tert-butyl)phenyl)methyl, (4-(tert-butyl)phenyl)methyl, (3,5-dimethylphenyl)methyl, 1-phenylethyl, 1-methyl-1-phenylethyl, 1,1-diphenylethyl, (1-naphthyl)methyl, and (2-naphthyl)methyl;
arylalkenyl groups such as 1-phenylethenyl, 2-phenylethenyl (phenylvinyl), 2,2-diphenylethenyl, and 2-phenyl-2-(1-naphthyl)ethenyl;
arylalkynyl groups such as phenylethynyl;
phenyl groups with one or more phenyl groups bonded, such as biphenylyl and terphenylyl; and
cyclohexylmethylphenyl, benzylphenyl, and (dimethyl(phenyl)methyl)phenyl.

This group has preferably 7 to 18 carbon atoms, and more preferably 7 to 15 carbon atoms.

The group represented by R^{a1} to R^{a12}, R^{b1} to R^{b3}, R^{x2}, R^{x4}, R^{x5} and R^{y1} to R^{y5} may also be a group in which the above-mentioned hydrocarbon groups (for example, a chain hydrocarbon group and an alicyclic hydrocarbon group) are combined. Examples of thereof include alkyl groups with one or more alicyclic hydrocarbon groups bonded, such as cyclopropylmethyl, cyclopropylethyl, cyclobutylmethyl, cyclobutylethyl, cyclopentylmethyl, cyclopentylethyl, cyclohexylmethyl, (2-methylcyclohexyl)methyl, cyclohexylethyl, and adamantylmethyl.

This group has preferably 4 to 15 carbon atoms, and more preferably 4 to 10 carbon atoms.

The hydrocarbon groups having 1 to 21 carbon atoms represented by R^{a1} to R^{a12}, and the hydrocarbon groups having 1 to 20 carbon atoms represented by R^{b1} to R^{b3}, R^{x2}, R^{x4}, R^{x5}, and R^{y1} to R^{y5} may have substituents.

The substituents of the hydrocarbon groups having 1 to 21 carbon atoms represented by R^{a1} to R^{a12} and the hydrocarbon groups having 1 to 20 carbon atoms represented by R^{b1} to R^{b3}, R^{x2}, R^{x4}, R^{x5}, and R^{y1} to R^{y5} may be heterocyclic groups which may have a substituent, a halogen atom, a nitro group, a cyano group, -OR^{xa1}, -CO₂R^{xa1}, -SR^{xa1}, -SO₂R^{xa1}, -SO₃R^{xa1}, -SO₂NR^{xa1}R^{xa2} and -NR^{xa1}R^{xa2}, wherein R^{xa1} and R^{xa2} are the same as above.

The heterocyclic group used as the substituents of the hydrocarbon group having 1 to 21 carbon atoms represented by R^{a1} to R^{a12}, and the hydrocarbon group having 1 to 20 carbon atoms represented by R^{b1} to R^{b3}, R^{x2}, R^{x4}, R^{x5} and R^{y1} to R^{y5} may be monocyclic or polycyclic, and is preferably a heterocycle containing a heteroatom as a constituent element of its ring. Examples of the heteroatom include a nitrogen atom, an oxygen atom, and a sulfur atom.

Examples of the heterocycle include the same heterocyclic groups as those used as the substituent of the C2-C20 unsaturated hydrocarbon group represented by R^{x1} and R^{x3}.

The heterocyclic group has preferably 2 to 30 carbon atoms, more preferably 3 to 22 carbon atoms, and further preferably 3 to 20 carbon atoms.

The heterocyclic group optionally has a substituent. Examples of the substituent include a halogen atom, a nitro group, a cyano group, -OR^{xa1}, -CO₂R^{xa1}, -SR^{xa1}, -SO₂R^{xa1}, -SO₃R^{xa1}, - SO₂NR^{xa1}R^{xa2}, and -NR^{xa1}R^{xa2}, wherein R ^{xa1} and R^{xa2} are the same as mentioned above.

The bonding position of the heterocycle is at a portion where any hydrogen atom contained in each ring is eliminated.

Examples of the halogen atom used as the substituent of the hydrocarbon group having 1 to 21 carbon atoms represented by R^{a1} to R^{a12}, and the hydrocarbon group having 1 to 20 carbon atoms represented by R^{b1} to R^{b3}, R^{x2}, R^{x4}, R^{x5} and R^{y1} to R^{y5} include a fluorine atom, a chlorine atom, a bromine atom, and an iodine atom.

When R^{x2} is a single bond connecting Z^{x2} and R^{x1}, a part or the whole of R^{x1} forms a ring together with ^{∗}-Z^{x2}-P(=O)-Z^{x1}-^{∗} (* represents a point of attachment). That is, when R^{x2} is a single bond connecting Z^{x2} and R^{x1}, a bond formed by sharing a pair of electrons between Z^{x2} and any carbon atom in the unsaturated hydrocarbon group having 2 to 20 carbon atoms that may have a substituent represented by R^{x1} or any carbon atom in the aromatic hydrocarbon group having 6 to 20 carbon atoms that may have a substituent represented by R^{x1} (preferably any carbon atom in the unsaturated hydrocarbon group having 2 to 20 carbon atoms that may have a substituent) corresponds to a single bond represented by R^{x2}.

In the ring formed from a part or the whole of R^{x1} together with ^{∗}-Z^{x2}-P(=O)-Z^{x1}-^{∗} (* represents a point of attachment), an unsaturated bond may be formed between carbon atoms that are constituent elements of the ring, between a carbon atom that is a constituent element of the ring and a carbon atom that is not a constituent element of the ring, or between carbon atoms that are not constituent elements of the ring.

When R^{y2} is a single bond connecting Z^{y3} and R^{y1}, R^{y1} is the hydrocarbon group having 1 to 20 carbon atoms having optionally a substituent and a part or the whole of R^{y1} forms a ring together with ^{∗}-Z^{y3}-P(=Z^{y1})-Z^{y2}-^{∗} (* represents a point of attachment). That is, when R^{y2} is a single bond connecting Z^{y3} and R^{y1}, a bond formed by sharing a pair of electrons between Z^{y3} and any carbon atom in the hydrocarbon group having 1 to 20 carbon atoms that may have a substituent represented by R^{y1} corresponds to a single bond represented by R^{y2}.

Examples of the halogen atom represented by X^{x1} to X^{x12} include a fluorine atom, a chlorine atom, a bromine atom, and an iodine atom. Among these, a fluorine atom is preferable.

The sulfamoyl group represented by X^{x1} to X^{x12} is represented by ^{∗}-SO₂-NH₂ (* represents a point of attachment).

The sulfamoyl group represented by X^{x1} to X^{x12} optionally has a substituent. Examples of the substituent of the sulfamoyl group represented by X^{x1} to X^{x12} are the same as those for the substituent of the C2-C20 unsaturated hydrocarbon group represented by R^{x1} and R^{x3}. Specific examples thereof include an aromatic hydrocarbon group having 6 to 20 carbon atoms and optionally having a substituent, a heterocyclic group optionally having a substituent, a halogen atom, a nitro group, a cyano group, -OR^{xa1}, -CO₂R^{xa1}, -SR^{xa1}, -SO₂R^{xa1}, -SO₃R^{xa1}, - SO₂NR^{xa1}R^{xa2}, and -NR^{xa1}R^{xa2}, wherein R^{xa1} and R^{xa2} are the same as mentioned above.

-R^{x4} represented by X^{x1} to X^{x4}, -R^{x5} represented by X^{x5} to X^{x12}, -R^{y4} represented by X^{y1} to X^{y4} or -R^{y5} represented by X^{y5} to X^{y12} are preferably a C1-C20 aliphatic hydrocarbon group, more preferably a C1-C20 saturated chain hydrocarbon group, further preferably a C1-C10 saturated chain hydrocarbon group, further more preferably a C1-C5 branched-chain alkyl group, and particularly preferably a tert-butyl group.

In formula (XI),
R^{x1} is
preferably an unsaturated chain hydrocarbon group having 2 to 20 carbon atoms and optionally having a substituent or an aromatic hydrocarbon group having 6 to 10 carbon atoms and optionally having a substituent,
more preferably an unsaturated chain hydrocarbon group having 2 to 10 carbon atoms and optionally having a substituent or an aromatic hydrocarbon group having 6 to 8 carbon atoms and optionally having a substituent,
further preferably an unsaturated chain hydrocarbon group having 2 to 7 carbon atoms and optionally having a substituent or an aromatic hydrocarbon group having 6 to 7 carbon atoms and optionally having a substituent, and
particularly preferably an ethenyl group optionally having a substituent, a propenyl group optionally having a substituent, a butenyl group optionally having a substituent, a 3-methyl-2-butenyl group optionally having a substituent, a 3-methyl-1,2-butadienyl group optionally having a substituent, a heptenyl group optionally having a substituent, an ethynyl group optionally having a substituent, a propynyl group optionally having a substituent, a butynyl group optionally having a substituent, or a phenyl group optionally having a substituent.

When the unsaturated hydrocarbon group having 2 to 20 carbon atoms represented by R^{x1} has a substituent, the substituent is preferably a phenyl group.

R^{x2} is
preferably an aromatic hydrocarbon group having 6 to 20 carbon atoms and optionally having a substituent or an unsaturated hydrocarbon group having 2 to 20 carbon atoms and optionally having a substituent,
more preferably an aromatic hydrocarbon group having 6 to 10 carbon atoms and optionally having a substituent or an unsaturated chain hydrocarbon group having 2 to 20 carbon atoms and optionally having a substituent,
further preferably an aromatic hydrocarbon group having 6 to 8 carbon atoms and optionally having a substituent or an unsaturated chain hydrocarbon group having 2 to 7 carbon atoms and optionally having a substituent, and
particularly preferably a phenyl group optionally having a substituent, an ethenyl group optionally having a substituent, a propenyl group optionally having a substituent, a butenyl group optionally having a substituent, a 3-methyl-2-butenyl group optionally having a substituent, a 3-methyl-1,2-butadienyl group optionally having a substituent, a heptenyl group optionally having a substituent, an ethynyl group optionally having a substituent, a propynyl group optionally having a substituent, or a butynyl group optionally having a substituent.

When the unsaturated hydrocarbon group having 2 to 20 carbon atoms represented by R^{x2} has a substituent, the substituent is preferably a phenyl group.

In formula (Xa) or formula (XI),
X^{x1} to X^{x4} are each independently preferably -R^{x4} or a halogen atom.
nx1 to nx4 are each independently preferably 0 to 2 and more preferably 0 to 1.

In formula (XII),
R^{x3} is
preferably an unsaturated chain hydrocarbon group having 2 to 20 carbon atoms and optionally having a substituent or an aromatic hydrocarbon group having 6 to 10 carbon atoms and optionally having a substituent,
more preferably an unsaturated chain hydrocarbon group having 2 to 10 carbon atoms and optionally having a substituent or an aromatic hydrocarbon group having 6 to 8 carbon atoms and optionally having a substituent,
further preferably an unsaturated chain hydrocarbon group having 2 to 5 carbon atoms and optionally having a substituent or an aromatic hydrocarbon group having 6 to 7 carbon atoms and optionally having a substituent, and
particularly preferably an ethenyl group optionally having a substituent, a propenyl group optionally having a substituent, a butenyl group optionally having a substituent, an ethynyl group optionally having a substituent, a propynyl group optionally having a substituent, a butynyl group optionally having a substituent, or a phenyl group optionally having a substituent.

When the unsaturated hydrocarbon group having 2 to 20 carbon atoms represented by R^{x3} has a substituent, the substituent is preferably a phenyl group.

In formula (Xb) or formula (XII),
X^{x5} to x^{x12} are each independently preferably -R^{x5} or a halogen atom.
nx5 to nx12 are each independently preferably 0 to 2 and more preferably 0 to 1.

As the aluminum phthalocyanine pigment (preferably the compound represented by formula (XI)), compounds represented by formula (XIA) to formula (XIE) are preferable.

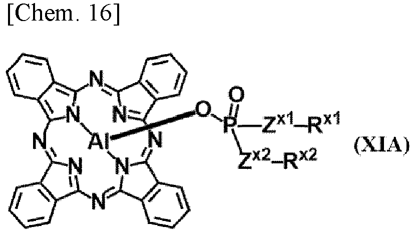

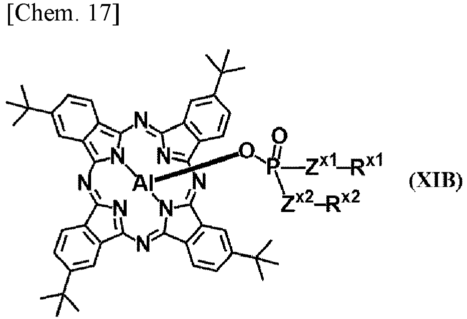

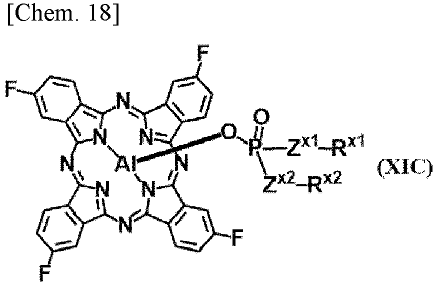

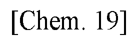

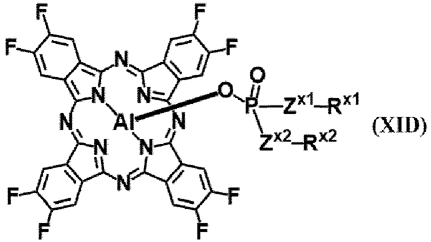

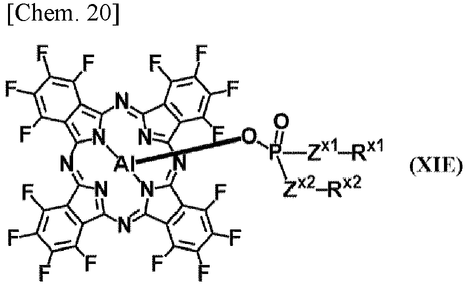

[In formula (XIA) to formula (XIE), R^{x1}, R^{x2}, Z^{x1}, and Z^{x2} are the same as above.]

Examples of the compound represented by formula (XIA) include compounds represented by formula (XIA-1) to formula (XIA-190) shown in Table 1 to Table 4.

Examples of the compound represented by formula (XIB) include compounds represented by formula (XIB-1) to formula (XIB-190) shown in Table 5 to Table 8.

Examples of the compound represented by formula (XIC) include compounds represented by formula (XIC-1) to formula (XIC-190) shown in Table 9 to Table 12.

Examples of the compound represented by formula (XID) include compounds represented by formula (XID-1) to formula (XID-190) shown in Table 13 to Table 16.

Examples of the compound represented by formula (XIE) include compounds represented by formula (XIE-1) to formula (XIE-190) shown in Table 17 to Table 20.

The symbols described in the cells for "R^{x1}" and the cells for "R^{x2}" in Table 1 to Table 3, Table 5 to Table 7, Table 9 to Table 11, Table 13 to Table 15, and Table 17 to Table 19 correspond to groups represented by formula (xi-1) to formula (xi-12) and formula (xii-1).

Also, the symbols described in the cells for "Group formed by R^{x1} and R^{x2}" in Table 4, Table 8, Table 12, Table 16, and Table 20 correspond to groups represented by formula (xca-1), formula (xca-2), formula (xcb-1), and formula (xcc-1). The "Group formed by R^{x1} and R^{x2}" represents a group bonded to a bond * in ^{∗}-Z^{x2}-P(=O)-Z^{x1}-^{∗} (* represents a bond) when R^{x2} is a single bond linking Z^{x2} and R^{x1}.

In formula (xca-1) and formula (xca-2), R^{x6} and R^{x7} each independently represent a hydrogen atom or a hydrocarbon group having 1 to 20 carbon atoms and optionally having a substituent, and examples of the hydrocarbon group having 1 to 20 carbon atoms and optionally having a substituent include the same groups as the hydrocarbon groups having 1 to 20 carbon atoms represented by R^{b1} to R^{b3}, R^{x2}, R^{x4}, R^{x5}, and R^{y1} to R^{y5}.
* represents a bond.

In formula (xcb-1), R^{x8} corresponds to a group represented by formula (xcc-1), and R^{x9} corresponds to a hydrogen atom or a hydroxy group.
* represents a bond.

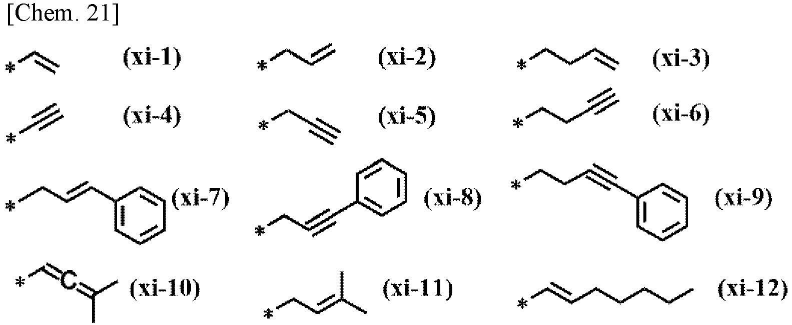

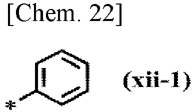

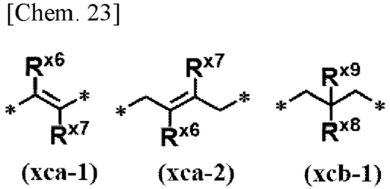

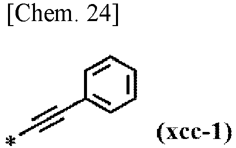

**[Table 1]**

| | **Z^{x1}** | **Z^{x2}** | **R^{x1}** | **R^{x2}** |
|---|---|---|---|---|
| **(XIA-1)** | **Single bond** | **Single bond** | **xi-1** | **xii-1** |
| **(XIA-2)** | **Single bond** | **Single bond** | **xi-2** | **xii-1** |
| **(XIA-3)** | **Single bond** | **Single bond** | **xi-3** | **xii-1** |
| **(XIA-4)** | **Single bond** | **Single bond** | **xi-4** | **xii-1** |
| **(XIA-5)** | **Single bond** | **Single bond** | **xi-5** | **xii-1** |
| **(XIA-6)** | **Single bond** | **Single bond** | **xi-6** | **xii-1** |
| **(XIA-7)** | **Single bond** | **Single bond** | **xi-7** | **xii-1** |
| **(XIA-8)** | **Single bond** | **Single bond** | **xi-8** | **xii-1** |
| **(XIA-9)** | **Single bond** | **Single bond** | **xi-9** | **xii-1** |
| **(XIA-10)** | **Single bond** | **Single bond** | **xi-10** | **xii-1** |
| **(XIA-11)** | **Single bond** | **Single bond** | **xi-11** | **xii-1** |
| **(XIA-12)** | **Single bond** | **Single bond** | **xi-12** | **xii-1** |
| **(XIA-13)** | **Single bond** | **Single bond** | **xi-1** | **xi-1** |
| **(XIA-14)** | **Single bond** | **Single bond** | **xi-2** | **xi-1** |
| **(XIA-15)** | **Single bond** | **Single bond** | **xi-3** | **xi-1** |
| **(XIA-16)** | **Single bond** | **Single bond** | **xi-4** | **xi-1** |
| **(XIA-17)** | **Single bond** | **Single bond** | **xi-5** | **xi-1** |
| **(XIA-18)** | **Single bond** | **Single bond** | **xi-6** | **xi-1** |
| **(XIA-19)** | **Single bond** | **Single bond** | **xi-7** | **xi-1** |
| **(XIA-20)** | **Single bond** | **Single bond** | **xi-8** | **xi-1** |
| **(XIA-21)** | **Single bond** | **Single bond** | **xi-9** | **xi-1** |
| **(XIA-22)** | **Single bond** | **Single bond** | **xi-10** | **xi-1** |
| **(XIA-23)** | **Single bond** | **Single bond** | **xi-11** | **xi-1** |
| **(XIA-24)** | **Single bond** | **Single bond** | **xi-12** | **xi-1** |
| **(XIA-25)** | **Single bond** | **Single bond** | **xi-2** | **xi-2** |
| **(XIA-26)** | **Single bond** | **Single bond** | **xi-3** | **xi-2** |
| **(XIA-27)** | **Single bond** | **Single bond** | **xi-4** | **xi-2** |
| **(XIA-28)** | **Single bond** | **Single bond** | **xi-5** | **xi-2** |
| **(XIA-29)** | **Single bond** | **Single bond** | **xi-6** | **xi-2** |
| **(XIA-30)** | **Single bond** | **Single bond** | **xi-7** | **xi-2** |
| **(XIA-31)** | **Single bond** | **Single bond** | **xi-8** | **xi-2** |
| **(XIA-32)** | **Single bond** | **Single bond** | **xi-9** | **xi-2** |
| **(XIA-33)** | **Single bond** | **Single bond** | **xi-10** | **xi-2** |
| **(XIA-34)** | **Single bond** | **Single bond** | **xi-11** | **xi-2** |
| **(XIA-35)** | **Single bond** | **Single bond** | **xi-12** | **xi-2** |
| **(XIA-36)** | **Single bond** | **Single bond** | **xi-3** | **xi-3** |
| **(XIA-37)** | **Single bond** | **Single bond** | **xi-4** | **xi-3** |
| **(XIA-38)** | **Single bond** | **Single bond** | **xi-5** | **xi-3** |
| **(XIA-39)** | **Single bond** | **Single bond** | **xi-6** | **xi-3** |
| **(XIA-40)** | **Single bond** | **Single bond** | **xi-7** | **xi-3** |
| **(XIA-41)** | **Single bond** | **Single bond** | **xi-8** | **xi-3** |
| **(XIA-42)** | **Single bond** | **Single bond** | **xi-9** | **xi-3** |
| **(XIA-43)** | **Single bond** | **Single bond** | **xi-10** | **xi-3** |
| **(XIA-44)** | **Single bond** | **Single bond** | **xi-11** | **xi-3** |
| **(XIA-45)** | **Single bond** | **Single bond** | **xi-12** | **xi-3** |
| **(XIA-46)** | **Single bond** | **Single bond** | **xi-4** | **xi-4** |
| **(XIA-47)** | **Single bond** | **Single bond** | **xi-5** | **xi-4** |
| **(XIA-48)** | **Single bond** | **Single bond** | **xi-6** | **xi-4** |
| **(XIA-49)** | **Single bond** | **Single bond** | **xi-7** | **xi-4** |
| **(XIA-50)** | **Single bond** | **Single bond** | **xi-8** | **xi-4** |
| **(XIA-51)** | **Single bond** | **Single bond** | **xi-9** | **xi-4** |
| **(XIA-52)** | **Single bond** | **Single bond** | **xi-10** | **xi-4** |
| **(XIA-53)** | **Single bond** | **Single bond** | **xi-11** | **xi-4** |
| **(XIA-54)** | **Single bond** | **Single bond** | **xi-12** | **xi-4** |
| **(XIA-55)** | **Single bond** | **Single bond** | **xi-5** | **xi-5** |
| **(XIA-56)** | **Single bond** | **Single bond** | **xi-6** | **xi-5** |
| **(XIA-57)** | **Single bond** | **Single bond** | **xi-7** | **xi-5** |
| **(XIA-58)** | **Single bond** | **Single bond** | **xi-8** | **xi-5** |
| **(XIA-59)** | **Single bond** | **Single bond** | **xi-9** | **xi-5** |
| **(XIA-60)** | **Single bond** | **Single bond** | **xi-10** | **xi-5** |

**[Table 2]**

| | **Z^{x1}** | **Z^{x2}** | **R^{x1}** | **R^{x2}** |
|---|---|---|---|---|
| **(XIA-61)** | **Single bond** | **Single bond** | **xi-11** | **xi-5** |
| **(XIA-62)** | **Single bond** | **Single bond** | **xi-12** | **xi-5** |
| **(XIA-63)** | **Single bond** | **Single bond** | **xi-6** | **xi-6** |
| **(XIA-64)** | **Single bond** | **Single bond** | **xi-7** | **xi-6** |
| **(XIA-65)** | **Single bond** | **Single bond** | **xi-8** | **xi-6** |
| **(XIA-66)** | **Single bond** | **Single bond** | **xi-9** | **xi-6** |
| **(XIA-67)** | **Single bond** | **Single bond** | **xi-10** | **xi-6** |
| **(XIA-68)** | **Single bond** | **Single bond** | **xi-11** | **xi-6** |
| **(XIA-69)** | **Single bond** | **Single bond** | **xi-12** | **xi-6** |
| **(XIA-70)** | **Single bond** | **Single bond** | **xi-7** | **xi-7** |
| **(XIA-71)** | **Single bond** | **Single bond** | **xi-8** | **xi-7** |
| **(XIA-72)** | **Single bond** | **Single bond** | **xi-9** | **xi-7** |
| **(XIA-73)** | **Single bond** | **Single bond** | **xi-10** | **xi-7** |
| **(XIA-74)** | **Single bond** | **Single bond** | **xi-11** | **xi-7** |
| **(XIA-75)** | **Single bond** | **Single bond** | **xi-12** | **xi-7** |
| **(XIA-76)** | **Single bond** | **Single bond** | **xi-8** | **xi-8** |
| **(XIA-77)** | **Single bond** | **Single bond** | **xi-9** | **xi-8** |
| **(XIA-78)** | **Single bond** | **Single bond** | **xi-10** | **xi-8** |
| **(XIA-79)** | **Single bond** | **Single bond** | **xi-11** | **xi-8** |
| **(XIA-80)** | **Single bond** | **Single bond** | **xi-12** | **xi-8** |
| **(XIA-81)** | **Single bond** | **Single bond** | **xi-9** | **xi-9** |
| **(XIA-82)** | **Single bond** | **Single bond** | **xi-10** | **xi-9** |
| **(XIA-83)** | **Single bond** | **Single bond** | **xi-11** | **xi-9** |
| **(XIA-84)** | **Single bond** | **Single bond** | **xi-12** | **xi-9** |
| **(XIA-85)** | **Single bond** | **Single bond** | **xi-10** | **xi-10** |
| **(XIA-86)** | **Single bond** | **Single bond** | **xi-11** | **xi-10** |
| **(XIA-87)** | **Single bond** | **Single bond** | **xi-12** | **xi-10** |
| **(XIA-88)** | **Single bond** | **Single bond** | **xi-11** | **xi-11** |
| **(XIA-89)** | **Single bond** | **Single bond** | **xi-12** | **xi-11** |
| **(XIA-90)** | **Single bond** | **Single bond** | **xi-12** | **xi-12** |
| **(XIA-91)** | **Oxygen atom** | **Oxygen atom** | **xi-1** | **xii-1** |
| **(XIA-92)** | **Oxygen atom** | **Oxygen atom** | **xi-2** | **xii-1** |
| **(XIA-93)** | **Oxygen atom** | **Oxygen atom** | **xi-3** | **xii-1** |
| **(XIA-94)** | **Oxygen atom** | **Oxygen atom** | **xi-4** | **xii-1** |
| **(XIA-95)** | **Oxygen atom** | **Oxygen atom** | **xi-5** | **xii-1** |
| **(XIA-96)** | **Oxygen atom** | **Oxygen atom** | **xi-6** | **xii-1** |
| **(XIA-97)** | **Oxygen atom** | **Oxygen atom** | **xi-7** | **xii-1** |
| **(XIA-98)** | **Oxygen atom** | **Oxygen atom** | **xi-8** | **xii-1** |
| **(XIA-99)** | **Oxygen atom** | **Oxygen atom** | **xi-9** | **xii-1** |
| **(XIA-100)** | **Oxygen atom** | **Oxygen atom** | **xi-10** | **xii-1** |
| **(XIA-101)** | **Oxygen atom** | **Oxygen atom** | **xi-11** | **xii-1** |
| **(XIA-102)** | **Oxygen atom** | **Oxygen atom** | **xi-12** | **xii-1** |
| **(XIA-103)** | **Oxygen atom** | **Oxygen atom** | **xi-1** | **xi-1** |
| **(XIA-104)** | **Oxygen atom** | **Oxygen atom** | **xi-2** | **xi-1** |
| **(XIA-105)** | **Oxygen atom** | **Oxygen atom** | **xi-3** | **xi-1** |
| **(XIA-106)** | **Oxygen atom** | **Oxygen atom** | **xi-4** | **xi-1** |
| **(XIA-107)** | **Oxygen atom** | **Oxygen atom** | **xi-5** | **xi-1** |
| **(XIA-108)** | **Oxygen atom** | **Oxygen atom** | **xi-6** | **xi-1** |
| **(XIA-109)** | **Oxygen atom** | **Oxygen atom** | **xi-7** | **xi-1** |
| **(XIA-110)** | **Oxygen atom** | **Oxygen atom** | **xi-8** | **xi-1** |
| **(XIA-111)** | **Oxygen atom** | **Oxygen atom** | **xi-9** | **xi-1** |
| **(XIA-112)** | **Oxygen atom** | **Oxygen atom** | **xi-10** | **xi-1** |
| **(XIA-113)** | **Oxygen atom** | **Oxygen atom** | **xi-11** | **xi-1** |
| **(XIA-114)** | **Oxygen atom** | **Oxygen atom** | **xi-12** | **xi-1** |
| **(XIA-115)** | **Oxygen atom** | **Oxygen atom** | **xi-2** | **xi-2** |
| **(XIA-116)** | **Oxygen atom** | **Oxygen atom** | **xi-3** | **xi-2** |
| **(XIA-117)** | **Oxygen atom** | **Oxygen atom** | **xi-4** | **xi-2** |
| **(XIA-118)** | **Oxygen atom** | **Oxygen atom** | **xi-5** | **xi-2** |
| **(XIA-119)** | **Oxygen atom** | **Oxygen atom** | **xi-6** | **xi-2** |
| **(XIA-120)** | **Oxygen atom** | **Oxygen atom** | **xi-7** | **xi-2** |

**[Table 3]**

| | **Z^{x1}** | **Z^{x2}** | **R^{x1}** | **R^{x2}** |
|---|---|---|---|---|
| **(XIA-121)** | **Oxygen atom** | **Oxygen atom** | **xi-8** | **xi-2** |
| **(XIA-122)** | **Oxygen atom** | **Oxygen atom** | **xi-9** | **xi-2** |
| **(XIA-123)** | **Oxygen atom** | **Oxygen atom** | **xi-10** | **xi-2** |
| **(XIA-124)** | **Oxygen atom** | **Oxygen atom** | **xi-11** | **xi-2** |
| **(XIA-125)** | **Oxygen atom** | **Oxygen atom** | **xi-12** | **xi-2** |
| **(XIA-126)** | **Oxygen atom** | **Oxygen atom** | **xi-3** | **xi-3** |
| **(XIA-127)** | **Oxygen atom** | **Oxygen atom** | **xi-4** | **xi-3** |
| **(XIA-128)** | **Oxygen atom** | **Oxygen atom** | **xi-5** | **xi-3** |
| **(XIA-129)** | **Oxygen atom** | **Oxygen atom** | **xi-6** | **xi-3** |
| **(XIA-130)** | **Oxygen atom** | **Oxygen atom** | **xi-7** | **xi-3** |
| **(XIA-131)** | **Oxygen atom** | **Oxygen atom** | **xi-8** | **xi-3** |
| **(XIA-132)** | **Oxygen atom** | **Oxygen atom** | **xi-9** | **xi-3** |
| **(XIA-133)** | **Oxygen atom** | **Oxygen atom** | **xi-10** | **xi-3** |
| **(XIA-134)** | **Oxygen atom** | **Oxygen atom** | **xi-11** | **xi-3** |
| **(XIA-135)** | **Oxygen atom** | **Oxygen atom** | **xi-12** | **xi-3** |
| **(XIA-136)** | **Oxygen atom** | **Oxygen atom** | **xi-4** | **xi-4** |
| **(XIA-137)** | **Oxygen atom** | **Oxygen atom** | **xi-5** | **xi-4** |
| **(XIA-138)** | **Oxygen atom** | **Oxygen atom** | **xi-6** | **xi-4** |
| **(XIA-139)** | **Oxygen atom** | **Oxygen atom** | **xi-7** | **xi-4** |
| **(XIA-140)** | **Oxygen atom** | **Oxygen atom** | **xi-8** | **xi-4** |
| **(XIA-141)** | **Oxygen atom** | **Oxygen atom** | **xi-9** | **xi-4** |
| **(XIA-142)** | **Oxygen atom** | **Oxygen atom** | **xi-10** | **xi-4** |
| **(XIA-143)** | **Oxygen atom** | **Oxygen atom** | **xi-11** | **xi-4** |
| **(XIA-144)** | **Oxygen atom** | **Oxygen atom** | **xi-12** | **xi-4** |
| **(XIA-145)** | **Oxygen atom** | **Oxygen atom** | **xi-5** | **xi-5** |
| **(XIA-146)** | **Oxygen atom** | **Oxygen atom** | **xi-6** | **xi-5** |
| **(XIA-147)** | **Oxygen atom** | **Oxygen atom** | **xi-7** | **xi-5** |
| **(XIA-148)** | **Oxygen atom** | **Oxygen atom** | **xi-8** | **xi-5** |
| **(XIA-149)** | **Oxygen atom** | **Oxygen atom** | **xi-9** | **xi-5** |
| **(XIA-150)** | **Oxygen atom** | **Oxygen atom** | **xi-10** | **xi-5** |
| **(XIA-151)** | **Oxygen atom** | **Oxygen atom** | **xi-11** | **xi-5** |
| **(XIA-152)** | **Oxygen atom** | **Oxygen atom** | **xi-12** | **xi-5** |
| **(XIA-153)** | **Oxygen atom** | **Oxygen atom** | **xi-6** | **xi-6** |
| **(XIA-154)** | **Oxygen atom** | **Oxygen atom** | **xi-7** | **xi-6** |
| **(XIA-155)** | **Oxygen atom** | **Oxygen atom** | **xi-8** | **xi-6** |
| **(XIA-156)** | **Oxygen atom** | **Oxygen atom** | **xi-9** | **xi-6** |
| **(XIA-157)** | **Oxygen atom** | **Oxygen atom** | **xi-10** | **xi-6** |
| **(XIA-158)** | **Oxygen atom** | **Oxygen atom** | **xi-11** | **xi-6** |
| **(XIA-159)** | **Oxygen atom** | **Oxygen atom** | **xi-12** | **xi-6** |
| **(XIA-160)** | **Oxygen atom** | **Oxygen atom** | **xi-7** | **xi-7** |
| **(XIA-161)** | **Oxygen atom** | **Oxygen atom** | **xi-8** | **xi-7** |
| **(XIA-162)** | **Oxygen atom** | **Oxygen atom** | **xi-9** | **xi-7** |
| **(XIA-163)** | **Oxygen atom** | **Oxygen atom** | **xi-10** | **xi-7** |
| **(XIA-164)** | **Oxygen atom** | **Oxygen atom** | **xi-11** | **xi-7** |
| **(XIA-165)** | **Oxygen atom** | **Oxygen atom** | **xi-12** | **xi-7** |
| **(XIA-166)** | **Oxygen atom** | **Oxygen atom** | **xi-8** | **xi-8** |
| **(XIA-167)** | **Oxygen atom** | **Oxygen atom** | **xi-9** | **xi-8** |
| **(XIA-168)** | **Oxygen atom** | **Oxygen atom** | **xi-10** | **xi-8** |
| **(XIA-169)** | **Oxygen atom** | **Oxygen atom** | **xi-11** | **xi-8** |
| **(XIA-170)** | **Oxygen atom** | **Oxygen atom** | **xi-12** | **xi-8** |
| **(XIA-171)** | **Oxygen atom** | **Oxygen atom** | **xi-9** | **xi-9** |
| **(XIA-172)** | **Oxygen atom** | **Oxygen atom** | **xi-10** | **xi-9** |
| **(XIA-173)** | **Oxygen atom** | **Oxygen atom** | **xi-11** | **xi-9** |
| **(XIA-174)** | **Oxygen atom** | **Oxygen atom** | **xi-12** | **xi-9** |
| **(XIA-175)** | **Oxygen atom** | **Oxygen atom** | **xi-10** | **xi-10** |
| **(XIA-176)** | **Oxygen atom** | **Oxygen atom** | **xi-11** | **xi-10** |
| **(XIA-177)** | **Oxygen atom** | **Oxygen atom** | **xi-12** | **xi-10** |
| **(XIA-178)** | **Oxygen atom** | **Oxygen atom** | **xi-11** | **xi-11** |
| **(XIA-179)** | **Oxygen atom** | **Oxygen atom** | **xi-12** | **xi-11** |
| **(XIA-180)** | **Oxygen atom** | **Oxygen atom** | **xi-12** | **xi-12** |
| **(XIA-181)** | **Single bond** | **Single bond** | **xii-1** | **xii-1** |
| **(XIA-182)** | **Oxygen atom** | **Oxygen atom** | **xii-1** | **xii-1** |

**[Table 4]**

| | **Z^{x1}** | **Z^{x2}** | **Group formed by R^{x1} and R^{x2}** | | | **Z^{x1}** | **Z^{x2}** | **Group formed by R^{x1} and R^{x2}** | **R^{x8}** | **R^{x9}** |
|---|---|---|---|---|---|---|---|---|---|---|
| **(XIA-183)** | **Oxygen atom** | **Oxygen atom** | **xca-1** | | **(XIA-187)** | **Oxygen atom** | **Oxygen atom** | **xcb-1** | **xcc-1** | **OH** |
| **(XIA-184)** | **Oxygen atom** | **Oxygen atom** | **xca-2** | | **(XIA-188)** | **Single bond** | **Single bond** | **xcb-1** | **xcc-1** | **OH** |
| **(XIA-185)** | **Single bond** | **Single bond** | **xca-1** | | **(XIA-189)** | **Oxygen atom** | **Oxygen atom** | **xcb-1** | **xcc-1** | **H** |
| **(XIA-186)** | **Single bond** | **Single bond** | **xca-2** | | **(XIA-190)** | **Single bond** | **Single bond** | **xcb-1** | **xcc-1** | **H** |

As the compound represented by formula (XIA),
the compounds represented by formula (XIA-1) to formula (XIA-12), formula (XIA-91) to formula (XIA-102), formula (XIA-103) to formula (XIA-108), formula (XIA-115) to formula (XIA-119), formula (XIA-126) to formula (XIA-129), formula (XIA-136) to formula (XIA-138), formula (XIA-145), formula (XIA-146), formula (XIA-153), and formula (XIA-181) to formula (XIA-190) are preferable,
the compounds represented by formula (XIA-1) to formula (XIA-12), formula (XIA-103) to formula (XIA-105), formula (XIA-115) to formula (XIA-116), formula (XIA-126), formula (XIA-136) to formula (XIA-138), formula (XIA-145) to formula (XIA-146), formula (XIA-153), formula (XIA-181) to formula (XIA-182), formula (XIA-183) to formula (XIA-184), formula (XIA-187) to formula (XIA-188) are more preferable,
the compounds represented by formula (XIA-1), formula (XIA-10), formula (XIA-11), formula (XIA-12), formula (XIA-115), formula (XIA-126), formula (XIA-145), formula (XIA-153), formula (XIA-181), formula (XIA-182), formula (XIA-183), formula (XIA-184), and formula (XIA-187) are further preferable, and
the compounds represented by formula (XIA-115), formula (XIA-126), and formula (XIA-182) are even further preferable.

**[Table 5]**

| | **Z^{x1}** | **Z^{x2}** | **R^{x1}** | **R^{x2}** |
|---|---|---|---|---|
| **(XIB-1)** | **Single bond** | **Single bond** | **xi-1** | **xii-1** |
| **(XIB-2)** | **Single bond** | **Single bond** | **xi-2** | **xii-1** |
| **(XIB-3)** | **Single bond** | **Single bond** | **xi-3** | **xii-1** |
| **(XIB-4)** | **Single bond** | **Single bond** | **xi-4** | **xii-1** |
| **(XIB-5)** | **Single bond** | **Single bond** | **xi-5** | **xii-1** |
| **(XIB-6)** | **Single bond** | **Single bond** | **xi-6** | **xii-1** |
| **(XIB-7)** | **Single bond** | **Single bond** | **xi-7** | **xii-1** |
| **(XIB-8)** | **Single bond** | **Single bond** | **xi-8** | **xii-1** |
| **(XIB-9)** | **Single bond** | **Single bond** | **xi-9** | **xii-1** |
| **(XIB-10)** | **Single bond** | **Single bond** | **xi-10** | **xii-1** |
| **(XIB-11)** | **Single bond** | **Single bond** | **xi-11** | **xii-1** |
| **(XIB-12)** | **Single bond** | **Single bond** | **xi-12** | **xii-1** |
| **(XIB-13)** | **Single bond** | **Single bond** | **xi-1** | **xi-1** |
| **(XIB-14)** | **Single bond** | **Single bond** | **xi-2** | **xi-1** |
| **(XIB-15)** | **Single bond** | **Single bond** | **xi-3** | **xi-1** |
| **(XIB-16)** | **Single bond** | **Single bond** | **xi-4** | **xi-1** |
| **(XIB-17)** | **Single bond** | **Single bond** | **xi-5** | **xi-1** |
| **(XIB-18)** | **Single bond** | **Single bond** | **xi-6** | **xi-1** |
| **(XIB-19)** | **Single bond** | **Single bond** | **xi-7** | **xi-1** |
| **(XIB-20)** | **Single bond** | **Single bond** | **xi-8** | **xi-1** |
| **(XIB-21)** | **Single bond** | **Single bond** | **xi-9** | **xi-1** |
| **(XIB-22)** | **Single bond** | **Single bond** | **xi-10** | **xi-1** |
| **(XIB-23)** | **Single bond** | **Single bond** | **xi-11** | **xi-1** |
| **(XIB-24)** | **Single bond** | **Single bond** | **xi-12** | **xi-1** |
| **(XIB-25)** | **Single bond** | **Single bond** | **xi-2** | **xi-2** |
| **(XIB-26)** | **Single bond** | **Single bond** | **xi-3** | **xi-2** |
| **(XIB-27)** | **Single bond** | **Single bond** | **xi-4** | **xi-2** |
| **(XIB-28)** | **Single bond** | **Single bond** | **xi-5** | **xi-2** |
| **(XIB-29)** | **Single bond** | **Single bond** | **xi-6** | **xi-2** |
| **(XIB-30)** | **Single bond** | **Single bond** | **xi-7** | **xi-2** |
| **(XIB-31)** | **Single bond** | **Single bond** | **xi-8** | **xi-2** |
| **(XIB-32)** | **Single bond** | **Single bond** | **xi-9** | **xi-2** |
| **(XIB-33)** | **Single bond** | **Single bond** | **xi-10** | **xi-2** |
| **(XIB-34)** | **Single bond** | **Single bond** | **xi-11** | **xi-2** |
| **(XIB-35)** | **Single bond** | **Single bond** | **xi-12** | **xi-2** |
| **(XIB-36)** | **Single bond** | **Single bond** | **xi-3** | **xi-3** |
| **(XIB-37)** | **Single bond** | **Single bond** | **xi-4** | **xi-3** |
| **(XIB-38)** | **Single bond** | **Single bond** | **xi-5** | **xi-3** |
| **(XIB-39)** | **Single bond** | **Single bond** | **xi-6** | **xi-3** |
| **(XIB-40)** | **Single bond** | **Single bond** | **xi-7** | **xi-3** |
| **(XIB-41)** | **Single bond** | **Single bond** | **xi-8** | **xi-3** |
| **(XIB-42)** | **Single bond** | **Single bond** | **xi-9** | **xi-3** |
| **(XIB-43)** | **Single bond** | **Single bond** | **xi-10** | **xi-3** |
| **(XIB-44)** | **Single bond** | **Single bond** | **xi-11** | **xi-3** |
| **(XIB-45)** | **Single bond** | **Single bond** | **xi-12** | **xi-3** |
| **(XIB-46)** | **Single bond** | **Single bond** | **xi-4** | **xi-4** |
| **(XIB-47)** | **Single bond** | **Single bond** | **xi-5** | **xi-4** |
| **(XIB-48)** | **Single bond** | **Single bond** | **xi-6** | **xi-4** |
| **(XIB-49)** | **Single bond** | **Single bond** | **xi-7** | **xi-4** |
| **(XIB-50)** | **Single bond** | **Single bond** | **xi-8** | **xi-4** |
| **(XIB-51)** | **Single bond** | **Single bond** | **xi-9** | **xi-4** |
| **(XIB-52)** | **Single bond** | **Single bond** | **xi-10** | **xi-4** |
| **(XIB-53)** | **Single bond** | **Single bond** | **xi-11** | **xi-4** |
| **(XIB-54)** | **Single bond** | **Single bond** | **xi-12** | **xi-4** |
| **(XIB-55)** | **Single bond** | **Single bond** | **xi-5** | **xi-5** |
| **(XIB-56)** | **Single bond** | **Single bond** | **xi-6** | **xi-5** |
| **(XIB-57)** | **Single bond** | **Single bond** | **xi-7** | **xi-5** |
| **(XIB-58)** | **Single bond** | **Single bond** | **xi-8** | **xi-5** |
| **(XIB-59)** | **Single bond** | **Single bond** | **xi-9** | **xi-5** |
| **(XIB-60)** | **Single bond** | **Single bond** | **xi-10** | **xi-5** |

**[Table 6]**

| | **Z^{x1}** | **Z^{x2}** | **R^{x1}** | **R^{x2}** |
|---|---|---|---|---|
| **(XIB-61)** | **Single bond** | **Single bond** | **xi-11** | **xi-5** |
| **(XIB-62)** | **Single bond** | **Single bond** | **xi-12** | **xi-5** |
| **(XIB-63)** | **Single bond** | **Single bond** | **xi-6** | **xi-6** |
| **(XIB-64)** | **Single bond** | **Single bond** | **xi-7** | **xi-6** |
| **(XIB-65)** | **Single bond** | **Single bond** | **xi-8** | **xi-6** |
| **(XIB-66)** | **Single bond** | **Single bond** | **xi-9** | **xi-6** |
| **(XIB-67)** | **Single bond** | **Single bond** | **xi-10** | **xi-6** |
| **(XIB-68)** | **Single bond** | **Single bond** | **xi-11** | **xi-6** |
| **(XIB-69)** | **Single bond** | **Single bond** | **xi-12** | **xi-6** |
| **(XIB-70)** | **Single bond** | **Single bond** | **xi-7** | **xi-7** |
| **(XIB-71)** | **Single bond** | **Single bond** | **xi-8** | **xi-7** |
| **(XIB-72)** | **Single bond** | **Single bond** | **xi-9** | **xi-7** |
| **(XIB-73)** | **Single bond** | **Single bond** | **xi-10** | **xi-7** |
| **(XIB-74)** | **Single bond** | **Single bond** | **xi-11** | **xi-7** |
| **(XIB-75)** | **Single bond** | **Single bond** | **xi-12** | **xi-7** |
| **(XIB-76)** | **Single bond** | **Single bond** | **xi-8** | **xi-8** |
| **(XIB-77)** | **Single bond** | **Single bond** | **xi-9** | **xi-8** |
| **(XIB-78)** | **Single bond** | **Single bond** | **xi-10** | **xi-8** |
| **(XIB-79)** | **Single bond** | **Single bond** | **xi-11** | **xi-8** |
| **(XIB-80)** | **Single bond** | **Single bond** | **xi-12** | **xi-8** |
| **(XIB-81)** | **Single bond** | **Single bond** | **xi-9** | **xi-9** |
| **(XIB-82)** | **Single bond** | **Single bond** | **xi-10** | **xi-9** |
| **(XIB-83)** | **Single bond** | **Single bond** | **xi-11** | **xi-9** |
| **(XIB-84)** | **Single bond** | **Single bond** | **xi-12** | **xi-9** |
| **(XIB-85)** | **Single bond** | **Single bond** | **xi-10** | **xi-10** |
| **(XIB-86)** | **Single bond** | **Single bond** | **xi-11** | **xi-10** |
| **(XIB-87)** | **Single bond** | **Single bond** | **xi-12** | **xi-10** |
| **(XIB-88)** | **Single bond** | **Single bond** | **xi-11** | **xi-11** |
| **(XIB-89)** | **Single bond** | **Single bond** | **xi-12** | **xi-11** |
| **(XIB-90)** | **Single bond** | **Single bond** | **xi-12** | **xi-12** |
| **(XIB-91)** | **Oxygen atom** | **Oxygen atom** | **xi-1** | **xii-1** |
| **(XIB-92)** | **Oxygen atom** | **Oxygen atom** | **xi-2** | **xii-1** |
| **(XIB-93)** | **Oxygen atom** | **Oxygen atom** | **xi-3** | **xii-1** |
| **(XIB-94)** | **Oxygen atom** | **Oxygen atom** | **xi-4** | **xii-1** |
| **(XIB-95)** | **Oxygen atom** | **Oxygen atom** | **xi-5** | **xii-1** |
| **(XIB-96)** | **Oxygen atom** | **Oxygen atom** | **xi-6** | **xii-1** |
| **(XIB-97)** | **Oxygen atom** | **Oxygen atom** | **xi-7** | **xii-1** |
| **(XIB-98)** | **Oxygen atom** | **Oxygen atom** | **xi-8** | **xii-1** |
| **(XIB-99)** | **Oxygen atom** | **Oxygen atom** | **xi-9** | **xii-1** |
| **(XIB-100)** | **Oxygen atom** | **Oxygen atom** | **xi-10** | **xii-1** |
| **(XIB-101)** | **Oxygen atom** | **Oxygen atom** | **xi-11** | **xii-1** |
| **(XIB-102)** | **Oxygen atom** | **Oxygen atom** | **xi-12** | **xii-1** |
| **(XIB-103)** | **Oxygen atom** | **Oxygen atom** | **xi-1** | **xi-1** |
| **(XIB-104)** | **Oxygen atom** | **Oxygen atom** | **xi-2** | **xi-1** |
| **(XIB-105)** | **Oxygen atom** | **Oxygen atom** | **xi-3** | **xi-1** |
| **(XIB-106)** | **Oxygen atom** | **Oxygen atom** | **xi-4** | **xi-1** |
| **(XIB-107)** | **Oxygen atom** | **Oxygen atom** | **xi-5** | **xi-1** |
| **(XIB-108)** | **Oxygen atom** | **Oxygen atom** | **xi-6** | **xi-1** |
| **(XIB-109)** | **Oxygen atom** | **Oxygen atom** | **xi-7** | **xi-1** |
| **(XIB-110)** | **Oxygen atom** | **Oxygen atom** | **xi-8** | **xi-1** |
| **(XIB-111)** | **Oxygen atom** | **Oxygen atom** | **xi-9** | **xi-1** |
| **(XIB-112)** | **Oxygen atom** | **Oxygen atom** | **xi-10** | **xi-1** |
| **(XIB-113)** | **Oxygen atom** | **Oxygen atom** | **xi-11** | **xi-1** |
| **(XIB-114)** | **Oxygen atom** | **Oxygen atom** | **xi-12** | **xi-1** |
| **(XIB-115)** | **Oxygen atom** | **Oxygen atom** | **xi-2** | **xi-2** |
| **(XIB-116)** | **Oxygen atom** | **Oxygen atom** | **xi-3** | **xi-2** |
| **(XIB-117)** | **Oxygen atom** | **Oxygen atom** | **xi-4** | **xi-2** |
| **(XIB-118)** | **Oxygen atom** | **Oxygen atom** | **xi-5** | **xi-2** |
| **(XIB-119)** | **Oxygen atom** | **Oxygen atom** | **xi-6** | **xi-2** |
| **(XIB-120)** | **Oxygen atom** | **Oxygen atom** | **xi-7** | **xi-2** |

**[Table 7]**

| | **Z^{x1}** | **Z^{x2}** | **R^{x1}** | **R^{x2}** |
|---|---|---|---|---|
| **(XIB-121)** | **Oxygen atom** | **Oxygen atom** | **xi-8** | **xi-2** |
| **(XIB-122)** | **Oxygen atom** | **Oxygen atom** | **xi-9** | **xi-2** |
| **(XIB-123)** | **Oxygen atom** | **Oxygen atom** | **xi-10** | **xi-2** |
| **(XIB-124)** | **Oxygen atom** | **Oxygen atom** | **xi-11** | **xi-2** |
| **(XIB-125)** | **Oxygen atom** | **Oxygen atom** | **xi-12** | **xi-2** |
| **(XIB-126)** | **Oxygen atom** | **Oxygen atom** | **xi-3** | **xi-3** |
| **(XIB-127)** | **Oxygen atom** | **Oxygen atom** | **xi-4** | **xi-3** |
| **(XIB-128)** | **Oxygen atom** | **Oxygen atom** | **xi-5** | **xi-3** |
| **(XIB-129)** | **Oxygen atom** | **Oxygen atom** | **xi-6** | **xi-3** |
| **(XIB-130)** | **Oxygen atom** | **Oxygen atom** | **xi-7** | **xi-3** |
| **(XIB-131)** | **Oxygen atom** | **Oxygen atom** | **xi-8** | **xi-3** |
| **(XIB-132)** | **Oxygen atom** | **Oxygen atom** | **xi-9** | **xi-3** |
| **(XIB-133)** | **Oxygen atom** | **Oxygen atom** | **xi-10** | **xi-3** |
| **(XIB-134)** | **Oxygen atom** | **Oxygen atom** | **xi-11** | **xi-3** |
| **(XIB-135)** | **Oxygen atom** | **Oxygen atom** | **xi-12** | **xi-3** |
| **(XIB-136)** | **Oxygen atom** | **Oxygen atom** | **xi-4** | **xi-4** |
| **(XIB-137)** | **Oxygen atom** | **Oxygen atom** | **xi-5** | **xi-4** |
| **(XIB-138)** | **Oxygen atom** | **Oxygen atom** | **xi-6** | **xi-4** |
| **(XIB-139)** | **Oxygen atom** | **Oxygen atom** | **xi-7** | **xi-4** |
| **(XIB-140)** | **Oxygen atom** | **Oxygen atom** | **xi-8** | **xi-4** |
| **(XIB-141)** | **Oxygen atom** | **Oxygen atom** | **xi-9** | **xi-4** |
| **(XIB-142)** | **Oxygen atom** | **Oxygen atom** | **xi-10** | **xi-4** |
| **(XIB-143)** | **Oxygen atom** | **Oxygen atom** | **xi-11** | **xi-4** |
| **(XIB-144)** | **Oxygen atom** | **Oxygen atom** | **xi-12** | **xi-4** |
| **(XIB-145)** | **Oxygen atom** | **Oxygen atom** | **xi-5** | **xi-5** |
| **(XIB-146)** | **Oxygen atom** | **Oxygen atom** | **xi-6** | **xi-5** |
| **(XIB-147)** | **Oxygen atom** | **Oxygen atom** | **xi-7** | **xi-5** |
| **(XIB-148)** | **Oxygen atom** | **Oxygen atom** | **xi-8** | **xi-5** |
| **(XIB-149)** | **Oxygen atom** | **Oxygen atom** | **xi-9** | **xi-5** |
| **(XIB-150)** | **Oxygen atom** | **Oxygen atom** | **xi-10** | **xi-5** |
| **(XIB-151)** | **Oxygen atom** | **Oxygen atom** | **xi-11** | **xi-5** |
| **(XIB-152)** | **Oxygen atom** | **Oxygen atom** | **xi-12** | **xi-5** |
| **(XIB-153)** | **Oxygen atom** | **Oxygen atom** | **xi-6** | **xi-6** |
| **(XIB-154)** | **Oxygen atom** | **Oxygen atom** | **xi-7** | **xi-6** |
| **(XIB-155)** | **Oxygen atom** | **Oxygen atom** | **xi-8** | **xi-6** |
| **(XIB-156)** | **Oxygen atom** | **Oxygen atom** | **xi-9** | **xi-6** |
| **(XIB-157)** | **Oxygen atom** | **Oxygen atom** | **xi-10** | **xi-6** |
| **(XIB-158)** | **Oxygen atom** | **Oxygen atom** | **xi-11** | **xi-6** |
| **(XIB-159)** | **Oxygen atom** | **Oxygen atom** | **xi-12** | **xi-6** |
| **(XIB-160)** | **Oxygen atom** | **Oxygen atom** | **xi-7** | **xi-7** |
| **(XIB-161)** | **Oxygen atom** | **Oxygen atom** | **xi-8** | **xi-7** |
| **(XIB-162)** | **Oxygen atom** | **Oxygen atom** | **xi-9** | **xi-7** |
| **(XIB-163)** | **Oxygen atom** | **Oxygen atom** | **xi-10** | **xi-7** |
| **(XIB-164)** | **Oxygen atom** | **Oxygen atom** | **xi-11** | **xi-7** |
| **(XIB-165)** | **Oxygen atom** | **Oxygen atom** | **xi-12** | **xi-7** |
| **(XIB-166)** | **Oxygen atom** | **Oxygen atom** | **xi-8** | **xi-8** |
| **(XIB-167)** | **Oxygen atom** | **Oxygen atom** | **xi-9** | **xi-8** |
| **(XIB-168)** | **Oxygen atom** | **Oxygen atom** | **xi-10** | **xi-8** |
| **(XIB-169)** | **Oxygen atom** | **Oxygen atom** | **xi-11** | **xi-8** |
| **(XIB-170)** | **Oxygen atom** | **Oxygen atom** | **xi-12** | **xi-8** |
| **(XIB-171)** | **Oxygen atom** | **Oxygen atom** | **xi-9** | **xi-9** |
| **(XIB-172)** | **Oxygen atom** | **Oxygen atom** | **xi-10** | **xi-9** |
| **(XIB-173)** | **Oxygen atom** | **Oxygen atom** | **xi-11** | **xi-9** |
| **(XIB-174)** | **Oxygen atom** | **Oxygen atom** | **xi-12** | **xi-9** |
| **(XIB-175)** | **Oxygen atom** | **Oxygen atom** | **xi-10** | **xi-10** |
| **(XIB-176)** | **Oxygen atom** | **Oxygen atom** | **xi-11** | **xi-10** |
| **(XIB-177)** | **Oxygen atom** | **Oxygen atom** | **xi-12** | **xi-10** |
| **(XIB-178)** | **Oxygen atom** | **Oxygen atom** | **xi-11** | **xi-11** |
| **(XIB-179)** | **Oxygen atom** | **Oxygen atom** | **xi-12** | **xi-11** |
| **(XIB-180)** | **Oxygen atom** | **Oxygen atom** | **xi-12** | **xi-12** |
| **(XIB-181)** | **Single bond** | **Single bond** | **xii-1** | **xii-1** |
| **(XIB-182)** | **Oxygen atom** | **Oxygen atom** | **xii-1** | **xii-1** |

**[Table 8]**

| | **Z^{x1}** | **Z^{x2}** | **Group formed by R^{x1} and R^{x2}** | | | **Z^{x1}** | **Z^{x2}** | **Group formed by R^{x1} and R^{x2}** | **R^{x8}** | **R^{x9}** |
|---|---|---|---|---|---|---|---|---|---|---|
| **(XIA-183)** | **Oxygen atom** | **Oxygen atom** | **xca-1** | | **(XIA-187)** | **Oxygen atom** | **Oxygen atom** | **xcb-1** | **xcc-1** | **OH** |
| **(XIA-184)** | **Oxygen atom** | **Oxygen atom** | **xca-2** | | **(XIA-188)** | **Single bond** | **Single bond** | **xcb-1** | **xcc-1** | **OH** |
| **(XIA-185)** | **Single bond** | **Single bond** | **xca-1** | | **(XIA-189)** | **Oxygen atom** | **Oxygen atom** | **xcb-1** | **xcc-1** | **H** |
| **(XIA-186)** | **Single bond** | **Single bond** | **xca-2** | | **(XIA-190)** | **Single bond** | **Single bond** | **xcb-1** | **xcc-1** | **H** |

As the compound represented by formula (XIB),
the compounds represented by formula (XIB-1) to formula (XIB-12), formula (XIB-91) to formula (XIB-102), formula (XIB-103) to formula (XIB-108), formula (XIB-115) to formula (XIB-119), formula (XIB-126) to formula (XIB-129), formula (XIB-136) to formula (XIB-138), formula (XIB-145) to formula (XIB-146), formula (XIB-153), and formula (XIB-181) to formula (XIB-190) are preferable,
the compounds represented by formula (XIB-1) to formula (XIB-12) are more preferable, and
the compound represented by formula (XIB-1) is further preferable.

**[Table 9]**

| | **Z^{x1}** | **Z^{x2}** | **R^{x1}** | **R^{x2}** |
|---|---|---|---|---|
| **(XIC-1)** | **Single bond** | **Single bond** | **xi-1** | **xii-1** |
| **(XIC-2)** | **Single bond** | **Single bond** | **xi-2** | **xii-1** |
| **(XIC-3)** | **Single bond** | **Single bond** | **xi-3** | **xii-1** |
| **(XIC-4)** | **Single bond** | **Single bond** | **xi-4** | **xii-1** |
| **(XIC-5)** | **Single bond** | **Single bond** | **xi-5** | **xii-1** |
| **(XIC-6)** | **Single bond** | **Single bond** | **xi-6** | **xii-1** |
| **(XIC-7)** | **Single bond** | **Single bond** | **xi-7** | **xii-1** |
| **(XIC-8)** | **Single bond** | **Single bond** | **xi-8** | **xii-1** |
| **(XIC-9)** | **Single bond** | **Single bond** | **xi-9** | **xii-1** |
| **(XIC-10)** | **Single bond** | **Single bond** | **xi-10** | **xii-1** |
| **(XIC-11)** | **Single bond** | **Single bond** | **xi-11** | **xii-1** |
| **(XIC-12)** | **Single bond** | **Single bond** | **xi-12** | **xii-1** |
| **(XIC-13)** | **Single bond** | **Single bond** | **xi-1** | **xi-1** |
| **(XIC-14)** | **Single bond** | **Single bond** | **xi-2** | **xi-1** |
| **(XIC-15)** | **Single bond** | **Single bond** | **xi-3** | **xi-1** |
| **(XIC-16)** | **Single bond** | **Single bond** | **xi-4** | **xi-1** |
| **(XIC-17)** | **Single bond** | **Single bond** | **xi-5** | **xi-1** |
| **(XIC-18)** | **Single bond** | **Single bond** | **xi-6** | **xi-1** |
| **(XIC-19)** | **Single bond** | **Single bond** | **xi-7** | **xi-1** |
| **(XIC-20)** | **Single bond** | **Single bond** | **xi-8** | **xi-1** |
| **(XIC-21)** | **Single bond** | **Single bond** | **xi-9** | **xi-1** |
| **(XIC-22)** | **Single bond** | **Single bond** | **xi-10** | **xi-1** |
| **(XIC-23)** | **Single bond** | **Single bond** | **xi-11** | **xi-1** |
| **(XIC-24)** | **Single bond** | **Single bond** | **xi-12** | **xi-1** |
| **(XIC-25)** | **Single bond** | **Single bond** | **xi-2** | **xi-2** |
| **(XIC-26)** | **Single bond** | **Single bond** | **xi-3** | **xi-2** |
| **(XIC-27)** | **Single bond** | **Single bond** | **xi-4** | **xi-2** |
| **(XIC-28)** | **Single bond** | **Single bond** | **xi-5** | **xi-2** |
| **(XIC-29)** | **Single bond** | **Single bond** | **xi-6** | **xi-2** |
| **(XIC-30)** | **Single bond** | **Single bond** | **xi-7** | **xi-2** |
| **(XIC-31)** | **Single bond** | **Single bond** | **xi-8** | **xi-2** |
| **(XIC-32)** | **Single bond** | **Single bond** | **xi-9** | **xi-2** |
| **(XIC-33)** | **Single bond** | **Single bond** | **xi-10** | **xi-2** |
| **(XIC-34)** | **Single bond** | **Single bond** | **xi-11** | **xi-2** |
| **(XIC-35)** | **Single bond** | **Single bond** | **xi-12** | **xi-2** |
| **(XIC-36)** | **Single bond** | **Single bond** | **xi-3** | **xi-3** |
| **(XIC-37)** | **Single bond** | **Single bond** | **xi-4** | **xi-3** |
| **(XIC-38)** | **Single bond** | **Single bond** | **xi-5** | **xi-3** |
| **(XIC-39)** | **Single bond** | **Single bond** | **xi-6** | **xi-3** |
| **(XIC-40)** | **Single bond** | **Single bond** | **xi-7** | **xi-3** |
| **(XIC-41)** | **Single bond** | **Single bond** | **xi-8** | **xi-3** |
| **(XIC-42)** | **Single bond** | **Single bond** | **xi-9** | **xi-3** |
| **(XIC-43)** | **Single bond** | **Single bond** | **xi-10** | **xi-3** |
| **(XIC-44)** | **Single bond** | **Single bond** | **xi-11** | **xi-3** |
| **(XIC-45)** | **Single bond** | **Single bond** | **xi-12** | **xi-3** |
| **(XIC-46)** | **Single bond** | **Single bond** | **xi-4** | **xi-4** |
| **(XIC-47)** | **Single bond** | **Single bond** | **xi-5** | **xi-4** |
| **(XIC-48)** | **Single bond** | **Single bond** | **xi-6** | **xi-4** |
| **(XIC-49)** | **Single bond** | **Single bond** | **xi-7** | **xi-4** |
| **(XIC-50)** | **Single bond** | **Single bond** | **xi-8** | **xi-4** |
| **(XIC-51)** | **Single bond** | **Single bond** | **xi-9** | **xi-4** |
| **(XIC-52)** | **Single bond** | **Single bond** | **xi-10** | **xi-4** |
| **(XIC-53)** | **Single bond** | **Single bond** | **xi-11** | **xi-4** |
| **(XIC-54)** | **Single bond** | **Single bond** | **xi-12** | **xi-4** |
| **(XIC-55)** | **Single bond** | **Single bond** | **xi-5** | **xi-5** |
| **(XIC-56)** | **Single bond** | **Single bond** | **xi-6** | **xi-5** |
| **(XIC-57)** | **Single bond** | **Single bond** | **xi-7** | **xi-5** |
| **(XIC-58)** | **Single bond** | **Single bond** | **xi-8** | **xi-5** |
| **(XIC-59)** | **Single bond** | **Single bond** | **xi-9** | **xi-5** |
| **(XIC-60)** | **Single bond** | **Single bond** | **xi-10** | **xi-5** |

**[Table 10]**

| | **Z^{x1}** | **Z^{x2}** | **R^{x1}** | **R^{x2}** |
|---|---|---|---|---|
| **(XIC-61)** | **Single bond** | **Single bond** | **xi-11** | **xi-5** |
| **(XIC-62)** | **Single bond** | **Single bond** | **xi-12** | **xi-5** |
| **(XIC-63)** | **Single bond** | **Single bond** | **xi-6** | **xi-6** |
| **(XIC-64)** | **Single bond** | **Single bond** | **xi-7** | **xi-6** |
| **(XIC-65)** | **Single bond** | **Single bond** | **xi-8** | **xi-6** |
| **(XIC-66)** | **Single bond** | **Single bond** | **xi-9** | **xi-6** |
| **(XIC-67)** | **Single bond** | **Single bond** | **xi-10** | **xi-6** |
| **(XIC-68)** | **Single bond** | **Single bond** | **xi-11** | **xi-6** |
| **(XIC-69)** | **Single bond** | **Single bond** | **xi-12** | **xi-6** |
| **(XIC-70)** | **Single bond** | **Single bond** | **xi-7** | **xi-7** |
| **(XIC-71)** | **Single bond** | **Single bond** | **xi-8** | **xi-7** |
| **(XIC-72)** | **Single bond** | **Single bond** | **xi-9** | **xi-7** |
| **(XIC-73)** | **Single bond** | **Single bond** | **xi-10** | **xi-7** |
| **(XIC-74)** | **Single bond** | **Single bond** | **xi-11** | **xi-7** |
| **(XIC-75)** | **Single bond** | **Single bond** | **xi-12** | **xi-7** |
| **(XIC-76)** | **Single bond** | **Single bond** | **xi-8** | **xi-8** |
| **(XIC-77)** | **Single bond** | **Single bond** | **xi-9** | **xi-8** |
| **(XIC-78)** | **Single bond** | **Single bond** | **xi-10** | **xi-8** |
| **(XIC-79)** | **Single bond** | **Single bond** | **xi-11** | **xi-8** |
| **(XIC-80)** | **Single bond** | **Single bond** | **xi-12** | **xi-8** |
| **(XIC-81)** | **Single bond** | **Single bond** | **xi-9** | **xi-9** |
| **(XIC-82)** | **Single bond** | **Single bond** | **xi-10** | **xi-9** |
| **(XIC-83)** | **Single bond** | **Single bond** | **xi-11** | **xi-9** |
| **(XIC-84)** | **Single bond** | **Single bond** | **xi-12** | **xi-9** |
| **(XIC-85)** | **Single bond** | **Single bond** | **xi-10** | **xi-10** |
| **(XIC-86)** | **Single bond** | **Single bond** | **xi-11** | **xi-10** |
| **(XIC-87)** | **Single bond** | **Single bond** | **xi-12** | **xi-10** |
| **(XIC-88)** | **Single bond** | **Single bond** | **xi-11** | **xi-11** |
| **(XIC-89)** | **Single bond** | **Single bond** | **xi-12** | **xi-11** |
| **(XIC-90)** | **Single bond** | **Single bond** | **xi-12** | **xi-12** |
| **(XIC-91)** | **Oxygen atom** | **Oxygen atom** | **xi-1** | **xii-1** |
| **(XIC-92)** | **Oxygen atom** | **Oxygen atom** | **xi-2** | **xii-1** |
| **(XIC-93)** | **Oxygen atom** | **Oxygen atom** | **xi-3** | **xii-1** |
| **(XIC-94)** | **Oxygen atom** | **Oxygen atom** | **xi-4** | **xii-1** |
| **(XIC-95)** | **Oxygen atom** | **Oxygen atom** | **xi-5** | **xii-1** |
| **(XIC-96)** | **Oxygen atom** | **Oxygen atom** | **xi-6** | **xii-1** |
| **(XIC-97)** | **Oxygen atom** | **Oxygen atom** | **xi-7** | **xii-1** |
| **(XIC-98)** | **Oxygen atom** | **Oxygen atom** | **xi-8** | **xii-1** |
| **(XIC-99)** | **Oxygen atom** | **Oxygen atom** | **xi-9** | **xii-1** |
| **(XIC-100)** | **Oxygen atom** | **Oxygen atom** | **xi-10** | **xii-1** |
| **(XIC-101)** | **Oxygen atom** | **Oxygen atom** | **xi-11** | **xii-1** |
| **(XIC-102)** | **Oxygen atom** | **Oxygen atom** | **xi-12** | **xii-1** |
| **(XIC-103)** | **Oxygen atom** | **Oxygen atom** | **xi-1** | **xi-1** |
| **(XIC-104)** | **Oxygen atom** | **Oxygen atom** | **xi-2** | **xi-1** |
| **(XIC-105)** | **Oxygen atom** | **Oxygen atom** | **xi-3** | **xi-1** |
| **(XIC-106)** | **Oxygen atom** | **Oxygen atom** | **xi-4** | **xi-1** |
| **(XIC-107)** | **Oxygen atom** | **Oxygen atom** | **xi-5** | **xi-1** |
| **(XIC-108)** | **Oxygen atom** | **Oxygen atom** | **xi-6** | **xi-1** |
| **(XIC-109)** | **Oxygen atom** | **Oxygen atom** | **xi-7** | **xi-1** |
| **(XIC-110)** | **Oxygen atom** | **Oxygen atom** | **xi-8** | **xi-1** |
| **(XIC-111)** | **Oxygen atom** | **Oxygen atom** | **xi-9** | **xi-1** |
| **(XIC-112)** | **Oxygen atom** | **Oxygen atom** | **xi-10** | **xi-1** |
| **(XIC-113)** | **Oxygen atom** | **Oxygen atom** | **xi-11** | **xi-1** |
| **(XIC-114)** | **Oxygen atom** | **Oxygen atom** | **xi-12** | **xi-1** |
| **(XIC-115)** | **Oxygen atom** | **Oxygen atom** | **xi-2** | **xi-2** |
| **(XIC-116)** | **Oxygen atom** | **Oxygen atom** | **xi-3** | **xi-2** |
| **(XIC-117)** | **Oxygen atom** | **Oxygen atom** | **xi-4** | **xi-2** |
| **(XIC-118)** | **Oxygen atom** | **Oxygen atom** | **xi-5** | **xi-2** |
| **(XIC-119)** | **Oxygen atom** | **Oxygen atom** | **xi-6** | **xi-2** |
| **(XIC-120)** | **Oxygen atom** | **Oxygen atom** | **xi-7** | **xi-2** |

**[Table 11]**

| | **Z^{x1}** | **Z^{x2}** | **R^{x1}** | **R^{x2}** |
|---|---|---|---|---|
| **(XIC-121)** | **Oxygen atom** | **Oxygen atom** | **xi-8** | **xi-2** |
| **(XIC-122)** | **Oxygen atom** | **Oxygen atom** | **xi-9** | **xi-2** |
| **(XIC-123)** | **Oxygen atom** | **Oxygen atom** | **xi-10** | **xi-2** |
| **(XIC-124)** | **Oxygen atom** | **Oxygen atom** | **xi-11** | **xi-2** |
| **(XIC-125)** | **Oxygen atom** | **Oxygen atom** | **xi-12** | **xi-2** |
| **(XIC-126)** | **Oxygen atom** | **Oxygen atom** | **xi-3** | **xi-3** |
| **(XIC-127)** | **Oxygen atom** | **Oxygen atom** | **xi-4** | **xi-3** |
| **(XIC-128)** | **Oxygen atom** | **Oxygen atom** | **xi-5** | **xi-3** |
| **(XIC-129)** | **Oxygen atom** | **Oxygen atom** | **xi-6** | **xi-3** |
| **(XIC-130)** | **Oxygen atom** | **Oxygen atom** | **xi-7** | **xi-3** |
| **(XIC-131)** | **Oxygen atom** | **Oxygen atom** | **xi-8** | **xi-3** |
| **(XIC-132)** | **Oxygen atom** | **Oxygen atom** | **xi-9** | **xi-3** |
| **(XIC-133)** | **Oxygen atom** | **Oxygen atom** | **xi-10** | **xi-3** |
| **(XIC-134)** | **Oxygen atom** | **Oxygen atom** | **xi-11** | **xi-3** |
| **(XIC-135)** | **Oxygen atom** | **Oxygen atom** | **xi-12** | **xi-3** |
| **(XIC-136)** | **Oxygen atom** | **Oxygen atom** | **xi-4** | **xi-4** |
| **(XIC-137)** | **Oxygen atom** | **Oxygen atom** | **xi-5** | **xi-4** |
| **(XIC-138)** | **Oxygen atom** | **Oxygen atom** | **xi-6** | **xi-4** |
| **(XIC-139)** | **Oxygen atom** | **Oxygen atom** | **xi-7** | **xi-4** |
| **(XIC-140)** | **Oxygen atom** | **Oxygen atom** | **xi-8** | **xi-4** |
| **(XIC-141)** | **Oxygen atom** | **Oxygen atom** | **xi-9** | **xi-4** |
| **(XIC-142)** | **Oxygen atom** | **Oxygen atom** | **xi-10** | **xi-4** |
| **(XIC-143)** | **Oxygen atom** | **Oxygen atom** | **xi-11** | **xi-4** |
| **(XIC-144)** | **Oxygen atom** | **Oxygen atom** | **xi-12** | **xi-4** |
| **(XIC-145)** | **Oxygen atom** | **Oxygen atom** | **xi-5** | **xi-5** |
| **(XIC-146)** | **Oxygen atom** | **Oxygen atom** | **xi-6** | **xi-5** |
| **(XIC-147)** | **Oxygen atom** | **Oxygen atom** | **xi-7** | **xi-5** |
| **(XIC-148)** | **Oxygen atom** | **Oxygen atom** | **xi-8** | **xi-5** |
| **(XIC-149)** | **Oxygen atom** | **Oxygen atom** | **xi-9** | **xi-5** |
| **(XIC-150)** | **Oxygen atom** | **Oxygen atom** | **xi-10** | **xi-5** |
| **(XIC-151)** | **Oxygen atom** | **Oxygen atom** | **xi-11** | **xi-5** |
| **(XIC-152)** | **Oxygen atom** | **Oxygen atom** | **xi-12** | **xi-5** |
| **(XIC-153)** | **Oxygen atom** | **Oxygen atom** | **xi-6** | **xi-6** |
| **(XIC-154)** | **Oxygen atom** | **Oxygen atom** | **xi-7** | **xi-6** |
| **(XIC-155)** | **Oxygen atom** | **Oxygen atom** | **xi-8** | **xi-6** |
| **(XIC-156)** | **Oxygen atom** | **Oxygen atom** | **xi-9** | **xi-6** |
| **(XIC-157)** | **Oxygen atom** | **Oxygen atom** | **xi-10** | **xi-6** |
| **(XIC-158)** | **Oxygen atom** | **Oxygen atom** | **xi-11** | **xi-6** |
| **(XIC-159)** | **Oxygen atom** | **Oxygen atom** | **xi-12** | **xi-6** |
| **(XIC-160)** | **Oxygen atom** | **Oxygen atom** | **xi-7** | **xi-7** |
| **(XIC-161)** | **Oxygen atom** | **Oxygen atom** | **xi-8** | **xi-7** |
| **(XIC-162)** | **Oxygen atom** | **Oxygen atom** | **xi-9** | **xi-7** |
| **(XIC-163)** | **Oxygen atom** | **Oxygen atom** | **xi-10** | **xi-7** |
| **(XIC-164)** | **Oxygen atom** | **Oxygen atom** | **xi-11** | **xi-7** |
| **(XIC-165)** | **Oxygen atom** | **Oxygen atom** | **xi-12** | **xi-7** |
| **(XIC-166)** | **Oxygen atom** | **Oxygen atom** | **xi-8** | **xi-8** |
| **(XIC-167)** | **Oxygen atom** | **Oxygen atom** | **xi-9** | **xi-8** |
| **(XIC-168)** | **Oxygen atom** | **Oxygen atom** | **xi-10** | **xi-8** |
| **(XIC-169)** | **Oxygen atom** | **Oxygen atom** | **xi-11** | **xi-8** |
| **(XIC-170)** | **Oxygen atom** | **Oxygen atom** | **xi-12** | **xi-8** |
| **(XIC-171)** | **Oxygen atom** | **Oxygen atom** | **xi-9** | **xi-9** |
| **(XIC-172)** | **Oxygen atom** | **Oxygen atom** | **xi-10** | **xi-9** |
| **(XIC-173)** | **Oxygen atom** | **Oxygen atom** | **xi-11** | **xi-9** |
| **(XIC-174)** | **Oxygen atom** | **Oxygen atom** | **xi-12** | **xi-9** |
| **(XIC-175)** | **Oxygen atom** | **Oxygen atom** | **xi-10** | **xi-10** |
| **(XIC-176)** | **Oxygen atom** | **Oxygen atom** | **xi-11** | **xi-10** |
| **(XIC-177)** | **Oxygen atom** | **Oxygen atom** | **xi-12** | **xi-10** |
| **(XIC-178)** | **Oxygen atom** | **Oxygen atom** | **xi-11** | **xi-11** |
| **(XIC-179)** | **Oxygen atom** | **Oxygen atom** | **xi-12** | **xi-11** |
| **(XIC-180)** | **Oxygen atom** | **Oxygen atom** | **xi-12** | **xi-12** |
| **(XIC-181)** | **Single bond** | **Single bond** | **xii-1** | **xii-1** |
| **(XIC-182)** | **Oxygen atom** | **Oxygen atom** | **xii-1** | **xii-1** |

**[Table 12]**

| | **Z^{x1}** | **Z^{x2}** | **Group formed by R^{x1} and R^{x2}** | | | **Z^{x1}** | **Z^{x2}** | **Group formed by R^{x1} and R^{x2}** | **R^{x8}** | **R^{x9}** |
|---|---|---|---|---|---|---|---|---|---|---|
| **(XIA-183)** | **Oxygen atom** | **Oxygen atom** | **xca-1** | | **(XIA-187)** | **Oxygen atom** | **Oxygen atom** | **xcb-1** | **xcc-1** | **OH** |
| **(XIA-184)** | **Oxygen atom** | **Oxygen atom** | **xca-2** | | **(XIA-188)** | **Single bond** | **Single bond** | **xcb-1** | **xcc-1** | **OH** |
| **(XIA-185)** | **Single bond** | **Single bond** | **xca-1** | | **(XIA-189)** | **Oxygen atom** | **Oxygen atom** | **xcb-1** | **xcc-1** | **H** |
| **(XIA-186)** | **Single bond** | **Single bond** | **xca-2** | | **(XIA-190)** | **Single bond** | **Single bond** | **xcb-1** | **xcc-1** | **H** |

As the compound represented by formula (XIC),
the compounds represented by formula (XIC-1) to formula (XIC-12), formula (XIC-91) to formula (XIC-102), formula (XIC-103) to formula (XIC-108), formula (XIC-115) to formula (XIC-119), formula (XIC-126) to formula (XIC-129), formula (XIC-136) to formula (XIC-138), formula (XIC-145) to formula (XIC-146), formula (XIC-153), and formula (XIC-181) to formula (XIC-190) are preferable,
the compounds represented by formula (XIC-1) to formula (XIC-12), formula (XIC-103) to formula (XIC-105), formula (XIC-115) to formula (XIC-116), and formula (XIC-126) are more preferable, and
the compounds represented by formula (XIC-1) and formula (XIC-115) are further preferable.

**[Table 13]**

| | **Z^{x1}** | **Z^{x2}** | **R^{x1}** | **R^{x2}** |
|---|---|---|---|---|
| **(XID-1)** | **Single bond** | **Single bond** | **xi-1** | **xii-1** |
| **(XID-2)** | **Single bond** | **Single bond** | **xi-2** | **xii-1** |
| **(XID-3)** | **Single bond** | **Single bond** | **xi-3** | **xii-1** |
| **(XID-4)** | **Single bond** | **Single bond** | **xi-4** | **xii-1** |
| **(XID-5)** | **Single bond** | **Single bond** | **xi-5** | **xii-1** |
| **(XID-6)** | **Single bond** | **Single bond** | **xi-6** | **xii-1** |
| **(XID-7)** | **Single bond** | **Single bond** | **xi-7** | **xii-1** |
| **(XID-8)** | **Single bond** | **Single bond** | **xi-8** | **xii-1** |
| **(XID-9)** | **Single bond** | **Single bond** | **xi-9** | **xii-1** |
| **(XID-10)** | **Single bond** | **Single bond** | **xi-10** | **xii-1** |
| **(XID-11)** | **Single bond** | **Single bond** | **xi-11** | **xii-1** |
| **(XID-12)** | **Single bond** | **Single bond** | **xi-12** | **xii-1** |
| **(XID-13)** | **Single bond** | **Single bond** | **xi-1** | **xi-1** |
| **(XID-14)** | **Single bond** | **Single bond** | **xi-2** | **xi-1** |
| **(XID-15)** | **Single bond** | **Single bond** | **xi-3** | **xi-1** |
| **(XID-16)** | **Single bond** | **Single bond** | **xi-4** | **xi-1** |
| **(XID-17)** | **Single bond** | **Single bond** | **xi-5** | **xi-1** |
| **(XID-18)** | **Single bond** | **Single bond** | **xi-6** | **xi-1** |
| **(XID-19)** | **Single bond** | **Single bond** | **xi-7** | **xi-1** |
| **(XID-20)** | **Single bond** | **Single bond** | **xi-8** | **xi-1** |
| **(XID-21)** | **Single bond** | **Single bond** | **xi-9** | **xi-1** |
| **(XID-22)** | **Single bond** | **Single bond** | **xi-10** | **xi-1** |
| **(XID-23)** | **Single bond** | **Single bond** | **xi-11** | **xi-1** |
| **(XID-24)** | **Single bond** | **Single bond** | **xi-12** | **xi-1** |
| **(XID-25)** | **Single bond** | **Single bond** | **xi-2** | **xi-2** |
| **(XID-26)** | **Single bond** | **Single bond** | **xi-3** | **xi-2** |
| **(XID-27)** | **Single bond** | **Single bond** | **xi-4** | **xi-2** |
| **(XID-28)** | **Single bond** | **Single bond** | **xi-5** | **xi-2** |
| **(XID-29)** | **Single bond** | **Single bond** | **xi-6** | **xi-2** |
| **(XID-30)** | **Single bond** | **Single bond** | **xi-7** | **xi-2** |
| **(XID-31)** | **Single bond** | **Single bond** | **xi-8** | **xi-2** |
| **(XID-32)** | **Single bond** | **Single bond** | **xi-9** | **xi-2** |
| **(XID-33)** | **Single bond** | **Single bond** | **xi-10** | **xi-2** |
| **(XID-34)** | **Single bond** | **Single bond** | **xi-11** | **xi-2** |
| **(XID-35)** | **Single bond** | **Single bond** | **xi-12** | **xi-2** |
| **(XID-36)** | **Single bond** | **Single bond** | **xi-3** | **xi-3** |
| **(XID-37)** | **Single bond** | **Single bond** | **xi-4** | **xi-3** |
| **(XID-38)** | **Single bond** | **Single bond** | **xi-5** | **xi-3** |
| **(XID-39)** | **Single bond** | **Single bond** | **xi-6** | **xi-3** |
| **(XID-40)** | **Single bond** | **Single bond** | **xi-7** | **xi-3** |
| **(XID-41)** | **Single bond** | **Single bond** | **xi-8** | **xi-3** |
| **(XID-42)** | **Single bond** | **Single bond** | **xi-9** | **xi-3** |
| **(XID-43)** | **Single bond** | **Single bond** | **xi-10** | **xi-3** |
| **(XID-44)** | **Single bond** | **Single bond** | **xi-11** | **xi-3** |
| **(XID-45)** | **Single bond** | **Single bond** | **xi-12** | **xi-3** |
| **(XID-46)** | **Single bond** | **Single bond** | **xi-4** | **xi-4** |
| **(XID-47)** | **Single bond** | **Single bond** | **xi-5** | **xi-4** |
| **(XID-48)** | **Single bond** | **Single bond** | **xi-6** | **xi-4** |
| **(XID-49)** | **Single bond** | **Single bond** | **xi-7** | **xi-4** |
| **(XID-50)** | **Single bond** | **Single bond** | **xi-8** | **xi-4** |
| **(XID-51)** | **Single bond** | **Single bond** | **xi-9** | **xi-4** |
| **(XID-52)** | **Single bond** | **Single bond** | **xi-10** | **xi-4** |
| **(XID-53)** | **Single bond** | **Single bond** | **xi-11** | **xi-4** |
| **(XID-54)** | **Single bond** | **Single bond** | **xi-12** | **xi-4** |
| **(XID-55)** | **Single bond** | **Single bond** | **xi-5** | **xi-5** |
| **(XID-56)** | **Single bond** | **Single bond** | **xi-6** | **xi-5** |
| **(XID-57)** | **Single bond** | **Single bond** | **xi-7** | **xi-5** |
| **(XID-58)** | **Single bond** | **Single bond** | **xi-8** | **xi-5** |
| **(XID-59)** | **Single bond** | **Single bond** | **xi-9** | **xi-5** |
| **(XID-60)** | **Single bond** | **Single bond** | **xi-10** | **xi-5** |

**[Table 14]**

| | **Z^{x1}** | **Z^{x2}** | **R^{x1}** | **R^{x2}** |
|---|---|---|---|---|
| **(XID-61)** | **Single bond** | **Single bond** | **xi-11** | **xi-5** |
| **(XID-62)** | **Single bond** | **Single bond** | **xi-12** | **xi-5** |
| **(XID-63)** | **Single bond** | **Single bond** | **xi-6** | **xi-6** |
| **(XID-64)** | **Single bond** | **Single bond** | **xi-7** | **xi-6** |
| **(XID-65)** | **Single bond** | **Single bond** | **xi-8** | **xi-6** |
| **(XID-66)** | **Single bond** | **Single bond** | **xi-9** | **xi-6** |
| **(XID-67)** | **Single bond** | **Single bond** | **xi-10** | **xi-6** |
| **(XID-68)** | **Single bond** | **Single bond** | **xi-11** | **xi-6** |
| **(XID-69)** | **Single bond** | **Single bond** | **xi-12** | **xi-6** |
| **(XID-70)** | **Single bond** | **Single bond** | **xi-7** | **xi-7** |
| **(XID-71)** | **Single bond** | **Single bond** | **xi-8** | **xi-7** |
| **(XID-72)** | **Single bond** | **Single bond** | **xi-9** | **xi-7** |
| **(XID-73)** | **Single bond** | **Single bond** | **xi-10** | **xi-7** |
| **(XID-74)** | **Single bond** | **Single bond** | **xi-11** | **xi-7** |
| **(XID-75)** | **Single bond** | **Single bond** | **xi-12** | **xi-7** |
| **(XID-76)** | **Single bond** | **Single bond** | **xi-8** | **xi-8** |
| **(XID-77)** | **Single bond** | **Single bond** | **xi-9** | **xi-8** |
| **(XID-78)** | **Single bond** | **Single bond** | **xi-10** | **xi-8** |
| **(XID-79)** | **Single bond** | **Single bond** | **xi-11** | **xi-8** |
| **(XID-80)** | **Single bond** | **Single bond** | **xi-12** | **xi-8** |
| **(XID-81)** | **Single bond** | **Single bond** | **xi-9** | **xi-9** |
| **(XID-82)** | **Single bond** | **Single bond** | **xi-10** | **xi-9** |
| **(XID-83)** | **Single bond** | **Single bond** | **xi-11** | **xi-9** |
| **(XID-84)** | **Single bond** | **Single bond** | **xi-12** | **xi-9** |
| **(XID-85)** | **Single bond** | **Single bond** | **xi-10** | **xi-10** |
| **(XID-86)** | **Single bond** | **Single bond** | **xi-11** | **xi-10** |
| **(XID-87)** | **Single bond** | **Single bond** | **xi-12** | **xi-10** |
| **(XID-88)** | **Single bond** | **Single bond** | **xi-11** | **xi-11** |
| **(XID-89)** | **Single bond** | **Single bond** | **xi-12** | **xi-11** |
| **(XID-90)** | **Single bond** | **Single bond** | **xi-12** | **xi-12** |
| **(XID-91)** | **Oxygen atom** | **Oxygen atom** | **xi-1** | **xii-1** |
| **(XID-92)** | **Oxygen atom** | **Oxygen atom** | **xi-2** | **xii-1** |
| **(XID-93)** | **Oxygen atom** | **Oxygen atom** | **xi-3** | **xii-1** |
| **(XID-94)** | **Oxygen atom** | **Oxygen atom** | **xi-4** | **xii-1** |
| **(XID-95)** | **Oxygen atom** | **Oxygen atom** | **xi-5** | **xii-1** |
| **(XID-96)** | **Oxygen atom** | **Oxygen atom** | **xi-6** | **xii-1** |
| **(XID-97)** | **Oxygen atom** | **Oxygen atom** | **xi-7** | **xii-1** |
| **(XID-98)** | **Oxygen atom** | **Oxygen atom** | **xi-8** | **xii-1** |
| **(XID-99)** | **Oxygen atom** | **Oxygen atom** | **xi-9** | **xii-1** |
| **(XID-100)** | **Oxygen atom** | **Oxygen atom** | **xi-10** | **xii-1** |
| **(XID-101)** | **Oxygen atom** | **Oxygen atom** | **xi-11** | **xii-1** |
| **(XID-102)** | **Oxygen atom** | **Oxygen atom** | **xi-12** | **xii-1** |
| **(XID-103)** | **Oxygen atom** | **Oxygen atom** | **xi-1** | **xi-1** |
| **(XID-104)** | **Oxygen atom** | **Oxygen atom** | **xi-2** | **xi-1** |
| **(XID-105)** | **Oxygen atom** | **Oxygen atom** | **xi-3** | **xi-1** |
| **(XID-106)** | **Oxygen atom** | **Oxygen atom** | **xi-4** | **xi-1** |
| **(XID-107)** | **Oxygen atom** | **Oxygen atom** | **xi-5** | **xi-1** |
| **(XID-108)** | **Oxygen atom** | **Oxygen atom** | **xi-6** | **xi-1** |
| **(XID-109)** | **Oxygen atom** | **Oxygen atom** | **xi-7** | **xi-1** |
| **(XID-110)** | **Oxygen atom** | **Oxygen atom** | **xi-8** | **xi-1** |
| **(XID-111)** | **Oxygen atom** | **Oxygen atom** | **xi-9** | **xi-1** |
| **(XID-112)** | **Oxygen atom** | **Oxygen atom** | **xi-10** | **xi-1** |
| **(XID-113)** | **Oxygen atom** | **Oxygen atom** | **xi-11** | **xi-1** |
| **(XID-114)** | **Oxygen atom** | **Oxygen atom** | **xi-12** | **xi-1** |
| **(XID-115)** | **Oxygen atom** | **Oxygen atom** | **xi-2** | **xi-2** |
| **(XID-116)** | **Oxygen atom** | **Oxygen atom** | **xi-3** | **xi-2** |
| **(XID-117)** | **Oxygen atom** | **Oxygen atom** | **xi-4** | **xi-2** |
| **(XID-118)** | **Oxygen atom** | **Oxygen atom** | **xi-5** | **xi-2** |
| **(XID-119)** | **Oxygen atom** | **Oxygen atom** | **xi-6** | **xi-2** |
| **(XID-120)** | **Oxygen atom** | **Oxygen atom** | **xi-7** | **xi-2** |

**[Table 15]**

| | **Z^{x1}** | **Z^{x2}** | **R^{x1}** | **R^{x2}** |
|---|---|---|---|---|
| **(XID-121)** | **Oxygen atom** | **Oxygen atom** | **xi-8** | **xi-2** |
| **(XID-122)** | **Oxygen atom** | **Oxygen atom** | **xi-9** | **xi-2** |
| **(XID-123)** | **Oxygen atom** | **Oxygen atom** | **xi-10** | **xi-2** |
| **(XID-124)** | **Oxygen atom** | **Oxygen atom** | **xi-11** | **xi-2** |
| **(XID-125)** | **Oxygen atom** | **Oxygen atom** | **xi-12** | **xi-2** |
| **(XID-126)** | **Oxygen atom** | **Oxygen atom** | **xi-3** | **xi-3** |
| **(XID-127)** | **Oxygen atom** | **Oxygen atom** | **xi-4** | **xi-3** |
| **(XID-128)** | **Oxygen atom** | **Oxygen atom** | **xi-5** | **xi-3** |
| **(XID-129)** | **Oxygen atom** | **Oxygen atom** | **xi-6** | **xi-3** |
| **(XID-130)** | **Oxygen atom** | **Oxygen atom** | **xi-7** | **xi-3** |
| **(XID-131)** | **Oxygen atom** | **Oxygen atom** | **xi-8** | **xi-3** |
| **(XID-132)** | **Oxygen atom** | **Oxygen atom** | **xi-9** | **xi-3** |
| **(XID-133)** | **Oxygen atom** | **Oxygen atom** | **xi-10** | **xi-3** |
| **(XID-134)** | **Oxygen atom** | **Oxygen atom** | **xi-11** | **xi-3** |
| **(XID-135)** | **Oxygen atom** | **Oxygen atom** | **xi-12** | **xi-3** |
| **(XID-136)** | **Oxygen atom** | **Oxygen atom** | **xi-4** | **xi-4** |
| **(XID-137)** | **Oxygen atom** | **Oxygen atom** | **xi-5** | **xi-4** |
| **(XID-138)** | **Oxygen atom** | **Oxygen atom** | **xi-6** | **xi-4** |
| **(XID-139)** | **Oxygen atom** | **Oxygen atom** | **xi-7** | **xi-4** |
| **(XID-140)** | **Oxygen atom** | **Oxygen atom** | **xi-8** | **xi-4** |
| **(XID-141)** | **Oxygen atom** | **Oxygen atom** | **xi-9** | **xi-4** |
| **(XID-142)** | **Oxygen atom** | **Oxygen atom** | **xi-10** | **xi-4** |
| **(XID-143)** | **Oxygen atom** | **Oxygen atom** | **xi-11** | **xi-4** |
| **(XID-144)** | **Oxygen atom** | **Oxygen atom** | **xi-12** | **xi-4** |
| **(XID-145)** | **Oxygen atom** | **Oxygen atom** | **xi-5** | **xi-5** |
| **(XID-146)** | **Oxygen atom** | **Oxygen atom** | **xi-6** | **xi-5** |
| **(XID-147)** | **Oxygen atom** | **Oxygen atom** | **xi-7** | **xi-5** |
| **(XID-148)** | **Oxygen atom** | **Oxygen atom** | **xi-8** | **xi-5** |
| **(XID-149)** | **Oxygen atom** | **Oxygen atom** | **xi-9** | **xi-5** |
| **(XID-150)** | **Oxygen atom** | **Oxygen atom** | **xi-10** | **xi-5** |
| **(XID-151)** | **Oxygen atom** | **Oxygen atom** | **xi-11** | **xi-5** |
| **(XID-152)** | **Oxygen atom** | **Oxygen atom** | **xi-12** | **xi-5** |
| **(XID-153)** | **Oxygen atom** | **Oxygen atom** | **xi-6** | **xi-6** |
| **(XID-154)** | **Oxygen atom** | **Oxygen atom** | **xi-7** | **xi-6** |
| **(XID-155)** | **Oxygen atom** | **Oxygen atom** | **xi-8** | **xi-6** |
| **(XID-156)** | **Oxygen atom** | **Oxygen atom** | **xi-9** | **xi-6** |
| **(XID-157)** | **Oxygen atom** | **Oxygen atom** | **xi-10** | **xi-6** |
| **(XID-158)** | **Oxygen atom** | **Oxygen atom** | **xi-11** | **xi-6** |
| **(XID-159)** | **Oxygen atom** | **Oxygen atom** | **xi-12** | **xi-6** |
| **(XID-160)** | **Oxygen atom** | **Oxygen atom** | **xi-7** | **xi-7** |
| **(XID-161)** | **Oxygen atom** | **Oxygen atom** | **xi-8** | **xi-7** |
| **(XID-162)** | **Oxygen atom** | **Oxygen atom** | **xi-9** | **xi-7** |
| **(XID-163)** | **Oxygen atom** | **Oxygen atom** | **xi-10** | **xi-7** |
| **(XID-164)** | **Oxygen atom** | **Oxygen atom** | **xi-11** | **xi-7** |
| **(XID-165)** | **Oxygen atom** | **Oxygen atom** | **xi-12** | **xi-7** |
| **(XID-166)** | **Oxygen atom** | **Oxygen atom** | **xi-8** | **xi-8** |
| **(XID-167)** | **Oxygen atom** | **Oxygen atom** | **xi-9** | **xi-8** |
| **(XID-168)** | **Oxygen atom** | **Oxygen atom** | **xi-10** | **xi-8** |
| **(XID-169)** | **Oxygen atom** | **Oxygen atom** | **xi-11** | **xi-8** |
| **(XID-170)** | **Oxygen atom** | **Oxygen atom** | **xi-12** | **xi-8** |
| **(XID-171)** | **Oxygen atom** | **Oxygen atom** | **xi-9** | **xi-9** |
| **(XID-172)** | **Oxygen atom** | **Oxygen atom** | **xi-10** | **xi-9** |
| **(XID-173)** | **Oxygen atom** | **Oxygen atom** | **xi-11** | **xi-9** |
| **(XID-174)** | **Oxygen atom** | **Oxygen atom** | **xi-12** | **xi-9** |
| **(XID-175)** | **Oxygen atom** | **Oxygen atom** | **xi-10** | **xi-10** |
| **(XID-176)** | **Oxygen atom** | **Oxygen atom** | **xi-11** | **xi-10** |
| **(XID-177)** | **Oxygen atom** | **Oxygen atom** | **xi-12** | **xi-10** |
| **(XID-178)** | **Oxygen atom** | **Oxygen atom** | **xi-11** | **xi-11** |
| **(XID-179)** | **Oxygen atom** | **Oxygen atom** | **xi-12** | **xi-11** |
| **(XID-180)** | **Oxygen atom** | **Oxygen atom** | **xi-12** | **xi-12** |
| **(XID-181)** | **Single bond** | **Single bond** | **xii-1** | **xii-1** |
| **(XID-182)** | **Oxygen atom** | **Oxygen atom** | **xii-1** | **xii-1** |

**[Table 16]**

| | **Z^{x1}** | **Z^{x2}** | **Group formed by R^{x1} and R^{x2}** | | | **Z^{x1}** | **Z^{x2}** | **Group formed by R^{x1} and R^{x2}** | **R^{x8}** | **R^{x9}** |
|---|---|---|---|---|---|---|---|---|---|---|
| **(XIA-183)** | **Oxygen atom** | **Oxygen atom** | **xca-1** | | **(XIA-187)** | **Oxygen atom** | **Oxygen atom** | **xcb-1** | **xcc-1** | **OH** |
| **(XIA-184)** | **Oxygen atom** | **Oxygen atom** | **xca-2** | | **(XIA-188)** | **Single bond** | **Single bond** | **xcb-1** | **xcc-1** | **OH** |
| **(XIA-185)** | **Single bond** | **Single bond** | **xca-1** | | **(XIA-189)** | **Oxygen atom** | **Oxygen atom** | **xcb-1** | **xcc-1** | **H** |
| **(XIA-186)** | **Single bond** | **Single bond** | **xca-2** | | **(XIA-190)** | **Single bond** | **Single bond** | **xcb-1** | **xcc-1** | **H** |

As the compound represented by formula (XID),
the compounds represented by formula (XID-1) to formula (XID-12), formula (XID-91) to formula (XID-102), formula (XID-103) to formula (XID-108), formula (XID-115) to formula (XID-119), formula (XID-126) to formula (XID-129), formula (XID-136) to formula (XID-13 8), formula (XID-145) to formula (XID-146), formula (XID-153), and formula (XID-181) to formula (XID-190) are preferable,
the compounds represented by formula (XID-1) to formula (XID-12) are more preferable, and
the compound represented by formula (XID-1) is further preferable.

**[Table 17]**

| | **Z^{x1}** | **Z^{x2}** | **R^{x1}** | **R^{x2}** |
|---|---|---|---|---|
| **(XIE-1)** | **Single bond** | **Single bond** | **xi-1** | **xii-1** |
| **(XIE-2)** | **Single bond** | **Single bond** | **xi-2** | **xii-1** |
| **(XIE-3)** | **Single bond** | **Single bond** | **xi-3** | **xii-1** |
| **(XIE-4)** | **Single bond** | **Single bond** | **xi-4** | **xii-1** |
| **(XIE-5)** | **Single bond** | **Single bond** | **xi-5** | **xii-1** |
| **(XIE-6)** | **Single bond** | **Single bond** | **xi-6** | **xii-1** |
| **(XIE-7)** | **Single bond** | **Single bond** | **xi-7** | **xii-1** |
| **(XIE-8)** | **Single bond** | **Single bond** | **xi-8** | **xii-1** |
| **(XIE-9)** | **Single bond** | **Single bond** | **xi-9** | **xii-1** |
| **(XIE-10)** | **Single bond** | **Single bond** | **xi-10** | **xii-1** |
| **(XIE-11)** | **Single bond** | **Single bond** | **xi-11** | **xii-1** |
| **(XIE-12)** | **Single bond** | **Single bond** | **xi-12** | **xii-1** |
| **(XIE-13)** | **Single bond** | **Single bond** | **xi-1** | **xi-1** |
| **(XIE-14)** | **Single bond** | **Single bond** | **xi-2** | **xi-1** |
| **(XIE-15)** | **Single bond** | **Single bond** | **xi-3** | **xi-1** |
| **(XIE-16)** | **Single bond** | **Single bond** | **xi-4** | **xi-1** |
| **(XIE-17)** | **Single bond** | **Single bond** | **xi-5** | **xi-1** |
| **(XIE-18)** | **Single bond** | **Single bond** | **xi-6** | **xi-1** |
| **(XIE-19)** | **Single bond** | **Single bond** | **xi-7** | **xi-1** |
| **(XIE-20)** | **Single bond** | **Single bond** | **xi-8** | **xi-1** |
| **(XIE-21)** | **Single bond** | **Single bond** | **xi-9** | **xi-1** |
| **(XIE-22)** | **Single bond** | **Single bond** | **xi-10** | **xi-1** |
| **(XIE-23)** | **Single bond** | **Single bond** | **xi-11** | **xi-1** |
| **(XIE-24)** | **Single bond** | **Single bond** | **xi-12** | **xi-1** |
| **(XIE-25)** | **Single bond** | **Single bond** | **xi-2** | **xi-2** |
| **(XIE-26)** | **Single bond** | **Single bond** | **xi-3** | **xi-2** |
| **(XIE-27)** | **Single bond** | **Single bond** | **xi-4** | **xi-2** |
| **(XIE-28)** | **Single bond** | **Single bond** | **xi-5** | **xi-2** |
| **(XIE-29)** | **Single bond** | **Single bond** | **xi-6** | **xi-2** |
| **(XIE-30)** | **Single bond** | **Single bond** | **xi-7** | **xi-2** |
| **(XIE-31)** | **Single bond** | **Single bond** | **xi-8** | **xi-2** |
| **(XIE-32)** | **Single bond** | **Single bond** | **xi-9** | **xi-2** |
| **(XIE-33)** | **Single bond** | **Single bond** | **xi-10** | **xi-2** |
| **(XIE-34)** | **Single bond** | **Single bond** | **xi-11** | **xi-2** |
| **(XIE-35)** | **Single bond** | **Single bond** | **xi-12** | **xi-2** |
| **(XIE-36)** | **Single bond** | **Single bond** | **xi-3** | **xi-3** |
| **(XIE-37)** | **Single bond** | **Single bond** | **xi-4** | **xi-3** |
| **(XIE-38)** | **Single bond** | **Single bond** | **xi-5** | **xi-3** |
| **(XIE-39)** | **Single bond** | **Single bond** | **xi-6** | **xi-3** |
| **(XIE-40)** | **Single bond** | **Single bond** | **xi-7** | **xi-3** |
| **(XIE-41)** | **Single bond** | **Single bond** | **xi-8** | **xi-3** |
| **(XIE-42)** | **Single bond** | **Single bond** | **xi-9** | **xi-3** |
| **(XIE-43)** | **Single bond** | **Single bond** | **xi-10** | **xi-3** |
| **(XIE-44)** | **Single bond** | **Single bond** | **xi-11** | **xi-3** |
| **(XIE-45)** | **Single bond** | **Single bond** | **xi-12** | **xi-3** |
| **(XIE-46)** | **Single bond** | **Single bond** | **xi-4** | **xi-4** |
| **(XIE-47)** | **Single bond** | **Single bond** | **xi-5** | **xi-4** |
| **(XIE-48)** | **Single bond** | **Single bond** | **xi-6** | **xi-4** |
| **(XIE-49)** | **Single bond** | **Single bond** | **xi-7** | **xi-4** |
| **(XIE-50)** | **Single bond** | **Single bond** | **xi-8** | **xi-4** |
| **(XIE-51)** | **Single bond** | **Single bond** | **xi-9** | **xi-4** |
| **(XIE-52)** | **Single bond** | **Single bond** | **xi-10** | **xi-4** |
| **(XIE-53)** | **Single bond** | **Single bond** | **xi-11** | **xi-4** |
| **(XIE-54)** | **Single bond** | **Single bond** | **xi-12** | **xi-4** |
| **(XIE-55)** | **Single bond** | **Single bond** | **xi-5** | **xi-5** |
| **(XIE-56)** | **Single bond** | **Single bond** | **xi-6** | **xi-5** |
| **(XIE-57)** | **Single bond** | **Single bond** | **xi-7** | **xi-5** |
| **(XIE-58)** | **Single bond** | **Single bond** | **xi-8** | **xi-5** |
| **(XIE-59)** | **Single bond** | **Single bond** | **xi-9** | **xi-5** |
| **(XIE-60)** | **Single bond** | **Single bond** | **xi-10** | **xi-5** |

**[Table 18]**

| | **Z^{x1}** | **Z^{x2}** | **R^{x1}** | **R^{x2}** |
|---|---|---|---|---|
| **(XIE-61)** | **Single bond** | **Single bond** | **xi-11** | **xi-5** |
| **(XIE-62)** | **Single bond** | **Single bond** | **xi-12** | **xi-5** |
| **(XIE-63)** | **Single bond** | **Single bond** | **xi-6** | **xi-6** |
| **(XIE-64)** | **Single bond** | **Single bond** | **xi-7** | **xi-6** |
| **(XIE-65)** | **Single bond** | **Single bond** | **xi-8** | **xi-6** |
| **(XIE-66)** | **Single bond** | **Single bond** | **xi-9** | **xi-6** |
| **(XIE-67)** | **Single bond** | **Single bond** | **xi-10** | **xi-6** |
| **(XIE-68)** | **Single bond** | **Single bond** | **xi-11** | **xi-6** |
| **(XIE-69)** | **Single bond** | **Single bond** | **xi-12** | **xi-6** |
| **(XIE-70)** | **Single bond** | **Single bond** | **xi-7** | **xi-7** |
| **(XIE-71)** | **Single bond** | **Single bond** | **xi-8** | **xi-7** |
| **(XIE-72)** | **Single bond** | **Single bond** | **xi-9** | **xi-7** |
| **(XIE-73)** | **Single bond** | **Single bond** | **xi-10** | **xi-7** |
| **(XIE-74)** | **Single bond** | **Single bond** | **xi-11** | **xi-7** |
| **(XIE-75)** | **Single bond** | **Single bond** | **xi-12** | **xi-7** |
| **(XIE-76)** | **Single bond** | **Single bond** | **xi-8** | **xi-8** |
| **(XIE-77)** | **Single bond** | **Single bond** | **xi-9** | **xi-8** |
| **(XIE-78)** | **Single bond** | **Single bond** | **xi-10** | **xi-8** |
| **(XIE-79)** | **Single bond** | **Single bond** | **xi-11** | **xi-8** |
| **(XIE-80)** | **Single bond** | **Single bond** | **xi-12** | **xi-8** |
| **(XIE-81)** | **Single bond** | **Single bond** | **xi-9** | **xi-9** |
| **(XIE-82)** | **Single bond** | **Single bond** | **xi-10** | **xi-9** |
| **(XIE-83)** | **Single bond** | **Single bond** | **xi-11** | **xi-9** |
| **(XIE-84)** | **Single bond** | **Single bond** | **xi-12** | **xi-9** |
| **(XIE-85)** | **Single bond** | **Single bond** | **xi-10** | **xi-10** |
| **(XIE-86)** | **Single bond** | **Single bond** | **xi-11** | **xi-10** |
| **(XIE-87)** | **Single bond** | **Single bond** | **xi-12** | **xi-10** |
| **(XIE-88)** | **Single bond** | **Single bond** | **xi-11** | **xi-11** |
| **(XIE-89)** | **Single bond** | **Single bond** | **xi-12** | **xi-11** |
| **(XIE-90)** | **Single bond** | **Single bond** | **xi-12** | **xi-12** |
| **(XIE-91)** | **Oxygen atom** | **Oxygen atom** | **xi-1** | **xii-1** |
| **(XIE-92)** | **Oxygen atom** | **Oxygen atom** | **xi-2** | **xii-1** |
| **(XIE-93)** | **Oxygen atom** | **Oxygen atom** | **xi-3** | **xii-1** |
| **(XIE-94)** | **Oxygen atom** | **Oxygen atom** | **xi-4** | **xii-1** |
| **(XIE-95)** | **Oxygen atom** | **Oxygen atom** | **xi-5** | **xii-1** |
| **(XIE-96)** | **Oxygen atom** | **Oxygen atom** | **xi-6** | **xii-1** |
| **(XIE-97)** | **Oxygen atom** | **Oxygen atom** | **xi-7** | **xii-1** |
| **(XIE-98)** | **Oxygen atom** | **Oxygen atom** | **xi-8** | **xii-1** |
| **(XIE-99)** | **Oxygen atom** | **Oxygen atom** | **xi-9** | **xii-1** |
| **(XIE-100)** | **Oxygen atom** | **Oxygen atom** | **xi-10** | **xii-1** |
| **(XIE-101)** | **Oxygen atom** | **Oxygen atom** | **xi-11** | **xii-1** |
| **(XIE-102)** | **Oxygen atom** | **Oxygen atom** | **xi-12** | **xii-1** |
| **(XIE-103)** | **Oxygen atom** | **Oxygen atom** | **xi-1** | **xi-1** |
| **(XIE-104)** | **Oxygen atom** | **Oxygen atom** | **xi-2** | **xi-1** |
| **(XIE-105)** | **Oxygen atom** | **Oxygen atom** | **xi-3** | **xi-1** |
| **(XIE-106)** | **Oxygen atom** | **Oxygen atom** | **xi-4** | **xi-1** |
| **(XIE-107)** | **Oxygen atom** | **Oxygen atom** | **xi-5** | **xi-1** |
| **(XIE-108)** | **Oxygen atom** | **Oxygen atom** | **xi-6** | **xi-1** |
| **(XIE-109)** | **Oxygen atom** | **Oxygen atom** | **xi-7** | **xi-1** |
| **(XIE-110)** | **Oxygen atom** | **Oxygen atom** | **xi-8** | **xi-1** |
| **(XIE-111)** | **Oxygen atom** | **Oxygen atom** | **xi-9** | **xi-1** |
| **(XIE-112)** | **Oxygen atom** | **Oxygen atom** | **xi-10** | **xi-1** |
| **(XIE-113)** | **Oxygen atom** | **Oxygen atom** | **xi-11** | **xi-1** |
| **(XIE-114)** | **Oxygen atom** | **Oxygen atom** | **xi-12** | **xi-1** |
| **(XIE-115)** | **Oxygen atom** | **Oxygen atom** | **xi-2** | **xi-2** |
| **(XIE-116)** | **Oxygen atom** | **Oxygen atom** | **xi-3** | **xi-2** |
| **(XIE-117)** | **Oxygen atom** | **Oxygen atom** | **xi-4** | **xi-2** |
| **(XIE-118)** | **Oxygen atom** | **Oxygen atom** | **xi-5** | **xi-2** |
| **(XIE-119)** | **Oxygen atom** | **Oxygen atom** | **xi-6** | **xi-2** |
| **(XIE-120)** | **Oxygen atom** | **Oxygen atom** | **xi-7** | **xi-2** |

**[Table 19]**

| | **Z^{x1}** | **Z^{x2}** | **R^{x1}** | **R^{x2}** |
|---|---|---|---|---|
| **(XIE-121)** | **Oxygen atom** | **Oxygen atom** | **xi-8** | **xi-2** |
| **(XIE-122)** | **Oxygen atom** | **Oxygen atom** | **xi-9** | **xi-2** |
| **(XIE-123)** | **Oxygen atom** | **Oxygen atom** | **xi-10** | **xi-2** |
| **(XIE-124)** | **Oxygen atom** | **Oxygen atom** | **xi-11** | **xi-2** |
| **(XIE-125)** | **Oxygen atom** | **Oxygen atom** | **xi-12** | **xi-2** |
| **(XIE-126)** | **Oxygen atom** | **Oxygen atom** | **xi-3** | **xi-3** |
| **(XIE-127)** | **Oxygen atom** | **Oxygen atom** | **xi-4** | **xi-3** |
| **(XIE-128)** | **Oxygen atom** | **Oxygen atom** | **xi-5** | **xi-3** |
| **(XIE-129)** | **Oxygen atom** | **Oxygen atom** | **xi-6** | **xi-3** |
| **(XIE-130)** | **Oxygen atom** | **Oxygen atom** | **xi-7** | **xi-3** |
| **(XIE-131)** | **Oxygen atom** | **Oxygen atom** | **xi-8** | **xi-3** |
| **(XIE-132)** | **Oxygen atom** | **Oxygen atom** | **xi-9** | **xi-3** |
| **(XIE-133)** | **Oxygen atom** | **Oxygen atom** | **xi-10** | **xi-3** |
| **(XIE-134)** | **Oxygen atom** | **Oxygen atom** | **xi-11** | **xi-3** |
| **(XIE-135)** | **Oxygen atom** | **Oxygen atom** | **xi-12** | **xi-3** |
| **(XIE-136)** | **Oxygen atom** | **Oxygen atom** | **xi-4** | **xi-4** |
| **(XIE-137)** | **Oxygen atom** | **Oxygen atom** | **xi-5** | **xi-4** |
| **(XIE-138)** | **Oxygen atom** | **Oxygen atom** | **xi-6** | **xi-4** |
| **(XIE-139)** | **Oxygen atom** | **Oxygen atom** | **xi-7** | **xi-4** |
| **(XIE-140)** | **Oxygen atom** | **Oxygen atom** | **xi-8** | **xi-4** |
| **(XIE-141)** | **Oxygen atom** | **Oxygen atom** | **xi-9** | **xi-4** |
| **(XIE-142)** | **Oxygen atom** | **Oxygen atom** | **xi-10** | **xi-4** |
| **(XIE-143)** | **Oxygen atom** | **Oxygen atom** | **xi-11** | **xi-4** |
| **(XIE-144)** | **Oxygen atom** | **Oxygen atom** | **xi-12** | **xi-4** |
| **(XIE-145)** | **Oxygen atom** | **Oxygen atom** | **xi-5** | **xi-5** |
| **(XIE-146)** | **Oxygen atom** | **Oxygen atom** | **xi-6** | **xi-5** |
| **(XIE-147)** | **Oxygen atom** | **Oxygen atom** | **xi-7** | **xi-5** |
| **(XIE-148)** | **Oxygen atom** | **Oxygen atom** | **xi-8** | **xi-5** |
| **(XIE-149)** | **Oxygen atom** | **Oxygen atom** | **xi-9** | **xi-5** |
| **(XIE-150)** | **Oxygen atom** | **Oxygen atom** | **xi-10** | **xi-5** |
| **(XIE-151)** | **Oxygen atom** | **Oxygen atom** | **xi-11** | **xi-5** |
| **(XIE-152)** | **Oxygen atom** | **Oxygen atom** | **xi-12** | **xi-5** |
| **(XIE-153)** | **Oxygen atom** | **Oxygen atom** | **xi-6** | **xi-6** |
| **(XIE-154)** | **Oxygen atom** | **Oxygen atom** | **xi-7** | **xi-6** |
| **(XIE-155)** | **Oxygen atom** | **Oxygen atom** | **xi-8** | **xi-6** |
| **(XIE-156)** | **Oxygen atom** | **Oxygen atom** | **xi-9** | **xi-6** |
| **(XIE-157)** | **Oxygen atom** | **Oxygen atom** | **xi-10** | **xi-6** |
| **(XIE-158)** | **Oxygen atom** | **Oxygen atom** | **xi-11** | **xi-6** |
| **(XIE-159)** | **Oxygen atom** | **Oxygen atom** | **xi-12** | **xi-6** |
| **(XIE-160)** | **Oxygen atom** | **Oxygen atom** | **xi-7** | **xi-7** |
| **(XIE-161)** | **Oxygen atom** | **Oxygen atom** | **xi-8** | **xi-7** |
| **(XIE-162)** | **Oxygen atom** | **Oxygen atom** | **xi-9** | **xi-7** |
| **(XIE-163)** | **Oxygen atom** | **Oxygen atom** | **xi-10** | **xi-7** |
| **(XIE-164)** | **Oxygen atom** | **Oxygen atom** | **xi-11** | **xi-7** |
| **(XIE-165)** | **Oxygen atom** | **Oxygen atom** | **xi-12** | **xi-7** |
| **(XIE-166)** | **Oxygen atom** | **Oxygen atom** | **xi-8** | **xi-8** |
| **(XIE-167)** | **Oxygen atom** | **Oxygen atom** | **xi-9** | **xi-8** |
| **(XIE-168)** | **Oxygen atom** | **Oxygen atom** | **xi-10** | **xi-8** |
| **(XIE-169)** | **Oxygen atom** | **Oxygen atom** | **xi-11** | **xi-8** |
| **(XIE-170)** | **Oxygen atom** | **Oxygen atom** | **xi-12** | **xi-8** |
| **(XIE-171)** | **Oxygen atom** | **Oxygen atom** | **xi-9** | **xi-9** |
| **(XIE-172)** | **Oxygen atom** | **Oxygen atom** | **xi-10** | **xi-9** |
| **(XIE-173)** | **Oxygen atom** | **Oxygen atom** | **xi-11** | **xi-9** |
| **(XIE-174)** | **Oxygen atom** | **Oxygen atom** | **xi-12** | **xi-9** |
| **(XIE-175)** | **Oxygen atom** | **Oxygen atom** | **xi-10** | **xi-10** |
| **(XIE-176)** | **Oxygen atom** | **Oxygen atom** | **xi-11** | **xi-10** |
| **(XIE-177)** | **Oxygen atom** | **Oxygen atom** | **xi-12** | **xi-10** |
| **(XIE-178)** | **Oxygen atom** | **Oxygen atom** | **xi-11** | **xi-11** |
| **(XIE-179)** | **Oxygen atom** | **Oxygen atom** | **xi-12** | **xi-11** |
| **(XIE-180)** | **Oxygen atom** | **Oxygen atom** | **xi-12** | **xi-12** |
| **(XIE-181)** | **Single bond** | **Single bond** | **xii-1** | **xii-1** |
| **(XIE-182)** | **Oxygen atom** | **Oxygen atom** | **xii-1** | **xii-1** |

**[Table 20]**

| | **Z^{x1}** | **Z^{x2}** | **Group formed by R^{x1} and R^{x2}** | | | **Z^{x1}** | **Z^{x2}** | **Group formed by R^{x1} and R^{x2}** | **R^{x8}** | **R^{x9}** |
|---|---|---|---|---|---|---|---|---|---|---|
| **(XIA-183)** | **Oxygen atom** | **Oxygen atom** | **xca-1** | | **(XIA-187)** | **Oxygen atom** | **Oxygen atom** | **xcb-1** | **xcc-1** | **OH** |
| **(XIA-184)** | **Oxygen atom** | **Oxygen atom** | **xca-2** | | **(XIA-188)** | **Single bond** | **Single bond** | **xcb-1** | **xcc-1** | **OH** |
| **(XIA-185)** | **Single bond** | **Single bond** | **xca-1** | | **(XIA-189)** | **Oxygen atom** | **Oxygen atom** | **xcb-1** | **xcc-1** | **H** |
| **(XIA-186)** | **Single bond** | **Single bond** | **xca-2** | | **(XIA-190)** | **Single bond** | **Single bond** | **xcb-1** | **xcc-1** | **H** |

As the compound represented by formula (XIE),
the compounds represented by formula (XIE-1) to formula (XIE-12), formula (XIE-91) to formula (XIE-102), formula (XIE-103) to formula (XIE-108), formula (XIE-115) to formula (XIE-119), formula (XIE-126) to formula (XIE-129), formula (XIE-136) to formula (XIE-13 8), formula (XIE-145) to formula (XIE-146), formula (XIE-153), and formula (XIE-181) to formula (XIE-190) are preferable,
the compounds represented by formula (XIE-1) to formula (XIE-12), formula (XIE-103) to formula (XIE-105), formula (XIE-115) to formula (XIE-116), and formula (XIE-126) are more preferable, and
the compounds represented by formula (XIE-1) and formula (XIE-115) are further preferable.

As the aluminum phthalocyanine pigment (preferably the compound represented by formula (XII)), compounds represented by formula (XIIA) to formula (XIIE) are preferable.

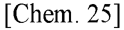

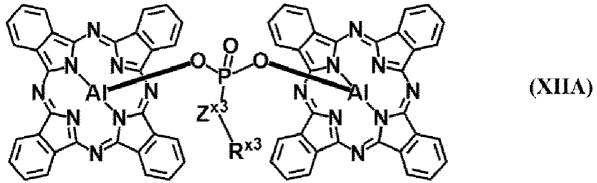

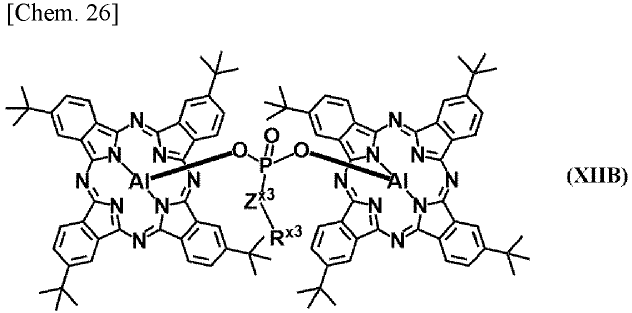

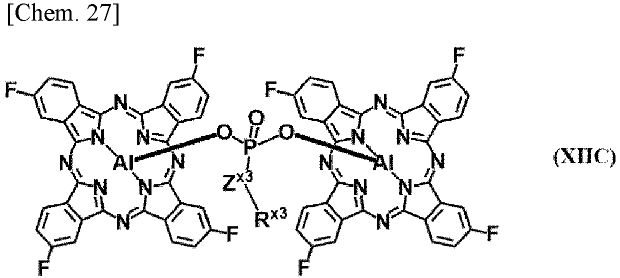

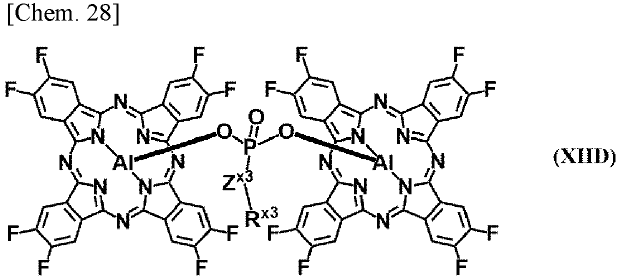

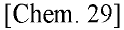

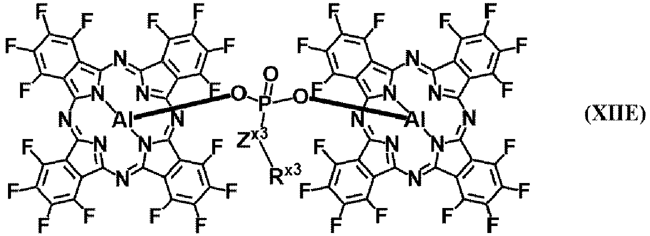

[In formula (XIIA) to formula (XIIE), R^{x3} and Z^{x3} are the same as above.]

Examples of the compound represented by formula (XIIA) include compounds represented by formula (XIIA-1) to formula (XIIA-18) shown in Table 21.

Examples of the compound represented by formula (XIIB) include compounds represented by formula (XIIB-1) to formula (XIIB-18) shown in Table 22.

Examples of the compound represented by formula (XIIC) include compounds represented by formula (XIIC-1) to formula (XIIC-18) shown in Table 23.

Examples of the compound represented by formula (XIID) include compounds represented by formula (XIID-1) to formula (XIID-18) shown in Table 24.

Examples of the compound represented by formula (XIIE) include compounds represented by formula (XIIE-1) to formula (XIIE-18) shown in Table 25.

The symbols described in the cells for "R^{x3}" in Table 21 to Table 25 correspond to groups represented by formula (xiii-1) to formula (xiii-9).
* represents a bond.

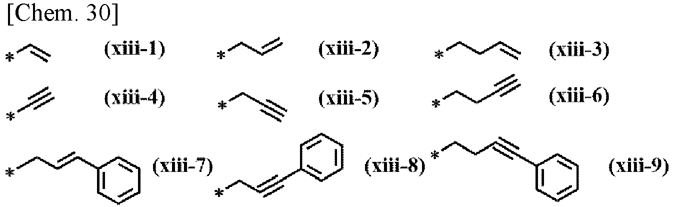

**[Table 21]**

| | **Z^{x3}** | **R^{x3}** |
|---|---|---|
| **(XIIA-1)** | **Single bond** | **xiii-1** |
| **(XIIA-2)** | **Single bond** | **xiii-2** |
| **(XIIA-3)** | **Single bond** | **xiii-3** |
| **(XIIA-4)** | **Single bond** | **xiii-4** |
| **(XIIA-5)** | **Single bond** | **xiii-5** |
| **(XIIA-6)** | **Single bond** | **xiii-6** |
| **(XIIA-7)** | **Single bond** | **xiii-7** |
| **(XIIA-8)** | **Single bond** | **xiii-8** |
| **(XIIA-9)** | **Single bond** | **xiii-9** |
| **(XIIA-10)** | **Oxygen atom** | **xiii-1** |
| **(XIIA-11)** | **Oxygen atom** | **xiii-2** |
| **(XIIA-12)** | **Oxygen atom** | **xiii-3** |
| **(XIIA-13)** | **Oxygen atom** | **xiii-4** |
| **(XIIA-14)** | **Oxygen atom** | **xiii-5** |
| **(XIIA-15)** | **Oxygen atom** | **xiii-6** |
| **(XIIA-16)** | **Oxygen atom** | **xiii-7** |
| **(XIIA-17)** | **Oxygen atom** | **xiii-8** |
| **(XIIA-18)** | **Oxygen atom** | **xiii-9** |

As the compound represented by formula (XIIA),
the compounds represented by formula (XIIA-1) to formula (XIIA-6) and formula (XIIA-10) to formula (XIIA-15) are preferable.

**[Table 22]**

| | **Z^{x3}** | **R^{x3}** |
|---|---|---|
| **(XIIB-1)** | **Single bond** | **xiii-1** |
| **(XIIB-2)** | **Single bond** | **xiii-2** |
| **(XIIB-3)** | **Single bond** | **xiii-3** |
| **(XIIB-4)** | **Single bond** | **xiii-4** |
| **(XIIB-5)** | **Single bond** | **xiii-5** |
| **(XIIB-6)** | **Single bond** | **xiii-6** |
| **(XIIB-7)** | **Single bond** | **xiii-7** |
| **(XIIB-8)** | **Single bond** | **xiii-8** |
| **(XIIB-9)** | **Single bond** | **xiii-9** |
| **(XIIB-10)** | **Oxygen atom** | **xiii-1** |
| **(XIIB-11)** | **Oxygen atom** | **xiii-2** |
| **(XIIB-12)** | **Oxygen atom** | **xiii-3** |
| **(XIIB-13)** | **Oxygen atom** | **xiii-4** |
| **(XIIB-14)** | **Oxygen atom** | **xiii-5** |
| **(XIIB-15)** | **Oxygen atom** | **xiii-6** |
| **(XIIB-16)** | **Oxygen atom** | **xiii-7** |
| **(XIIB-17)** | **Oxygen atom** | **xiii-8** |
| **(XIIB-18)** | **Oxygen atom** | **xiii-9** |

As the compound represented by formula (XIIB),
the compounds represented by formula (XIIB-1) to formula (XIIB-6) and formula (XIIB-10) to formula (XIIB-15) are preferable.

**[Table 23]**

| | **Z^{x3}** | **R^{x3}** |
|---|---|---|
| **(XIIC-1)** | **Single bond** | **xiii-1** |
| **(XIIC-2)** | **Single bond** | **xiii-2** |
| **(XIIC-3)** | **Single bond** | **xiii-3** |
| **(XIIC-4)** | **Single bond** | **xiii-4** |
| **(XIIC-5)** | **Single bond** | **xiii-5** |
| **(XIIC-6)** | **Single bond** | **xiii-6** |
| **(XIIC-7)** | **Single bond** | **xiii-7** |
| **(XIIC-8)** | **Single bond** | **xiii-8** |
| **(XIIC-9)** | **Single bond** | **xiii-9** |
| **(XIIC-10)** | **Oxygen atom** | **xiii-1** |
| **(XIIC-11)** | **Oxygen atom** | **xiii-2** |
| **(XIIC-12)** | **Oxygen atom** | **xiii-3** |
| **(XIIC-13)** | **Oxygen atom** | **xiii-4** |
| **(XIIC-14)** | **Oxygen atom** | **xiii-5** |
| **(XIIC-15)** | **Oxygen atom** | **xiii-6** |
| **(XIIC-16)** | **Oxygen atom** | **xiii-7** |
| **(XIIC-17.)** | **Oxygen atom** | **xiii-8** |
| **(XIIC-18)** | **Oxygen atom** | **xiii-9** |

As the compound represented by formula (XIIC),
the compounds represented by formula (XIIC-1) to formula (XIIC-6) and formula (XIIC-10) to formula (XIIC-15) are preferable.

**[Table 24]**

| | **Z^{x3}** | **R^{x3}** |
|---|---|---|
| **(XIID-1)** | **Single bond** | **xiii-1** |
| **(XIID-2)** | **Single bond** | **xiii-2** |
| **(XIID-3)** | **Single bond** | **xiii-3** |
| **(XIID-4)** | **Single bond** | **xiii-4** |
| **(XIID-5)** | **Single bond** | **xiii-5** |
| **(XIID-6)** | **Single bond** | **xiii-6** |
| **(XIID-7)** | **Single bond** | **xiii-7** |
| **(XIID-8)** | **Single bond** | **xiii-8** |
| **(XIID-9)** | **Single bond** | **xiii-9** |
| **(XIID-10)** | **Oxygen atom** | **xiii-1** |
| **(XIID-11)** | **Oxygen atom** | **xiii-2** |
| **(XIID-12)** | **Oxygen atom** | **xiii-3** |
| **(XIID-13)** | **Oxygen atom** | **xiii-4** |
| **(XIID-14)** | **Oxygen atom** | **xiii-5** |
| **(XIID-15)** | **Oxygen atom** | **xiii-6** |
| **(XIID-16)** | **Oxygen atom** | **xiii-7** |
| **(XIID-17)** | **Oxygen atom** | **xiii-8** |
| **(XIID-18)** | **Oxygen atom** | **xiii-9** |

As the compound represented by formula (XIID),
the compounds represented by formula (XIID-1) to formula (XIID-6) and formula (XIID-10) to formula (XIID-15) are preferable.

**[Table 25]**

| | **Z^{x3}** | **R^{x3}** |
|---|---|---|
| **(XIIE-1)** | **Single bond** | **xiii-1** |
| **(XIIE-2)** | **Single bond** | **xiii-2** |
| **(XIIE-3)** | **Single bond** | **xiii-3** |
| **(XIIE-4)** | **Single bond** | **xiii-4** |
| **(XIIE-5)** | **Single bond** | **xiii-5** |
| **(XIIE-6)** | **Single bond** | **xiii-6** |
| **(XIIE-7)** | **Single bond** | **xiii-7** |
| **(XIIE-8)** | **Single bond** | **xiii-8** |
| **(XIIE-9)** | **Single bond** | **xiii-9** |
| **(XIIE-10)** | **Oxygen atom** | **xiii-1** |
| **(XIIE-11)** | **Oxygen atom** | **xiii-2** |
| **(XIIE-12)** | **Oxygen atom** | **xiii-3** |
| **(XIIE-13)** | **Oxygen atom** | **xiii-4** |
| **(XIIE-14)** | **Oxygen atom** | **xiii-5** |
| **(XIIE-15)** | **Oxygen atom** | **xiii-6** |
| **(XIIE-16)** | **Oxygen atom** | **xiii-7** |
| **(XIIE-17)** | **Oxygen atom** | **xiii-8** |
| **(XIIE-18)** | **Oxygen atom** | **xiii-9** |

As the compound represented by formula (XIIE),
the compounds represented by formula (XIIE-1) to formula (XIIE-6) and formula (XIIE-10) to formula (XIIE-15) are preferable.

The compound represented by formula (XI) and the compound represented by formula (XII) include novel compounds.

The compound represented by formula (XI) can be produced, for example, by reacting the compound represented by formula (XIII) with the compound represented by formula (XIV), as appropriate.

Also, the compound represented by formula (XII) can be produced, for example, by reacting the compound represented by formula (XIII) with the compound represented by formula (XV), as appropriate.

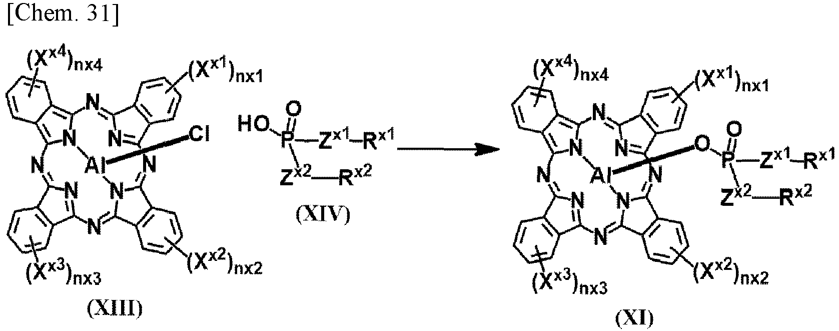

[In formula (XI), formula (XIII), and formula (XIV), R^{x1}, R^{x2}, Z^{x1}, Z^{x2}, X^{x1} to X^{x4}, and nx1 to nx4 are the same as above.]

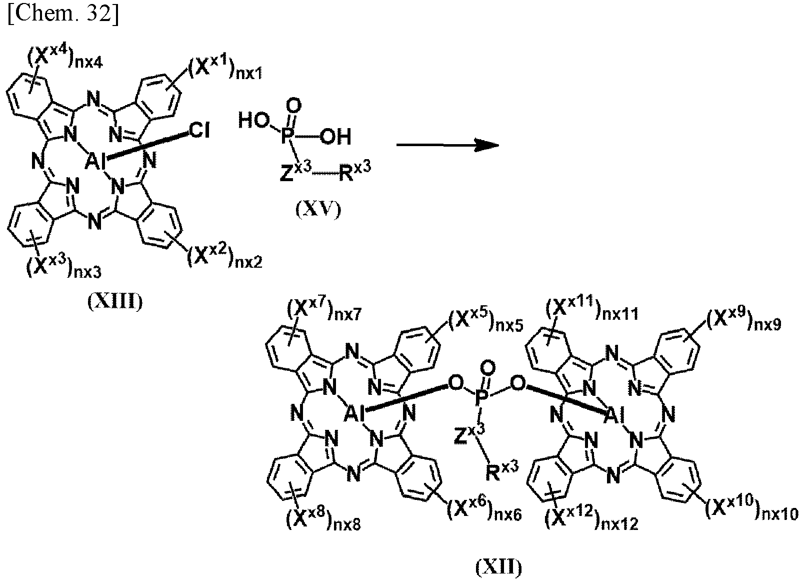

[In formula (XII), formula (XIII), and formula (XV), R^{x3}, Z^{x3}, X^{x1} to X^{x12}, and nx1 to nx12 are the same as above.]

In formula (YI),
R^{y1} is
   preferably an aromatic hydrocarbon group having 6 to 20 carbon atoms and optionally having a substituent,
   more preferably an aromatic hydrocarbon group having 6 to 10 carbon atoms and optionally having a substituent,
   further preferably an aromatic hydrocarbon group having 6 to 8 carbon atoms and optionally having a substituent, and
   particularly preferably a phenyl group optionally having a substituent.
R^{y2} is
   preferably an unsaturated hydrocarbon group having 2 to 20 carbon atoms and optionally having a substituent or an aromatic hydrocarbon group having 6 to 20 carbon atoms and optionally having a substituent,
   more preferably an unsaturated chain hydrocarbon group having 2 to 10 carbon atoms and optionally having a substituent or an aromatic hydrocarbon group having 6 to 10 carbon atoms and optionally having a substituent,
   further preferably an unsaturated chain hydrocarbon group having 2 to 7 carbon atoms and optionally having a substituent or an aromatic hydrocarbon group having 6 to 8 carbon atoms and optionally having a substituent,
   even further preferably an alkenyl group having 2 to 7 carbon atoms and optionally having a substituent or an aromatic hydrocarbon group having 6 to 8 carbon atoms and optionally having a substituent, and
   particularly preferably an ethenyl group optionally having a substituent or a phenyl group optionally having a substituent.
   ny1 to ny4 are each independently preferably 0 to 2, more preferably 0 to 1, and further preferably 0.
   X^{y1} to X^{y4} are each independently preferably -R^{y4} or a halogen atom.

Preferably, at least one of Y¹, Z^{y1}, Z^{y2}, and Z^{y3} represents a sulfur atom, and at least one of a mode in which Y¹ is a sulfur atom and Z^{y1} is an oxygen atom, a mode in which Y¹ is an oxygen atom and Z^{y1} is a sulfur atom, and a mode in which Z^{y2} and Z^{y3} are sulfur atoms is satisfied. When R^{y2} is an unsaturated hydrocarbon group, Z^{y2} and Z^{y3} are preferably single bonds.

In formula (YII),
R^{y3} is
preferably an unsaturated hydrocarbon group having 2 to 20 carbon atoms and optionally having a substituent or an aromatic hydrocarbon group having 6 to 20 carbon atoms and optionally having a substituent,
more preferably an unsaturated chain hydrocarbon group having 2 to 10 carbon atoms and optionally having a substituent or an aromatic hydrocarbon group having 6 to 10 carbon atoms and optionally having a substituent,
further preferably an unsaturated chain hydrocarbon group having 2 to 7 carbon atoms and optionally having a substituent or an aromatic hydrocarbon group having 6 to 8 carbon atoms and optionally having a substituent,
even further preferably an alkenyl group having 2 to 7 carbon atoms and optionally having a substituent or an aromatic hydrocarbon group having 6 to 8 carbon atoms and optionally having a substituent, and
particularly preferably an ethenyl group optionally having a substituent or a phenyl group optionally having a substituent.
ny5 to ny12 are each independently preferably 0 to 2, more preferably 0 to 1, and further preferably 0.
X^{y5} to X^{y12} are each independently preferably -R^{y5} or a halogen atom.

At least one of Y², Z^{y4}, and Z^{y5} represents a sulfur atom. When R^{y3} is an unsaturated hydrocarbon group, Z^{y5} is preferably a single bond.

Examples of the compound represented by formula (YI) include compounds represented by formula (YIA) to formula (YIE).

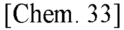

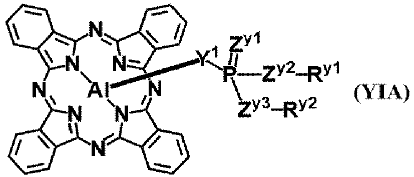

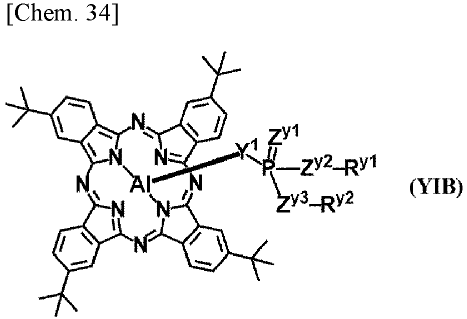

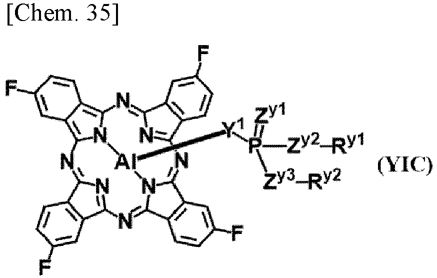

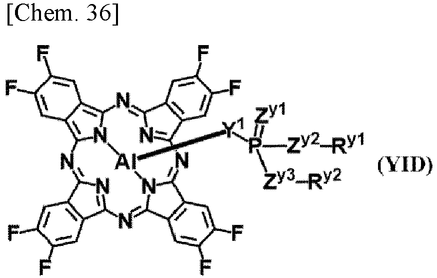

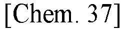

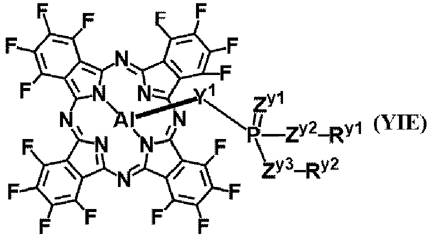

[In formula (YIA) to formula (YIE), R^{y1}, R^{y2}, Y¹, Z^{y1}, Z^{y2}, and Z^{y3} are the same as above.]

Examples of the compound represented by formula (YIA) include compounds represented by formula (YIA-1) to formula (YIA-24) shown in Table 26.

Examples of the compound represented by formula (YIB) include compounds represented by formula (YIB-1) to formula (YIB-24) shown in Table 27.

Examples of the compound represented by formula (YIC) include compounds represented by formula (YIC-1) to formula (YIC-24) shown in Table 28.

Examples of the compound represented by formula (YID) include compounds represented by formula (YID-1) to formula (YID-24) shown in Table 29.

Examples of the compound represented by formula (YIE) include compounds represented by formula (YIE-1) to formula (YIE-24) shown in Table 30.

In Table 26 to Table 30, "yi-1" represents a phenyl group, and "yi-2" represents an ethenyl group.

**[Table 26]**

| | **Y¹** | **Z^{y1}** | **Z^{y2}** | **Z^{y3}** | **R^{y1}** | **R^{y2}** |
|---|---|---|---|---|---|---|
| **(YIA-1)** | **Sulfur atom** | **Oxygen atom** | **Single bond** | **Single bond** | **yi-1** | **yi-1** |
| **(YIA-2)** | **Sulfur atom** | **Oxygen atom** | **Single bond** | **Oxygen atom** | **yi-1** | **yi-1** |
| **(YIA-3)** | **Sulfur atom** | **Oxygen atom** | **Single bond** | **Sulfur atom** | **yi-1** | **yi-1** |
| **(YIA-4)** | **Sulfur atom** | **Oxygen atom** | **Oxygen atom** | **Oxygen atom** | **yi-1** | **yi-1** |
| **(YIA-5)** | **Sulfur atom** | **Oxygen atom** | **Oxygen atom** | **Sulfur atom** | **yi-1** | **yi-1** |
| **(YIA-6)** | **Sulfur atom** | **Oxygen atom** | **Sulfur atom** | **Sulfur atom** | **yi-1** | **yi-1** |
| **(YIA-7)** | **Sulfur atom** | **Sulfur atom** | **Single bond** | **Single bond** | **yi-1** | **yi-1** |
| **(YIA-8)** | **Sulfur atom** | **Sulfur atom** | **Single bond** | **Oxygen atom** | **yi-1** | **yi-1** |
| **(YIA-9)** | **Sulfur atom** | **Sulfur atom** | **Single bond** | **Sulfur atom** | **yi-1** | **yi-1** |
| **(YIA-10)** | **Sulfur atom** | **Sulfur atom** | **Oxygen atom** | **Oxygen atom** | **yi-1** | **yi-1** |
| **(YIA-11)** | **Sulfur atom** | **Sulfur atom** | **Oxygen atom** | **Sulfur atom** | **yi-1** | **yi-1** |
| **(YIA-12)** | **Sulfur atom** | **Sulfur atom** | **Sulfur atom** | **Sulfur atom** | **yi-1** | **yi-1** |
| **(YIA-13)** | **Oxygen atom** | **Sulfur atom** | **Single bond** | **Single bond** | **yi-1** | **yi-1** |
| **(YIA-14)** | **Oxygen atom** | **Sulfur atom** | **Single bond** | **Oxygen atom** | **yi-1** | **yi-1** |
| **(YIA-15)** | **Oxygen atom** | **Sulfur atom** | **Single bond** | **Sulfur atom** | **yi-1** | **yi-1** |
| **(YIA-16)** | **Oxygen atom** | **Sulfur atom** | **Oxygen atom** | **Oxygen atom** | **yi-1** | **yi-1** |
| **(YIA-17)** | **Oxygen atom** | **Sulfur atom** | **Oxygen atom** | **Sulfur atom** | **yi-1** | **yi-1** |
| **(YIA-18)** | **Oxygen atom** | **Sulfur atom** | **Sulfur atom** | **Sulfur atom** | **yi-1** | **yi-1** |
| **(YIA-19)** | **Oxygen atom** | **Oxygen atom** | **Single bond** | **Sulfur atom** | **yi-1** | **yi-1** |
| **(YIA-20)** | **Oxygen atom** | **Oxygen atom** | **Oxygen atom** | **Sulfur atom** | **yi-1** | **yi-1** |
| **(YIA-21)** | **Oxygen atom** | **Oxygen atom** | **Sulfur atom** | **Sulfur atom** | **yi-1** | **yi-1** |
| **(YIA-22)** | **Sulfur atom** | **Oxygen atom** | **Single bond** | **Single bond** | **yi-1** | **yi-2** |
| **(YIA-23)** | **Sulfur atom** | **Sulfur atom** | **Single bond** | **Single bond** | **yi-1** | **yi-2** |
| **(YIA-24)** | **Oxygen atom** | **Sulfur atom** | **Single bond** | **Single bond** | **yi-1** | **yi-2** |

As the compound represented by formula (YIA),
the compounds represented by formula (YIA-1) to formula (YIA-6), formula (YIA-13) to formula (YIA-18), formula (YIA-21), and formula (YIA-22) to formula (YIA-24) are preferable, and
the compounds represented by formula (YIA-1), formula (YIA-13), formula (YIA-21), formula (YIA-23), and formula (YIA-24) are more preferable.

**[Table 27]**

| | **Y¹** | **Z^{y1}** | **Z^{y2}** | **Z^{y3}** | **R^{y1}** | **R^{y2}** |
|---|---|---|---|---|---|---|
| **(YIB-1)** | **Sulfur atom** | **Oxygen atom** | **Single bond** | **Single bond** | **yi-1** | **yi-1** |
| **(YIB-2)** | **Sulfur atom** | **Oxygen atom** | **Single bond** | **Oxygen atom** | **yi-1** | **yi-1** |
| **(YIB-3)** | **Sulfur atom** | **Oxygen atom** | **Single bond** | **Sulfur atom** | **yi-1** | **yi-1** |
| **(YIB-4)** | **Sulfur atom** | **Oxygen atom** | **Oxygen atom** | **Oxygen atom** | **yi-1** | **yi-1** |
| **(YIB-5)** | **Sulfur atom** | **Oxygen atom** | **Oxygen atom** | **Sulfur atom** | **yi-1** | **yi-1** |
| **(YIB-6)** | **Sulfur atom** | **Oxygen atom** | **Sulfur atom** | **Sulfur atom** | **yi-1** | **yi-1** |
| **(YIB-7)** | **Sulfur atom** | **Sulfur atom** | **Single bond** | **Single bond** | **yi-1** | **yi-1** |
| **(YIB-8)** | **Sulfur atom** | **Sulfur atom** | **Single bond** | **Oxygen atom** | **yi-1** | **yi-1** |
| **(YIB-9)** | **Sulfur atom** | **Sulfur atom** | **Single bond** | **Sulfur atom** | **yi-1** | **yi-1** |
| **(YIB-10)** | **Sulfur atom** | **Sulfur atom** | **Oxygen atom** | **Oxygen atom** | **yi-1** | **yi-1** |
| **(YIB-11)** | **Sulfur atom** | **Sulfur atom** | **Oxygen atom** | **Sulfur atom** | **yi-1** | **yi-1** |
| **(YIB-12)** | **Sulfur atom** | **Sulfur atom** | **Sulfur atom** | **Sulfur atom** | **yi-1** | **yi-1** |
| **(YIB-13)** | **Oxygen atom** | **Sulfur atom** | **Single bond** | **Single bond** | **yi-1** | **yi-1** |
| **(YIB-14)** | **Oxygen atom** | **Sulfur atom** | **Single bond** | **Oxygen atom** | **yi-1** | **yi-1** |
| **(YIB-15)** | **Oxygen atom** | **Sulfur atom** | **Single bond** | **Sulfur atom** | **yi-1** | **yi-1** |
| **(YIB-16)** | **Oxygen atom** | **Sulfur atom** | **Oxygen atom** | **Oxygen atom** | **yi-1** | **yi-1** |
| **(YIB-17)** | **Oxygen atom** | **Sulfur atom** | **Oxygen atom** | **Sulfur atom** | **yi-1** | **yi-1** |
| **(YIB-18)** | **Oxygen atom** | **Sulfur atom** | **Sulfur atom** | **Sulfur atom** | **yi-1** | **yi-1** |
| **(YIB-19)** | **Oxygen atom** | **Oxygen atom** | **Single bond** | **Sulfur atom** | **yi-1** | **yi-1** |
| **(YIB-20)** | **Oxygen atom** | **Oxygen atom** | **Oxygen atom** | **Sulfur atom** | **yi-1** | **yi-1** |
| **(YIB-21)** | **Oxygen atom** | **Oxygen atom** | **Sulfur atom** | **Sulfur atom** | **yi-1** | **yi-1** |
| **(YIB-22)** | **Sulfur atom** | **Oxygen atom** | **Single bond** | **Single bond** | **yi-1** | **yi-2** |
| **(YIB-23)** | **Sulfur atom** | **Sulfur atom** | **Single bond** | **Single bond** | **yi-1** | **yi-2** |
| **(YIB-24)** | **Oxygen atom** | **Sulfur atom** | **Single bond** | **Single bond** | **yi-1** | **yi-2** |

As the compound represented by formula (YIB),
the compounds represented by formula (YIB-1) to formula (YIB-6), formula (YIB-13) to formula (YIB-18), formula (YIB-21), and formula (YIB-22) to formula (YIB-24) are preferable, and
the compounds represented by formula (YIB-1), formula (YIB-13), formula (YIB-21), formula (YIB-23), and formula (YIB-24) are more preferable.

**[Table 28]**

| | **Y¹** | **Z^{y1}** | **Z^{y2}** | **Z^{y3}** | **R^{y1}** | **R^{y2}** |
|---|---|---|---|---|---|---|
| **(YIC-1)** | **Sulfur atom** | **Oxygen atom** | **Single bond** | **Single bond** | **yi-1** | **yi-1** |
| **(YIC-2)** | **Sulfur atom** | **Oxygen atom** | **Single bond** | **Oxygen atom** | **yi-1** | **yi-1** |
| **(YIC-3)** | **Sulfur atom** | **Oxygen atom** | **Single bond** | **Sulfur atom** | **yi-1** | **yi-1** |
| **(YIC-4)** | **Sulfur atom** | **Oxygen atom** | **Oxygen atom** | **Oxygen atom** | **yi-1** | **yi-1** |
| **(YIC-5)** | **Sulfur atom** | **Oxygen atom** | **Oxygen atom** | **Sulfur atom** | **yi-1** | **yi-1** |
| **(YIC-6)** | **Sulfur atom** | **Oxygen atom** | **Sulfur atom** | **Sulfur atom** | **yi-1** | **yi-1** |
| **(YIC-7)** | **Sulfur atom** | **Sulfur atom** | **Single bond** | **Single bond** | **yi-1** | **yi-1** |
| **(YIC-8)** | **Sulfur atom** | **Sulfur atom** | **Single bond** | **Oxygen atom** | **yi-1** | **yi-1** |
| **(YIC-9)** | **Sulfur atom** | **Sulfur atom** | **Single bond** | **Sulfur atom** | **yi-1** | **yi-1** |
| **(YIC-10)** | **Sulfur atom** | **Sulfur atom** | **Oxygen atom** | **Oxygen atom** | **yi-1** | **yi-1** |
| **(YIC-11)** | **Sulfur atom** | **Sulfur atom** | **Oxygen atom** | **Sulfur atom** | **yi-1** | **yi-1** |
| **(YIC-12)** | **Sulfur atom** | **Sulfur atom** | **Sulfur atom** | **Sulfur atom** | **yi-1** | **yi-1** |
| **(YIC-13)** | **Oxygen atom** | **Sulfur atom** | **Single bond** | **Single bond** | **yi-1** | **yi-1** |
| **(YIC-14)** | **Oxygen atom** | **Sulfur atom** | **Single bond** | **Oxygen atom** | **yi-1** | **yi-1** |
| **(YIC-15)** | **Oxygen atom** | **Sulfur atom** | **Single bond** | **Sulfur atom** | **yi-1** | **yi-1** |
| **(YIC-16)** | **Oxygen atom** | **Sulfur atom** | **Oxygen atom** | **Oxygen atom** | **yi-1** | **yi-1** |
| **(YIC-17)** | **Oxygen atom** | **Sulfur atom** | **Oxygen atom** | **Sulfur atom** | **yi-1** | **yi-1** |
| **(YIC-18)** | **Oxygen atom** | **Sulfur atom** | **Sulfur atom** | **Sulfur atom** | **yi-1** | **yi-1** |
| **(YIC-19)** | **Oxygen atom** | **Oxygen atom** | **Single bond** | **Sulfur atom** | **yi-1** | **yi-1** |
| **(YIC-20)** | **Oxygen atom** | **Oxygen atom** | **Oxygen atom** | **Sulfur atom** | **yi-1** | **yi-1** |
| **(YIC-21)** | **Oxygen atom** | **Oxygen atom** | **Sulfur atom** | **Sulfur atom** | **yi-1** | **yi-1** |
| **(YIC-22)** | **Sulfur atom** | **Oxygen atom** | **Single bond** | **Single bond** | **yi-1** | **yi-2** |
| **(YIC-23)** | **Sulfur atom** | **Sulfur atom** | **Single bond** | **Single bond** | **yi-1** | **yi-2** |
| **(YIC-24)** | **Oxygen atom** | **Sulfur atom** | **Single bond** | **Single bond** | **yi-1** | **yi-2** |

As the compound represented by formula (YIC),
the compounds represented by formula (YIC-1) to formula (YIC-6), formula (YIC-13) to formula (YIC-18), formula (YIC-21), and formula (YIC-22) to formula (YIC-24) are preferable, and
the compounds represented by formula (YIC-1), formula (YIC-13), formula (YIC-21), formula (YIC-23), and formula (YIC-24) are more preferable.

**[Table 29]**

| | **Y¹** | **Z^{y1}** | **Z^{y2}** | **Z^{y3}** | **R^{y1}** | **R^{y2}** |
|---|---|---|---|---|---|---|
| **(YID-1)** | **Sulfur atom** | **Oxygen atom** | **Single bond** | **Single bond** | **yi-1** | **yi-1** |
| **(YID-2)** | **Sulfur atom** | **Oxygen atom** | **Single bond** | **Oxygen atom** | **yi-1** | **yi-1** |
| **(YID-3)** | **Sulfur atom** | **Oxygen atom** | **Single bond** | **Sulfur atom** | **yi-1** | **yi-1** |
| **(YID-4)** | **Sulfur atom** | **Oxygen atom** | **Oxygen atom** | **Oxygen atom** | **yi-1** | **yi-1** |
| **(YID-5)** | **Sulfur atom** | **Oxygen atom** | **Oxygen atom** | **Sulfur atom** | **yi-1** | **yi-1** |
| **(YID-6)** | **Sulfur atom** | **Oxygen atom** | **Sulfur atom** | **Sulfur atom** | **yi-1** | **yi-1** |
| **(YID-7)** | **Sulfur atom** | **Sulfur atom** | **Single bond** | **Single bond** | **yi-1** | **yi-1** |
| **(YID-8)** | **Sulfur atom** | **Sulfur atom** | **Single bond** | **Oxygen atom** | **yi-1** | **yi-1** |
| **(YID-9)** | **Sulfur atom** | **Sulfur atom** | **Single bond** | **Sulfur atom** | **yi-1** | **yi-1** |
| **(YID-10)** | **Sulfur atom** | **Sulfur atom** | **Oxygen atom** | **Oxygen atom** | **yi-1** | **yi-1** |
| **(YID-11)** | **Sulfur atom** | **Sulfur atom** | **Oxygen atom** | **Sulfur atom** | **yi-1** | **yi-1** |
| **(YID-12)** | **Sulfur atom** | **Sulfur atom** | **Sulfur atom** | **Sulfur atom** | **yi-1** | **yi-1** |
| **(YID-13)** | **Oxygen atom** | **Sulfur atom** | **Single bond** | **Single bond** | **yi-1** | **yi-1** |
| **(YID-14)** | **Oxygen atom** | **Sulfur atom** | **Single bond** | **Oxygen atom** | **yi-1** | **yi-1** |
| **(YID-15)** | **Oxygen atom** | **Sulfur atom** | **Single bond** | **Sulfur atom** | **yi-1** | **yi-1** |
| **(YID-16)** | **Oxygen atom** | **Sulfur atom** | **Oxygen atom** | **Oxygen atom** | **yi-1** | **yi-1** |
| **(YID-17)** | **Oxygen atom** | **Sulfur atom** | **Oxygen atom** | **Sulfur atom** | **yi-1** | **yi-1** |
| **(YID-18)** | **Oxygen atom** | **Sulfur atom** | **Sulfur atom** | **Sulfur atom** | **yi-1** | **yi-1** |
| **(YID-19)** | **Oxygen atom** | **Oxygen atom** | **Single bond** | **Sulfur atom** | **yi-1** | **yi-1** |
| **(YID-20)** | **Oxygen atom** | **Oxygen atom** | **Oxygen atom** | **Sulfur atom** | **yi-1** | **yi-1** |
| **(YID-21)** | **Oxygen atom** | **Oxygen atom** | **Sulfur atom** | **Sulfur atom** | **yi-1** | **yi-1** |
| **(YID-22)** | **Sulfur atom** | **Oxygen atom** | **Single bond** | **Single bond** | **yi-1** | **yi-2** |
| **(YID-23)** | **Sulfur atom** | **Sulfur atom** | **Single bond** | **Single bond** | **yi-1** | **yi-2** |
| **(YID-24)** | **Oxygen atom** | **Sulfur atom** | **Single bond** | **Single bond** | **yi-1** | **yi-2** |

As the compound represented by formula (YID),
the compounds represented by formula (YID-1) to formula (YID-6), formula (YID-13) to formula (YID-18), formula (YID-21), and formula (YID-22) to formula (YID-24) are preferable, and
the compounds represented by formula (YID-1), formula (YID-13), formula (YID-21), formula (YID-23), and formula (YID-24) are more preferable.

**[Table 30]**

| | **Y¹** | **Z^{y1}** | **Z^{y2}** | **Z^{y3}** | **R^{y1}** | **R^{y2}** |
|---|---|---|---|---|---|---|
| **(YIE-1)** | **Sulfur atom** | **Oxygen atom** | **Single bond** | **Single bond** | **yi-1** | **yi-1** |
| **(YIE-2)** | **Sulfur atom** | **Oxygen atom** | **Single bond** | **Oxygen atom** | **yi-1** | **yi-1** |
| **(YIE-3)** | **Sulfur atom** | **Oxygen atom** | **Single bond** | **Sulfur atom** | **yi-1** | **yi-1** |
| **(YIE-4)** | **Sulfur atom** | **Oxygen atom** | **Oxygen atom** | **Oxygen atom** | **yi-1** | **yi-1** |
| **(YIE-5)** | **Sulfur atom** | **Oxygen atom** | **Oxygen atom** | **Sulfur atom** | **yi-1** | **yi-1** |
| **(YIE-6)** | **Sulfur atom** | **Oxygen atom** | **Sulfur atom** | **Sulfur atom** | **yi-1** | **yi-1** |
| **(YIE-7)** | **Sulfur atom** | **Sulfur atom** | **Single bond** | **Single bond** | **yi-1** | **yi-1** |
| **(YIE-8)** | **Sulfur atom** | **Sulfur atom** | **Single bond** | **Oxygen atom** | **yi-1** | **yi-1** |
| **(YIE-9)** | **Sulfur atom** | **Sulfur atom** | **Single bond** | **Sulfur atom** | **yi-1** | **yi-1** |
| **(YIE-10)** | **Sulfur atom** | **Sulfur atom** | **Oxygen atom** | **Oxygen atom** | **yi-1** | **yi-1** |
| **(YIE-11)** | **Sulfur atom** | **Sulfur atom** | **Oxygen atom** | **Sulfur atom** | **yi-1** | **yi-1** |
| **(YIE-12)** | **Sulfur atom** | **Sulfur atom** | **Sulfur atom** | **Sulfur atom** | **yi-1** | **yi-1** |
| **(YIE-13)** | **Oxygen atom** | **Sulfur atom** | **Single bond** | **Single bond** | **yi-1** | **yi-1** |
| **(YIE-14)** | **Oxygen atom** | **Sulfur atom** | **Single bond** | **Oxygen atom** | **yi-1** | **yi-1** |
| **(YIE-15)** | **Oxygen atom** | **Sulfur atom** | **Single bond** | **Sulfur atom** | **yi-1** | **yi-1** |
| **(YIE-16)** | **Oxygen atom** | **Sulfur atom** | **Oxygen atom** | **Oxygen atom** | **yi-1** | **yi-1** |
| **(YIE-17)** | **Oxygen atom** | **Sulfur atom** | **Oxygen atom** | **Sulfur atom** | **yi-1** | **yi-1** |
| **(YIE-18)** | **Oxygen atom** | **Sulfur atom** | **Sulfur atom** | **Sulfur atom** | **yi-1** | **yi-1** |
| **(YIE-19)** | **Oxygen atom** | **Oxygen atom** | **Single bond** | **Sulfur atom** | **yi-1** | **yi-1** |
| **(YIE-20)** | **Oxygen atom** | **Oxygen atom** | **Oxygen atom** | **Sulfur atom** | **yi-1** | **yi-1** |
| **(YIE-21)** | **Oxygen atom** | **Oxygen atom** | **Sulfur atom** | **Sulfur atom** | **yi-1** | **yi-1** |
| **(YIE-22)** | **Sulfur atom** | **Oxygen atom** | **Single bond** | **Single bond** | **yi-1** | **yi-2** |
| **(YIE-23)** | **Sulfur atom** | **Sulfur atom** | **Single bond** | **Single bond** | **yi-1** | **yi-2** |
| **(YIE-24)** | **Oxygen atom** | **Sulfur atom** | **Single bond** | **Single bond** | **yi-1** | **yi-2** |

As the compound represented by formula (YIE),
the compounds represented by formula (YIE-1) to formula (YIE-6), formula (YIE-13) to formula (YIE-18), formula (YIE-21), and formula (YIE-22) to formula (YIE-24) are preferable, and
the compounds represented by formula (YIE-1), formula (YIE-13), formula (YIE-21), formula (YIE-23), and formula (YIE-24) are more preferable.

Examples of the compound represented by formula (YII) include compounds represented by formula (YIIA) to formula (YIIE).

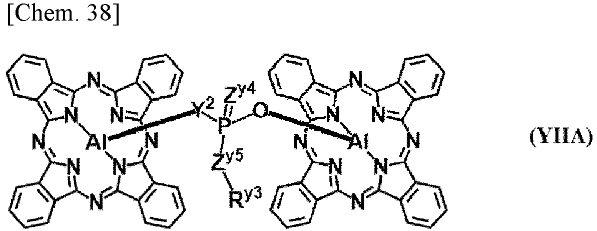

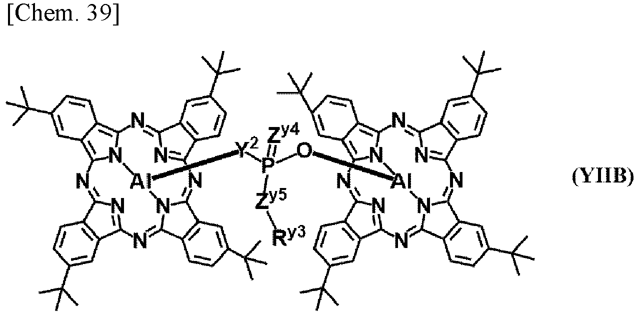

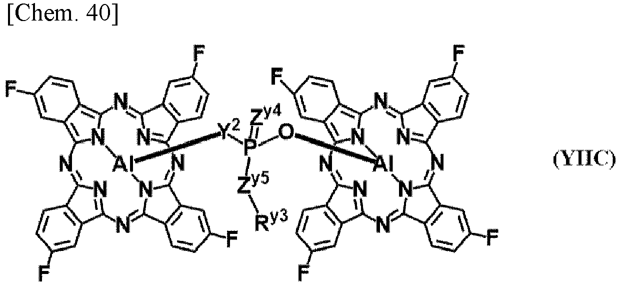

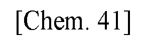

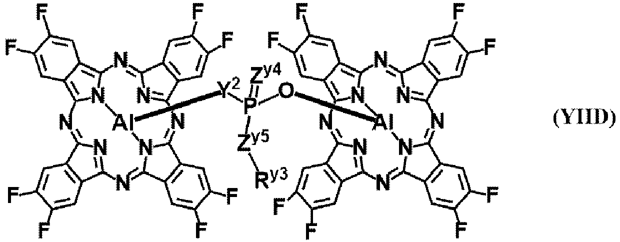

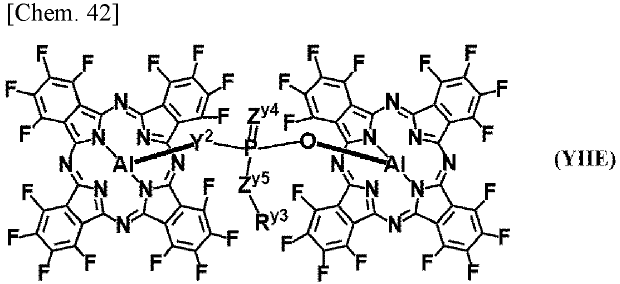

[In formula (YIIA) to formula (YIIE), R^{y3}, Y², Z^{y4}, and Z^{y5} are the same as above.]

Examples of the compound represented by formula (YIIA) include compounds represented by formula (YIIA-1) to formula (YIIA-13) shown in Table 31.

Examples of the compound represented by formula (YIIB) include compounds represented by formula (YIIB-1) to formula (YIIB-13) shown in Table 32.

Examples of the compound represented by formula (YIIC) include compounds represented by formula (YIIC-1) to formula (YIIC-13) shown in Table 33.

Examples of the compound represented by formula (YIID) include compounds represented by formula (YIID-1) to formula (YIID-13) shown in Table 34.

Examples of the compound represented by formula (YIIE) include compounds represented by formula (YIIE-1) to formula (YIIE-13) shown in Table 35.

In Table 31 to Table 35, "yi-1" represents a phenyl group, and "yi-2" represents an ethenyl group.

**[Table 31]**

| | **Y²** | **Z^{y4}** | **Z^{y5}** | **R^{y3}** |
|---|---|---|---|---|
| **(YIIA-1)** | **Sulfur atom** | **Oxygen atom** | **Single bond** | **yi-1** |
| **(YIIA-2)** | **Sulfur atom** | **Oxygen atom** | **Oxygen atom** | **yi-1** |
| **(YIIA-3)** | **Sulfur atom** | **Oxygen atom** | **Sulfur atom** | **yi-1** |
| **(YIIA-4)** | **Sulfur atom** | **Sulfur atom** | **Single bond** | **yi-1** |
| **(YIIA-5)** | **Sulfur atom** | **Sulfur atom** | **Oxygen atom** | **yi-1** |
| **(YIIA-6)** | **Sulfur atom** | **Sulfur atom** | **Sulfur atom** | **yi-1** |
| **(YIIA-7)** | **Oxygen atom** | **Oxygen atom** | **Sulfur atom** | **yi-1** |
| **(YIIA-8)** | **Oxygen atom** | **Sulfur atom** | **Single bond** | **yi-1** |
| **(YIIA-9)** | **Oxygen atom** | **Sulfur atom** | **Oxygen atom** | **yi-1** |
| **(YIIA-10)** | **Oxygen atom** | **Sulfur atom** | **Sulfur atom** | **yi-1** |
| **(YIIA-11)** | **Sulfur atom** | **Oxygen atom** | **Single bond** | **yi-2** |
| **(YIIA-12)** | **Sulfur atom** | **Sulfur atom** | **Single bond** | **yi-2** |
| **(YIIA-13)** | **Oxygen atom** | **Sulfur atom** | **Single bond** | **yi-2** |

As the compound represented by formula (YIIA),
the compounds represented by formula (YIIA-1), formula (YIIA-2), formula (YIIA-8), formula (YIIA-9), formula (YIIA-12), and formula (YIIA-13) are preferable, and
the compounds represented by formula (YIIA-1), formula (YIIA-8), formula (YIIA-12), and formula (YIIA-13) are more preferable.

**[Table 32]**

| | **Y²** | **Z^{y4}** | **Z^{y5}** | **R^{y3}** |
|---|---|---|---|---|
| **(YIIB-1)** | **Sulfur atom** | **Oxygen atom** | **Single bond** | **yi-1** |
| **(YIIB-2)** | **Sulfur atom** | **Oxygen atom** | **Oxygen atom** | **yi-1** |
| **(YIIB-3)** | **Sulfur atom** | **Oxygen atom** | **Sulfur atom** | **yi-1** |
| **(YIIB-4)** | **Sulfur atom** | **Sulfur atom** | **Single bond** | **yi-1** |
| **(YIIB-5)** | **Sulfur atom** | **Sulfur atom** | **Oxygen atom** | **yi-1** |
| **(YIIB-6)** | **Sulfur atom** | **Sulfur atom** | **Sulfur atom** | **yi-1** |
| **(YIIB-7)** | **Oxygen atom** | **Oxygen atom** | **Sulfur atom** | **yi-1** |
| **(YIIB-8)** | **Oxygen atom** | **Sulfur atom** | **Single bond** | **yi-1** |
| **(YIIB-9)** | **Oxygen atom** | **Sulfur atom** | **Oxygen atom** | **yi-1** |
| **(YIIB-10)** | **Oxygen atom** | **Sulfur atom** | **Sulfur atom** | **yi-1** |
| **(YIIB-11)** | **Sulfur atom** | **Oxygen atom** | **Single bond** | **yi-2** |
| **(YIIB-12)** | **Sulfur atom** | **Sulfur atom** | **Single bond** | **yi-2** |
| **(YIIB-13)** | **Oxygen atom** | **Sulfur atom** | **Single bond** | **yi-2** |

As the compound represented by formula (YIIB),
the compounds represented by formula (YIIB-1), formula (YIIB-2), formula (YIIB-8), formula (YIIB-9), formula (YIIB-12), and formula (YIIB-13) are preferable, and
the compounds represented by formula (YIIB-1), formula (YIIB-8), formula (YIIB-12), and formula (YIIB-13) are more preferable.

**[Table 33]**

| | **Y²** | **Z^{y4}** | **Z^{y5}** | **R^{y3}** |
|---|---|---|---|---|
| **(YIIC-1)** | **Sulfur atom** | **Oxygen atom** | **Single bond** | **yi-1** |
| **(YIIC-2)** | **Sulfur atom** | **Oxygen atom** | **Oxygen atom** | **yi-1** |
| **(YIIC-3)** | **Sulfur atom** | **Oxygen atom** | **Sulfur atom** | **yi-1** |
| **(YIIC-4)** | **Sulfur atom** | **Sulfur atom** | **Single bond** | **yi-1** |
| **(YIIC-5)** | **Sulfur atom** | **Sulfur atom** | **Oxygen atom** | **yi-1** |
| **(YIIC-6)** | **Sulfur atom** | **Sulfur atom** | **Sulfur atom** | **yi-1** |
| **(YIIC-7)** | **Oxygen atom** | **Oxygen atom** | **Sulfur atom** | **yi-1** |
| **(YIIC-8)** | **Oxygen atom** | **Sulfur atom** | **Single bond** | **yi-1** |
| **(YIIC-9)** | **Oxygen atom** | **Sulfur atom** | **Oxygen atom** | **yi-1** |
| **(YIIC-10)** | **Oxygen atom** | **Sulfur atom** | **Sulfur atom** | **yi-1** |
| **(YIIC-11)** | **Sulfur atom** | **Oxygen atom** | **Single bond** | **yi-2** |
| **(YIIC-12)** | **Sulfur atom** | **Sulfur atom** | **Single bond** | **yi-2** |
| **(YIIC-13)** | **Oxygen atom** | **Sulfur atom** | **Single bond** | **yi-2** |

As the compound represented by formula (YIIC),
the compounds represented by formula (YIIC-1), formula (YIIC-2), formula (YIIC-8), formula (YIIC-9), formula (YIIC-12), and formula (YIIC-13) are preferable, and
the compounds represented by formula (YIIC-1), formula (YIIC-8), formula (YIIC-12), and formula (YIIC-13) are more preferable.

**[Table 34]**

| | **Y²** | **Z^{y4}** | **Z^{y5}** | **R^{y3}** |
|---|---|---|---|---|
| **(YIID-1)** | **Sulfur atom** | **Oxygen atom** | **Single bond** | **yi-1** |
| **(YIID-2)** | **Sulfur atom** | **Oxygen atom** | **Oxygen atom** | **yi-1** |
| **(YIID-3)** | **Sulfur atom** | **Oxygen atom** | **Sulfur atom** | **yi-1** |
| **(YIID-4)** | **Sulfur atom** | **Sulfur atom** | **Single bond** | **yi-1** |
| **(YIID-5)** | **Sulfur atom** | **Sulfur atom** | **Oxygen atom** | **yi-1** |
| **(YIID-6)** | **Sulfur atom** | **Sulfur atom** | **Sulfur atom** | **yi-1** |
| **(YIID-7)** | **Oxygen atom** | **Oxygen atom** | **Sulfur atom** | **yi-1** |
| **(YIID-8)** | **Oxygen atom** | **Sulfur atom** | **Single bond** | **yi-1** |
| **(YIID-9)** | **Oxygen atom** | **Sulfur atom** | **Oxygen atom** | **yi-1** |
| **(YIID-10)** | **Oxygen atom** | **Sulfur atom** | **Sulfur atom** | **yi-1** |
| **(YIID-11)** | **Sulfur atom** | **Oxygen atom** | **Single bond** | **yi-2** |
| **(YIID-12)** | **Sulfur atom** | **Sulfur atom** | **Single bond** | **yi-2** |
| **(YIID-13)** | **Oxygen atom** | **Sulfur atom** | **Single bond** | **yi-2** |

As the compound represented by formula (YIID),
the compounds represented by formula (YIID-1), formula (YIID-2), formula (YIID-8), formula (YIID-9), formula (YIID-12), and formula (YIID-13) are preferable, and
the compounds represented by formula (YIID-1), formula (YIID-8), formula (YIID-12), and formula (YIID-13) are more preferable.

**[Table 35]**

| | **Y²** | **Z^{y4}** | **Z^{y5}** | **R^{y3}** |
|---|---|---|---|---|
| **(YIIE-1)** | **Sulfur atom** | **Oxygen atom** | **Single bond** | **yi-1** |
| **(YIIE-2)** | **Sulfur atom** | **Oxygen atom** | **Oxygen atom** | **yi-1** |
| **(YIIE-3)** | **Sulfur atom** | **Oxygen atom** | **Sulfur atom** | **yi-1** |
| **(YIIE-4)** | **Sulfur atom** | **Sulfur atom** | **Single bond** | **yi-1** |
| **(YIIE-5)** | **Sulfur atom** | **Sulfur atom** | **Oxygen atom** | **yi-1** |
| **(YIIE-6)** | **Sulfur atom** | **Sulfur atom** | **Sulfur atom** | **yi-1** |
| **(YIIE-7)** | **Oxygen atom** | **Oxygen atom** | **Sulfur atom** | **yi-1** |
| **(YIIE-8)** | **Oxygen atom** | **Sulfur atom** | **Single bond** | **yi-1** |
| **(YIIE-9)** | **Oxygen atom** | **Sulfur atom** | **Oxygen atom** | **yi-1** |
| **(YIIE-10)** | **Oxygen atom** | **Sulfur atom** | **Sulfur atom** | **yi-1** |
| **(YIIE-11)** | **Sulfur atom** | **Oxygen atom** | **Single bond** | **yi-2** |
| **(YIIE-12)** | **Sulfur atom** | **Sulfur atom** | **Single bond** | **yi-2** |
| **(YIIE-13)** | **Oxygen atom** | **Sulfur atom** | **Single bond** | **yi-2** |

As the compound represented by formula (YIIE),
the compounds represented by formula (YIIE-1), formula (YIIE-2), formula (YIIE-8), formula (YIIE-9), formula (YIIE-12), and formula (YIIE-13) are preferable, and
the compounds represented by formula (YIIE-1), formula (YIIE-8), formula (YIIE-12), and formula (YIIE-13) are more preferable.

The compound represented by formula (YI) can be produced, for example, by appropriately reacting the compound represented by formula (YIII) with the compound represented by formula (YIV).

The compound represented by formula (YII) can be produced, for example, by appropriately reacting the compound represented by formula (YIIIa) and the compound represented by formula (YIIIb) with the compound represented by formula (YV).

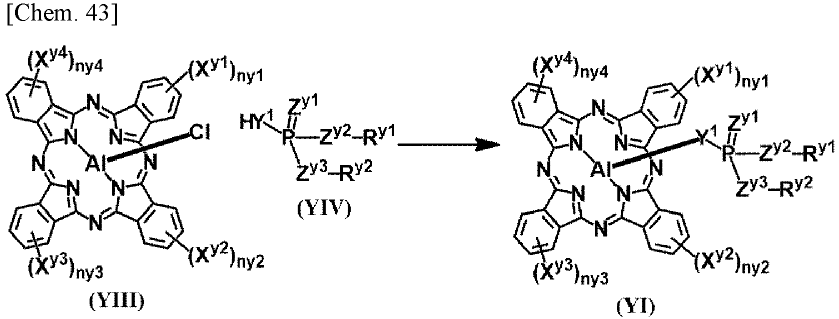

[In formula (YI), formula (YIII), and formula (YIV), R^{y1}, R^{y2}, Y¹, Z^{y1}, Z^{y2}, Z^{y3}, X^{y1} to X^{y4}, and ny1 to ny4 are the same as above.]

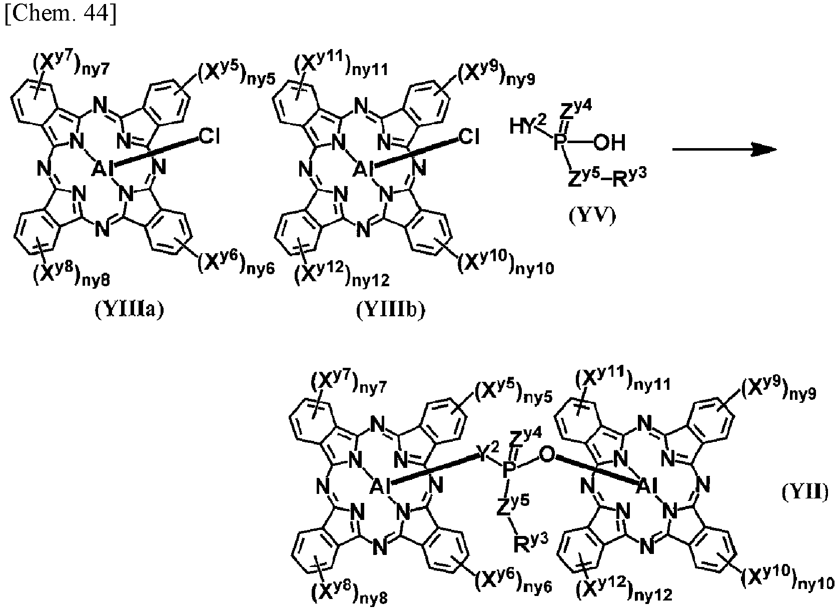

[In formula (YII), formula (YIIIa), formula (YIIIb), and formula (YV), R^{y3}, Y², Z^{y4}, Z^{y5}, X^{y5} to X^{y12}, and ny5 to ny12 are the same as above.]

The content of the aluminum phthalocyanine pigment is preferably 0.5 to 70% by mass, more preferably 1 to 55% by mass, and further preferably 2 to 50% by mass, in the whole amount of the solid content of the colored resin composition.

Herein, the term "whole amount of the solid content" means the total amount of components obtained by excluding the solvent from the colored resin composition of the present invention. The whole amount of the solid content and the content of each of the components with respect thereto can be measured by known analysis means such as liquid chromatography or gas chromatography.

The content of the aluminum phthalocyanine pigment in the whole amount of the colorant (A) is preferably 20 to 100% by mass, more preferably 30 to 100% by mass, further preferably 40 to 100% by mass, and further more preferably 60 to 100% by mass.

The colorant (A) may further contain a different colorant (hereinafter, sometimes referred to as a colorant (A2)) from the aluminum phthalocyanine pigment.

The colorant (A2) may be one or both of a dye and a pigment.

Examples of the dye include a compound that is not a pigment but classified into a compound having a hue in the Color Index (published by The Society of Dyers and Colourists), and a known dye as described in Dying note (Shikisensha Co., Ltd.).

As the dye, an azo dye, a cyanine dye, a triphenylmethane dye, a thiazole dye, an oxazine dye, a quinophthalone dye, an anthraquinone dye, a naphthoquinone dye, a quinonimine dye, a methine dye, an azomethine dye, a squarylium dye, an acridine dye, a styryl dye, a coumarin dye, a quinoline dye, a nitro dye, and the like may be used, and for each of these dyes, known dyes are used.

Specific examples of the dye include
C. I. Solvent dyes such as:
   C. I. Solvent Yellow 4 (hereinafter, the term "C. I. Solvent Yellow" is omitted and only the number is shown; ditto for other dyes), 14, 15, 23, 24, 38, 62, 63, 68, 82, 94, 99, 117, 162, 163, 167, and 189;
   C. I. Solvent Red 111, 125, 130, 143, 145, 146, 150, 151, 155, 168, 169, 172, 175, 181, 207, 222, 227, 230, 245, and 247;
   C. I. Solvent Orange 2, 7, 11, 15, 26, 56, 77, and 86;
   C. I. Solvent Violet 11, 13, 14, 26, 31, 36, 37, 38, 45, 47, 48, 51, 59, and 60;
   C. I. Solvent Blue 4, 5, 14, 18, 35, 36, 37, 45, 58, 59, 59:1, 63, 68, 69, 78, 79, 83, 90, 94, 97, 98, 100, 101, 102, 104, 105, 111, 112, 122, 128, 132, 136, and 139; and
   C. I. Solvent Green 1, 3, 5, 7, 28, 29, 32, 33, 34, and 35,
C. I. Acid dyes such as:
   C. I. Acid Yellow 1, 3, 7, 9, 11, 17, 23, 25, 29, 34, 36, 38, 40, 42, 54, 65, 72, 73, 76, 79, 98, 99, 111, 112, 113, 114, 116, 119, 123, 128, 134, 135, 138, 139, 140, 144, 150, 155, 157, 160, 161, 163, 168, 169, 172, 177, 178, 179, 184, 190, 193, 196, 197, 199, 202, 203, 204, 205, 207, 212, 214, 220, 221, 228, 230, 232, 235, 238, 240, 242, 243, and 251;
   C. I. Acid Red 1, 4, 8, 14, 17, 18, 26, 27, 29, 31, 33, 34, 35, 37, 40, 42, 44, 57, 66, 73, 76, 80, 88, 97, 103, 106, 111, 114, 129, 133, 134, 138, 143, 145, 150, 151, 155, 158, 160, 172, 176, 182, 183, 195, 198, 206, 211, 215, 216, 217, 227, 228, 249, 252, 257, 258, 260, 261, 266, 268, 270, 274, 277, 280, 281, 308, 312, 315, 316, 339, 341, 345, 346, 349, 382, 383, 394, 401, 412, 417, 418, 422, and 426;
   C. I. Acid Orange 6, 7, 8, 10, 12, 26, 50, 51, 52, 56, 62, 63, 64, 74, 75, 94, 95, 107, 108, 169, and 173;
   C. I. Acid Violet 6B, 7, 15, 16, 17, 19, 21, 23, 24, 25, 34, 38, 49, and 72;
   C.I. Acid Blue 1, 3, 5, 7, 9, 11, 13, 15, 17, 18, 22, 23, 24, 25, 26, 27, 29, 34, 38, 40, 41, 42, 43, 45, 48, 51, 54, 59, 60, 62, 70, 72, 74, 75, 78, 80, 82, 83, 86, 87, 88, 90, 90:1, 91, 92, 93, 93:1, 96, 99, 100, 102, 103, 104, 108, 109, 110, 112, 113, 117, 119, 120, 123, 126, 127, 129, 130, 131, 138, 140, 142, 143, 147, 150, 151, 154, 158, 161, 166, 167, 168, 170, 171, 175, 182, 183, 184, 187, 192, 199, 203, 204, 205, 210, 213, 229, 234, 236, 256, 259, 267, 269, 278, 280, 285, 290, 296, 315, 324:1, 335, and 340; and
   C. I. Acid Green 1, 3, 5, 6, 7, 8, 9, 11, 13, 14, 15, 16, 22, 25, 27, 28, 41, 50, 50:1, 58, 63, 65, 80, 104, 105, 106, and 109,
C. I. Direct dyes such as:
   C. I. Direct Yellow 2, 33, 34, 35, 38, 39, 43, 47, 50, 54, 58, 68, 69, 70, 71, 86, 93, 94, 95, 98, 102, 108, 109, 129, 136, 138, and 141;
   C. I. Direct Red 79, 82, 83, 84, 91, 92, 96, 97, 98, 99, 105, 106, 107, 172, 173, 176, 177, 179, 181, 182, 184, 204, 207, 211, 213, 218, 220, 221, 222, 232, 233, 234, 241, 243, 246, and 250;
   C. I. Direct Orange 26, 34, 39, 41, 46, 50, 52, 56, 57, 61, 64, 65, 68, 70, 96, 97, 106, and 107;
   C. I. Direct Violet 47, 52, 54, 59, 60, 65, 66, 79, 80, 81, 82, 84, 89, 90, 93, 95, 96, 103, and 104;
C. I. Direct Blue 1, 2, 3, 6, 8, 15, 22, 25, 28, 29, 40, 41, 42, 47, 52, 55, 57, 71, 76, 77, 78, 80, 81, 84, 85, 90, 93, 94, 95, 97, 98, 99, 100, 101, 106, 107, 108, 109, 113, 114, 115, 117, 119, 120, 137, 149, 150, 153, 155, 156, 158, 159, 160, 161, 162, 163, 164, 165, 166, 167, 168, 170, 171, 172, 173, 188, 190, 192, 193, 194, 195, 196, 198, 200, 201, 202, 203, 207, 209, 210, 212, 213, 214, 222, 225, 226, 228, 229, 236, 237, 238, 242, 243, 244, 245, 246, 247, 248, 249, 250, 251, 252, 256, 257, 259, 260, 268, 274, 275, and 293; and
   C. I. Direct Green 25, 27, 31, 32, 34, 37, 63, 65, 66, 67, 68, 69, 72, 77, 79, and 82,
C. I. Disperse dyes such as:
   C. I. Disperse Yellow 51, 54, and 76;
   C. I. Disperse Violet 26 and 27; and
   C. I. Disperse Blue 1, 14, 56, and 60,
C. I. Basic dyes such as:
   C. I. Basic Blue 1, 3, 5, 7, 9, 19, 21, 22, 24, 25, 26, 28, 29, 40, 41, 45, 47, 54, 58, 59, 60, 64, 65, 66, 67, 68, 81, 83, 88, and 89;
   C. I. Basic Violet 2;
   C. I. Basic Red 9; and
   C. I. Basic Green 1,
C. I. Reactive dyes such as:
   C. I. Reactive Yellow 2, 76, and 116;
   C. I. Reactive Orange 16; and
   C. I. Reactive Red 36,
C. I. Mordant dyes such as:
   C. I. Mordant Yellow 5, 8, 10, 16, 20, 26, 30, 31, 33, 42, 43, 45, 56, 61, 62, and 65;
   C. I. Mordant Red 1, 2, 3, 4, 9, 11, 12, 14, 17, 18, 19, 22, 23, 24, 25, 26, 29, 30, 32, 33, 36, 37, 38, 39, 41, 42, 43, 45, 46, 48, 52, 53, 56, 62, 63, 71, 74, 76, 78, 85, 86, 88, 90, 94, and 95;
   C. I. Mordant Orange 3, 4, 5, 8, 12, 13, 14, 20, 21, 23, 24, 28, 29, 32, 34, 35, 36, 37, 42, 43, 47, and 48;
   C. I. Mordant Violet 1, 1:1, 2, 3, 4, 5, 6, 7, 8, 10, 11, 14, 15, 16, 17, 18, 19, 21, 22, 23, 24, 27, 28, 30, 31, 32, 33, 36, 37, 39, 40, 41, 44, 45, 47, 48, 49, 53, and 58;
   C. I. Mordant Blue 1, 2, 3, 7, 8, 9, 12, 13, 15, 16, 19, 20, 21, 22, 23, 24, 26, 30, 31, 32, 39, 40, 41, 43, 44, 48, 49, 53, 61, 74, 83, and 84; and
   C. I. Mordant Green 1, 3, 4, 5, 10, 13, 15, 19, 21, 23, 26, 29, 31, 33, 34, 35, 41, 43, and 53; and
C. I. Vat dyes such as:
   C. I. Vat Green 1.

One dye or a plurality of dyes may be used for each of the colors of these dyes, and the dyes of the colors may be used in combination.

Examples of the pigment include a pigment that is classified into a pigment in the Color Index (published by The Society of Dyers and Colourists) and the following pigments.

Specific examples of the pigment include
green pigments such as C.I. Pigment Green 7, 36, and 58;
yellow pigments such as C.I. Pigment Yellow 1, 3, 12, 13, 14, 15, 16, 17, 20, 24, 31, 53, 83, 86, 93, 94, 109, 110, 117, 125, 128, 129, 137, 138, 139, 147, 148, 150, 153, 154, 166, 173, 185, 194, and 214;
orange pigments such as C.I. Pigment Orange 13, 31, 36, 38, 40, 42, 43, 51, 55, 59, 61, 64, 65, 71, and 73;
red pigments such as C.I. Pigment Red 9, 97, 105, 122, 144, 149, 166, 168, 176, 177, 180, 192, 209, 215, 216, 242, 254, 255, 264, and 265;
blue pigments such as C.I. Pigment Blue 16 and 60; and
violet pigments such as C.I. Pigment Violet 19, 23, 29, 32, 36, and 38.

One pigment or a plurality of pigments may be used for each of the colors of these pigments, and the pigments of the colors may be used in combination.

If necessary, the pigment may be subjected to a treatment such as a rosin treatment; a surface treatment using a pigment derivative or the like having an introduced acidic group or basic group; a pigment surface graft treatment with a polymeric compound or the like; a particle micronization treatment by a sulfuric acid micronization method or the like; a washing treatment with an organic solvent, water or the like for removing impurities; or a removing treatment of ionic impurities by an ionic exchange method or the like. The pigment preferably has a substantially uniform particle diameter. To the pigment, a pigment dispersant is added, followed by performing a dispersion treatment, whereby a pigment dispersion in which the pigment is uniformly dispersed may be produced. The pigment may be each independently subjected to the dispersion treatment, or a plurality of pigments may be together subjected to the dispersion treatment.

The pigment dispersant includes the same dispersant that may be included in the colored resin compositions described below.

When the pigment dispersant is used, the amount thereof used is preferably 10 parts by mass or more and 200 parts by mass or less, more preferably 15 parts by mass or more and 180 parts by mass or less, and further preferably 20 parts by mass or more and 160 parts by mass or less, relative to 100 parts by mass of the pigment. When the amount of the pigment dispersant used falls within the above-mentioned range, a pigment dispersion in which two or more pigments are more uniformly dispersed tends to be obtained.

When the colorant (A) contains the colorant (A2), the content of the colorant (A2) is preferably 1 to 80% by mass, more preferably 1 to 70% by mass, and further preferably 1 to 60% by mass, in the whole amount of the colorant (A).

The content of the colorant (A) is preferably 0.5 to 80% by mass, more preferably 1 to 70% by mass, and further preferably 2 to 55% by mass, in the whole amount of the solid content of the colored resin composition. When the content of the colorant (A) falls within the above-mentioned range, desired spectroscopy and color density are more likely to be obtained.

### <Compound represented by formula (DA)>

The colored resin composition according to the present invention contains a compound represented by formula (DA). When the compound represented by formula (DA) is combined with a copper phthalocyanine pigment among phthalocyanines, an adhesion effect may be decreased, but an adhesion improvement effect is significantly exhibited when the compound represented by formula (DA) is combined with an aluminum phthalocyanine pigment.

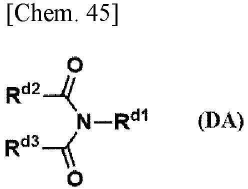

[In formula (DA),
R^{d1} represents a hydrocarbon group having 1 to 12 carbon atoms and optionally having a substituent. When the hydrocarbon group has 2 to 12 carbon atoms and the hydrocarbon group has -CH₂-, -CH₂- may be substituted with -O-, -S-, or -CO-.
R^{d2} and R^{d3} each independently represent a hydrogen atom or a hydrocarbon group having 1 to 12 carbon atoms and optionally having a substituent, or R^{d2} and R^{d3} represent that R^{d2} and R^{d3} are combined to form a ring together with -CO-NR^{d1}-CO-.]

The numbers of carbon atoms of the hydrocarbon groups represented by R^{d1} to R^{d3} are each 1 to 12, more preferably 1 to 10, further preferably 1 to 6, and even further preferably 1 to 3.

The number of carbon atoms of the hydrocarbon group represented by R^{d1} may be smaller than the number of carbon atoms of the hydrocarbon group represented by R^{d2} or R^{d3} and the number of carbon atoms of the ring formed together with -CO-NR^{d1}-CO- by combining R^{d2} and R^{d3}.

The hydrocarbon groups having 1 to 12 carbon atoms represented by R^{d1} to R^{d3} may each be an aliphatic hydrocarbon group or an aromatic hydrocarbon group, and the aliphatic hydrocarbon group may be saturated or unsaturated, and may be chain or cyclic (alicyclic hydrocarbon group).

Examples of the saturated or unsaturated chain hydrocarbon groups represented by R^{d1} to R^{d3} include the same groups as those having 1 to 12 carbon atoms among the saturated or unsaturated chain hydrocarbon groups represented by R^{x2}.

The numbers of carbon atoms of the saturated chain hydrocarbon groups represented by R^{d1} to R^{d3} are each preferably 1 to 10, more preferably 1 to 6, and further preferably 1 to 3.

The numbers of carbon atoms of the unsaturated chain hydrocarbon groups represented by R^{d1} to R^{d3} are each preferably 2 to 10, more preferably 2 to 6, and further preferably 2 to 3.

Examples of the saturated or unsaturated alicyclic hydrocarbon groups represented by R^{d1} to R^{d3} include the same groups as those having 3 to 12 carbon atoms among the saturated or unsaturated alicyclic hydrocarbon groups represented by R^{x2}.

The numbers of carbon atoms of the saturated or unsaturated alicyclic hydrocarbon groups represented by R^{d1} to R^{d3} are each preferably 3 to 10.

Examples of the aromatic hydrocarbon groups represented by R^{d1} to R^{d3} include the same groups as those having 6 to 12 carbon atoms among the aromatic hydrocarbon groups represented by R^{x2}.

The numbers of carbon atoms of the aromatic hydrocarbon groups represented by R^{d1} to R^{d3} are each preferably 6 to 10 and further preferably 6 to 8.

The hydrocarbon groups represented by R^{d1} to R^{d3} may each be a group obtained by combining the hydrocarbon groups exemplified above (e.g., an aromatic hydrocarbon group and at least one of a chain hydrocarbon group and an alicyclic hydrocarbon group). Specific examples of such groups include the same groups as those having 7 to 12 carbon atoms among the groups exemplified as R^{x2}.

The numbers of carbon atoms of these groups are each preferably 7 to 10.

The groups represented by R^{d1} to R^{d3} may each be an alkyl group to which one or more alicyclic hydrocarbon groups are bonded such as a group obtained by combining the hydrocarbon groups exemplified above (e.g., a chain hydrocarbon group and an alicyclic hydrocarbon group) (e.g., a cyclopropylmethyl group, etc.).

The numbers of carbon atoms of these groups are each preferably 4 to 10.

Examples of the hydrocarbon group having 1 to 12 carbon atoms represented by R^{d1} (note that -CH₂- in the hydrocarbon group is not substituted with -O-, -S-, or -CO-) include the following groups.

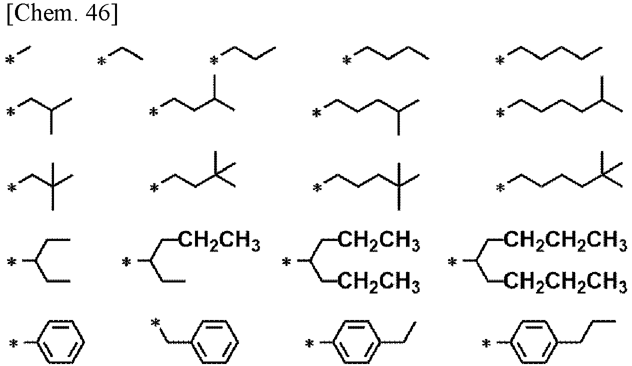

In the hydrocarbon group having 1 to 12 carbon atoms represented by R^{d1}, when the hydrocarbon group has 2 to 12 carbon atoms and the hydrocarbon group has -CH₂-, -CH₂- may be substituted with -O-, -S-, or -CO-. In the hydrocarbon group having 2 to 12 carbon atoms, adjacent -CH₂- groups are not substituted with -O- and/or -S- at the same time, and terminal - CH₂- groups are not substituted with -O-, -S-, or -CO-.

Examples of a group obtained by substituting -CH₂- in the hydrocarbon group having 1 to 12 carbon atoms represented by R^{d1} with -O-, -S-, or -CO- include the following groups.

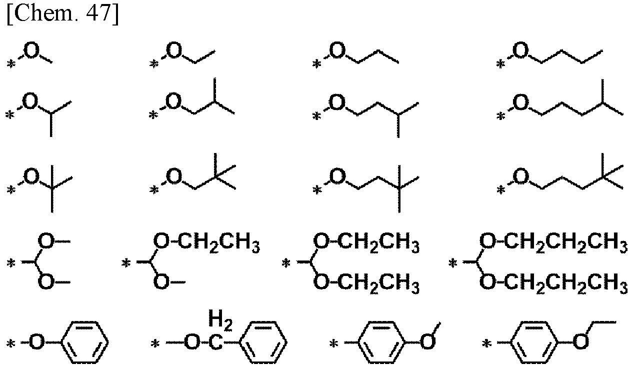

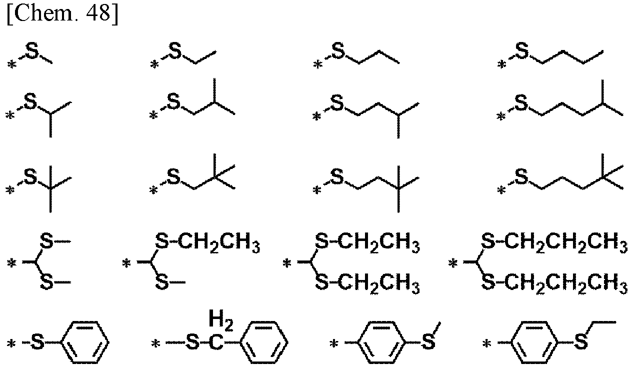

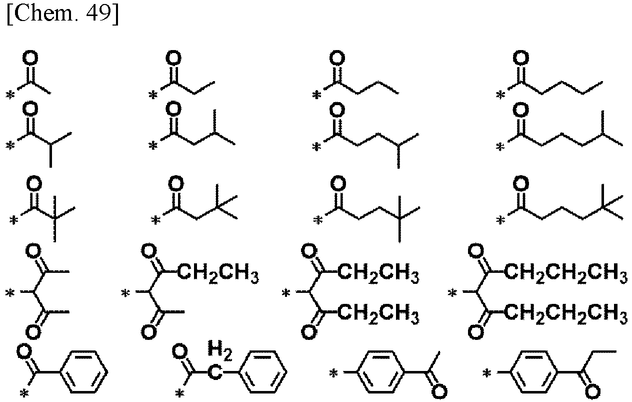

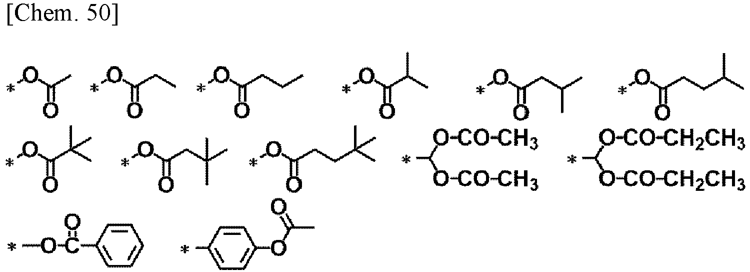

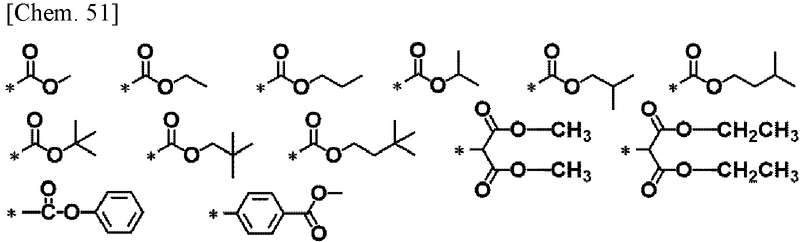

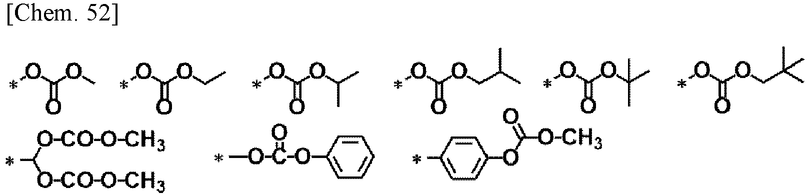

The hydrocarbon groups having 1 to 12 carbon atoms represented by R^{d1} to R^{d3} may have a substituent.

Examples of the substituents of the hydrocarbon groups having 1 to 12 carbon atoms represented by R^{d1} to R^{d3} include a heterocyclic group optionally having a substituent, a halogen atom, a nitro group, a cyano group, -OR^{xa1}, -CO₂R^{xa1}, -SR^{xa1}, -SO₂R^{xa1}, -SO₃R^{xa1}, - SO₂NR^{xa1}R^{xa2}, -NR^{xa1}R^{xa2}, etc. (note that R^{xa1} and R^{xa2} are the same as above).

The heterocyclic group used as each of the substituents of the hydrocarbon groups having 1 to 12 carbon atoms represented by R^{d1} to R^{d3} may be a monocyclic or polycyclic ring, and is preferably a heterocyclic ring containing a heteroatom as a ring component. Examples of the heteroatom include a nitrogen atom, an oxygen atom, a sulfur atom, etc.

Examples of the heterocyclic ring include the same heterocyclic groups as those used as the substituents of the unsaturated hydrocarbon groups having 2 to 20 carbon atoms represented by R^{x1} and R^{x3}.

The number of carbon atoms of the heterocyclic group is preferably 2 to 30, more preferably 3 to 22, and further preferably 3 to 20.

The heterocyclic group may have a substituent, and examples of the substituent include a halogen atom, a nitro group, a cyano group, -OR^{xa1}, -CO₂R^{xa1}, -SR^{xa1}, -SO₂R^{xa1}, -SO₃R^{xa1}, - SO₂NR^{xa1}R^{xa2}, -NR^{xa1}R^{xa2}, etc. (note that R^{xa1} and R^{xa2} are the same as above).

The bonding position of the heterocyclic ring is a portion from which any hydrogen atom contained in each ring is removed.

Examples of the halogen atom used as each of the substituents of the hydrocarbon groups having 1 to 12 carbon atoms represented by R^{d1} to R^{d3} include a fluorine atom, a chlorine atom, a bromine atom, an iodine atom, etc.

The substituents of the hydrocarbon groups having 1 to 12 carbon atoms represented by R^{d1} to R^{d3} are each preferably -OR^{xa1} (R^{xa1} is preferably a hydrogen atom or a saturated chain hydrocarbon group having 1 to 15 carbon atoms, more preferably a hydrogen atom or a straight-chain alkyl group or branched-chain alkyl group having 1 to 10 carbon atoms, further preferably a hydrogen atom, a methyl group, an ethyl group, a propyl group, an isopropyl group, or a t-butyl group, and even more preferably a hydrogen atom), and -CO₂R^{xa1} (R^{xa1} is preferably a hydrogen atom or a saturated chain hydrocarbon group having 1 to 15 carbon atoms, more preferably a hydrogen atom or a straight-chain alkyl group or branched-chain alkyl group having 1 to 10 carbon atoms, further preferably a hydrogen atom, a methyl group, an ethyl group, a propyl group, an isopropyl group, or a t-butyl group, and even more preferably a hydrogen atom).

When R^{d2} and R^{d3} are combined to form a ring together with -CO-NR^{d1}-CO-, examples of the formed ring include the following rings. In formula (r-1) to formula (r-7), * represents a bond with R^{d1}.

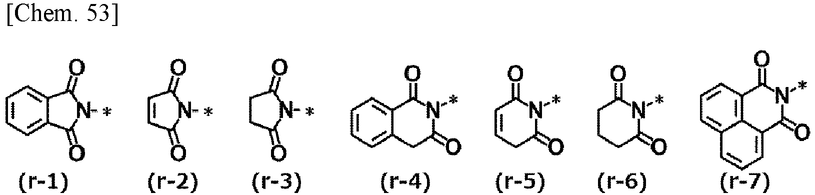

In formula (DA),
R^{d1} is
preferably a saturated aliphatic hydrocarbon group having 1 to 12 carbon atoms and having -CO₂R^{xa1} (R^{xa1} is preferably a hydrogen atom or a saturated chain hydrocarbon group having 1 to 15 carbon atoms, more preferably a hydrogen atom or a straight-chain alkyl group or branched-chain alkyl group having 1 to 10 carbon atoms, further preferably a hydrogen atom, a methyl group, an ethyl group, a propyl group, an isopropyl group, or a t-butyl group, and even more preferably a hydrogen atom) as a substituent,
more preferably a saturated chain hydrocarbon group having 1 to 12 carbon atoms and having -CO₂R^{xa1} (R^{xa1} is preferably a hydrogen atom or a saturated chain hydrocarbon group having 1 to 15 carbon atoms, more preferably a hydrogen atom or a straight-chain alkyl group or branched-chain alkyl group having 1 to 10 carbon atoms, further preferably a hydrogen atom, a methyl group, an ethyl group, a propyl group, an isopropyl group, or a t-butyl group, and even more preferably a hydrogen atom) as a substituent,
further preferably a saturated chain hydrocarbon group having 1 to 5 carbon atoms and having -CO₂R^{xa1} (R^{xa1} is preferably a hydrogen atom or a saturated chain hydrocarbon group having 1 to 10 carbon atoms, more preferably a hydrogen atom or a straight-chain alkyl group or branched-chain alkyl group having 1 to 8 carbon atoms, further preferably a hydrogen atom, a methyl group, an ethyl group, a propyl group, an isopropyl group, or a t-butyl group, and even more preferably a hydrogen atom) as a substituent,
even more preferably a straight-chain alkyl group having 1 to 5 carbon atoms and having -CO₂R^{xa1} (R^{xa1} is preferably a hydrogen atom or a saturated chain hydrocarbon group having 1 to 5 carbon atoms, more preferably a hydrogen atom or a straight-chain alkyl group or branched-chain alkyl group having 1 to 4 carbon atoms, further preferably a hydrogen atom, a methyl group, an ethyl group, a propyl group, an isopropyl group, or a t-butyl group, and even more preferably a hydrogen atom) as a substituent, and
particularly preferably a methyl group, an ethyl group, a propyl group, a butyl group, or a pentyl group having -CO₂R^{xa1} (R^{xa1} is preferably a hydrogen atom, a methyl group, an ethyl group, a propyl group, an isopropyl group, or a t-butyl group, and more preferably a hydrogen atom) as a substituent.

As for R^{d2} and R^{d3},
preferably, R^{d2} and R^{d3} are combined to form a ring together with -CO-NR^{d1}-CO-, and
more preferably, R^{d2} and R^{d3} are combined to form a ring represented by formula (r-1) or formula (r-2) together with -CO-NR^{d1}-CO-.

Specific examples of the compound represented by formula (DA) include compounds represented by formula (da-1) to formula (da-10).

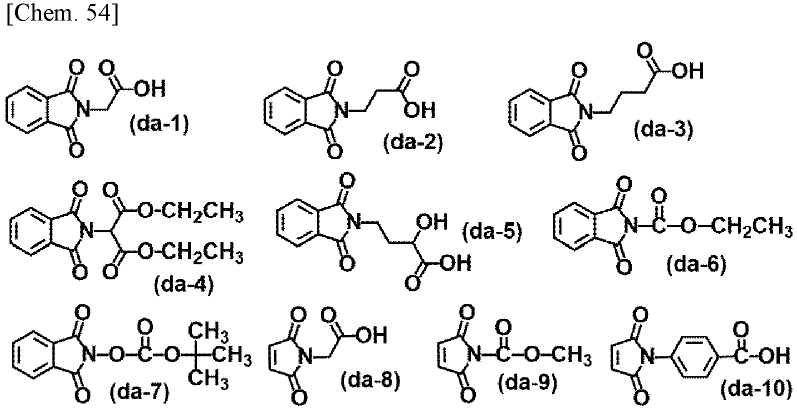

As the compound represented by formula (DA), the compounds represented by formula (da-1), formula (da-2), formula (da-4), formula (da-5), formula (da-6), formula (da-9), and formula (da-10) are preferable, and
the compounds represented by formula (da-1) and formula (da-2) are more preferable.

The colored resin composition of the present invention contains one or more compounds represented by formula (DA). That is, the compounds represented by formula (DA) may be used alone, or a plurality of compounds having different structures among the compounds represented by formula (DA) may be used in combination.

When the colored resin composition contains two or more compounds represented by formula (DA), as the compounds represented by formula (DA),
a compound which is represented by formula (DA) and in which R^{d2} and R^{d3} are combined to form a ring represented by formula (r-1) or formula (r-2) together with -CO-NR^{d1}-CO- is preferably contained,
at least two or more compounds selected from the group consisting of the compounds represented by formula (da-1) to formula (da-10) are more preferably contained,
at least two or more compounds selected from the group consisting of the compounds represented by formula (da-1), formula (da-2), formula (da-4), formula (da-5), formula (da-6), formula (da-9), and formula (da-10) are further preferably contained, and
the compounds represented by formula (da-1) and formula (da-2) are particularly preferably contained.

When the colored resin composition contains two or more compounds represented by formula (DA), the two or more compounds represented by formula (DA) may be contained in equal amounts or in different amounts. When the two or more compounds represented by formula (DA) are contained in different amounts, the content ratio between the smallest amount and the largest amount in the colored resin composition is preferably 1:1.1 to 1:10, more preferably 1:1.5 to 1:8, and further preferably 1:2 to 1:8, in mole ratio.

The amount of the compound represented by formula (DA) (total amount of the two or more compounds represented by formula (DA)) is preferably 1 to 180 parts by mass, more preferably 5 to 170 parts by mass, further preferably 10 to 160 parts by mass, even more preferably 15 to 160 parts by mass, even further preferably 25 to 150 parts by mass, and particularly preferably 45 to 140 parts by mass, relative to 100 parts by mass of the aluminum phthalocyanine pigment. When the amount of the compound represented by formula (DA) is within the above range, a colored coating film in which generation of foreign matter is suppressed and which has good adhesion to a substrate is formed.

The content of the compound represented by formula (DA) (total content of the two or more compounds represented by formula (DA)) in the colored resin composition is preferably 0.1 to 30% by mass, more preferably 2.0 to 25% by mass, further preferably 3.5 to 20% by mass, and even more preferably 6.0 to 20% by mass, with respect to the total solid content. When the content of the compound represented by formula (DA) is within the above range, a colored coating film in which generation of foreign matter is suppressed and which has good adhesion to a substrate is formed.

### <Dispersant>

The colored resin composition of the present invention may contain a dispersant. Examples of the dispersant include surfactants such as a cationic surfactant, an anionic surfactant, a non-ionic surfactant, and an amphoteric surfactant. Specific examples thereof include surfactants such as a polyester-based surfactant, a polyamine-based surfactant, and an acrylic surfactant. These pigment dispersants may be used singly or in combination of two or more thereof. Examples in trade names of the dispersant include KP (manufactured by Shin-Etsu Chemical Co., Ltd.), Flowlen (manufactured by Kyoeisha Chemical Co., Ltd.), Solsperse (registered trademark) (manufactured by Zeneca Ltd.), EFKA (registered trademark) (manufactured by BASF Corporation), AJISPER (registered trademark) (manufactured by Ajinomoto Fine-Techno Co., Inc.), Disperbyk (registered trademark) (manufactured by BYK-Chemie Corporation), and BYK (registered trademark) (manufactured by BYK-Chemie Corporation).

The amount of the dispersant is preferably 1 to 150 parts by mass, more preferably 10 to 130 parts by mass, further preferably 20 to 120 parts by mass, and further more preferably 30 to 110 parts by mass, relative to 100 parts by mass of the aluminum phthalocyanine pigment.

The amount of the dispersant is preferably 1 to 300 parts by mass, more preferably 10 to 150 parts by mass, even more preferably 15 to 85 parts by mass, and even more preferably 20 to 75 parts by mass relative to 100 parts by mass of the compound represented by formula (DA). When the amount of the dispersant is within this range, a colored coating film in which the generation of foreign matter is suppressed and adhesion to the substrate is good is formed.

### <Resin (B)>

The resin (B) is not particularly limited, and is preferably an alkali soluble resin. Examples of the resin (B) include the following resins [K1] to [K6].
Resin [K1]; a copolymer having a structural unit derived from at least one monomer (a) selected from the group consisting of an unsaturated carboxylic acid and an unsaturated carboxylic anhydride (hereinafter, the monomer (a) is sometimes referred to as "(a)") and a structural unit derived from a monomer (b) having a cyclic ether structure having 2 to 4 carbon atoms and an ethylenically unsaturated bond (hereinafter, monomer (b) is sometimes referred to as "(b)");
Resin [K2]; a copolymer having a structural unit derived from (a), a structural unit derived from (b), and a structural unit derived from a monomer (c) copolymerizable with (a) (It is noted that the (c) is different from the (a) and the (b)) (hereinafter, the monomer (c) is sometimes referred to as "(c)");
Resin [K3]; a copolymer having a structural unit derived from (a) and a structural unit derived from (c);
Resin [K4]; a copolymer having a structural unit produced by adding (b) to a copolymer having a structural unit derived from (a) and a structural unit derived from (c);
Resin [K5]; a copolymer having a structural unit produced by adding (a) to a copolymer having a structural unit derived from (b) and a structural unit derived from (c); and
Resin [K6]; a copolymer having a structural unit produced by adding (a) to a copolymer having a structural unit derived from (b) and a structural unit derived from (c) and further adding a polycarboxylic acid and/or a carboxylic anhydride thereto.

Specific examples of (a) include unsaturated monocarboxylic acids such as acrylic acid, methacrylic acid, crotonic acid, and o-, m- or p-vinylbenzoic acid;
unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid, and 1,4-cyclohexenedicarboxylic acid;
carboxy group-containing bicyclo unsaturated compounds such as methyl-5-norbomene-2,3-dicarboxylic acid, 5-carboxybicyclo[2.2.1]hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene, and 5-carboxy-6-ethylbicyclo[2.2.1]hept-2-ene;
unsaturated dicarboxylic anhydrides such as maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride;
unsaturated mono[(meth)acryloyloxyalkyl]esters of a polyvalent carboxylic acid having a valence of 2 or more such as succinic acid mono[2-(meth)acryloyloxyethyl], and phthalic acid mono[2-(meth)acryloyloxyethyl]; and
unsaturated acrylates containing a hydroxy group and a carboxy group in its molecule such as α-(hydroxymethyl)acrylic acid.

Among these, from the viewpoint of copolymerization reactivity and solubility of obtained resin to an alkaline aqueous solution, acrylic acid, methacrylic acid, maleic anhydride and the like are preferable.
(b) means a polymerizable compound having a C2-C4 cyclic ether structure (for example, at least one selected from the group consisting of an oxirane ring, an oxetane ring, and a tetrahydrofuran ring) and an ethylenically unsaturated bond. (b) is preferably a monomer having a C2-C4 cyclic ether and a (meth)acryloyloxy group.

As used herein, "(meth)acrylic acid" represents at least one selected from the group consisting of acrylic acid and methacrylic acid. The terms "(meth)acryloyl", "(meth)acrylate" and the like also have similar meanings.

Examples of (b) include a monomer (b 1) having an oxiranyl group and an ethylenically unsaturated bond (hereinafter, the monomer (b1) is sometimes referred to as "(b1)"), a monomer (b2) having an oxetanyl group and an ethylenically unsaturated bond (hereinafter, the monomer (b2) is sometimes referred to as "(b2)"), and a monomer (b3) having a tetrahydrofuryl group and an ethylenically unsaturated bond (hereinafter, the monomer (b3) is sometimes referred to as "(b3)").

Examples of (b 1) include a monomer (b 1-1) having a structure where a straight- or branched-chain aliphatic unsaturated hydrocarbon is epoxidized (hereinafter, the monomer (b1-1) is sometimes referred to as "(b1-1)") and a monomer (b1-2) having a structure where an alicyclic unsaturated hydrocarbon is epoxidized (hereinafter, the monomer (b 1-2) is sometimes referred to as "(b1-2)").

Examples of (b 1-1) include glycidyl(meth)acrylate, β-methylglycidyl(meth)acrylate, β-ethylglycidyl(meth)acrylate, glycidyl vinyl ether, o-vinylbenzyl glycidyl ether, m-vinylbenzyl glycidyl ether, p-vinylbenzyl glycidyl ether, α-methyl-o-vinylbenzyl glycidyl ether, α-methyl-m-vinylbenzyl glycidyl ether, α-methyl-p-vinylbenzyl glycidyl ether, 2,3-bis(glycidyloxymethyl)styrene, 2,4-bis(glycidyloxymethyl)styrene, 2,5-bis(glycidyloxymethyl)styrene, 2,6-bis(glycidyloxymethyl)styrene, 2,3,4-tris(glycidyloxymethyl)styrene, 2,3,5-tris(glycidyloxymethyl)styrene, 2,3,6-tris(glycidyloxymethyl)styrene, 3,4,5-tris(glycidyloxymethyl)styrene, and 2,4,6-tris(glycidyloxymethyl)styrene.

Examples of (b1-2) include vinylcyclohexene monoxide, 1,2-epoxy-4-vinylcyclohexane (for example, Celloxide 2000 manufactured by Daicel Corporation), 3,4-epoxycyclohexylmethyl(meth)acrylate (for example, Cyclomer A400 manufactured by Daicel Corporation), 3,4-epoxycyclohexylmethyl(meth)acrylate (for example, Cyclomer M100 manufactured by Daicel Corporation), 3,4-epoxytricyclo[5.2.1.02,6]decyl(meth)acrylate, a compound represented by formula (R1) and a compound represented by formula (R2).

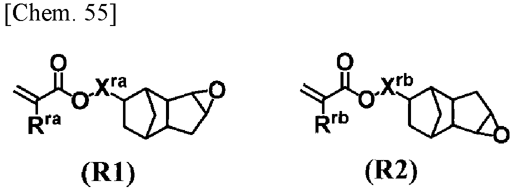

[In formula (R1) and formula (R2), R^{ra} and R^{rb} each represent a hydrogen atom or an alkyl group having 1 to 4 carbon atoms, and a hydrogen atom included in the alkyl group may be substituted with a hydroxy group.
X^{ra} and X^{rb} each represent a single bond, ^{∗}-R^{rc}-, ^{∗}-R^{rc}-O-, ^{∗}-R^{rc}-S-, or ^{∗}-R^{rc}-NH-.
R^{rc} represents an alkanediyl group having 1 to 6 carbon atoms.
^{∗} represents a bond with O.]

Examples of the alkyl group having 1 to 4 carbon atoms include a methyl group, an ethyl group, an n-propyl group, an isopropyl group, an n-butyl group, a sec-butyl group, a tert-butyl group, etc.

Examples of the alkyl group in which a hydrogen atom is substituted with hydroxy include a hydroxymethyl group, a 1-hydroxyethyl group, a 2-hydroxyethyl group, a 1-hydroxypropyl group, a 2-hydroxypropyl group, a 3-hydroxypropyl group, a 1-hydroxy-1-methylethyl group, a 2-hydroxy-1-methylethyl group, a 1-hydroxybutyl group, a 2-hydroxybutyl group, a 3-hydroxybutyl group, a 4-hydroxybutyl group, etc.

Preferable examples of R^{ra} and R^{rb} include a hydrogen atom, a methyl group, a hydroxymethyl group, a 1-hydroxyethyl group, and a 2-hydroxyethyl group, and more preferable examples of R^{ra} and R^{rb} include a hydrogen atom and a methyl group.

Examples of the alkanediyl group include a methylene group, an ethylene group, a propane-1,2-diyl group, a propane-1,3-diyl group, a butane-1,4-diyl group, a pentane-1,5-diyl group, a hexane-1,6-diyl group, etc.

Preferable examples of X^{ra} and X^{rb} include a single bond, a methylene group, an ethylene group, ^{∗}-CH₂-O-, and ^{∗}-CH₂CH₂-O-, and more preferable examples of X^{ra} and X^{rb} include a single bond and ^{∗}-CH₂CH₂-O- (^{∗} represents a bond with O).

Examples of the compound represented by formula (R1) include compounds represented by any of formula (R1-1) to formula (R1-15), etc. Among them, the compounds represented by formula (R1-1), formula (R1-3), formula (R1-5), formula (R1-7), formula (R1-9), or formula (R1-11) to formula (R1-15) are preferable, and the compound represented by formula (R1-1), formula (R1-7), formula (R1-9), or formula (R1-15) is more preferable.

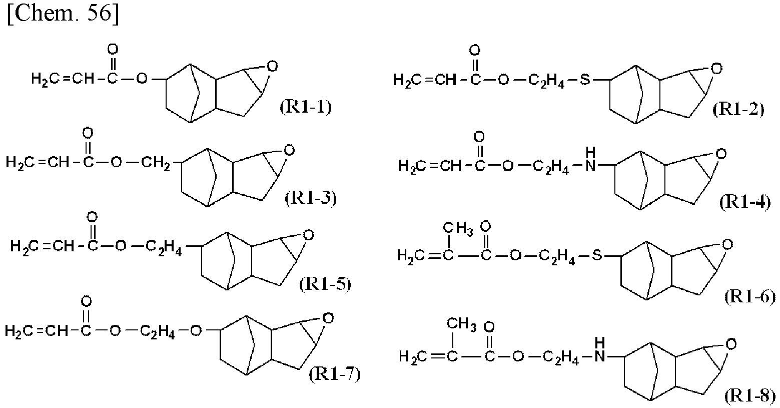

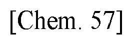

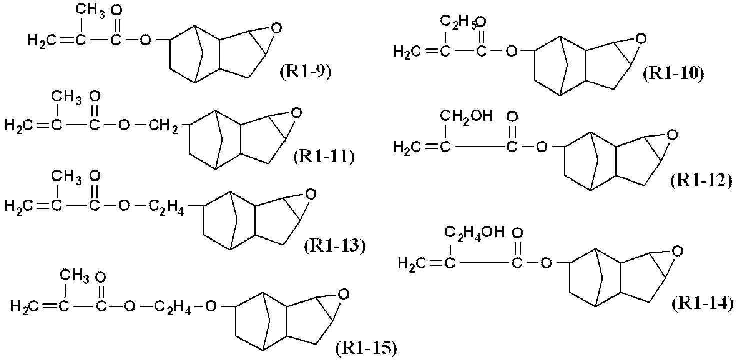

Examples of the compound represented by formula (R2) include compounds represented by any of formula (R2-1) to formula (R2-15), etc. Among them, the compounds represented by formula (R2-1), formula (R2-3), formula (R2-5), formula (R2-7), formula (R2-9), or formula (R2-11) to formula (R2-15) are preferable, and the compound represented by formula (R2-1), formula (R2-7), formula (R2-9), or formula (R2-15) is more preferable. 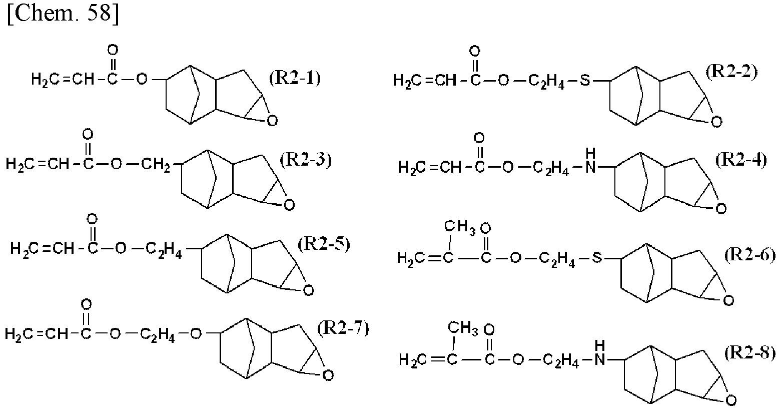 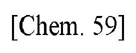 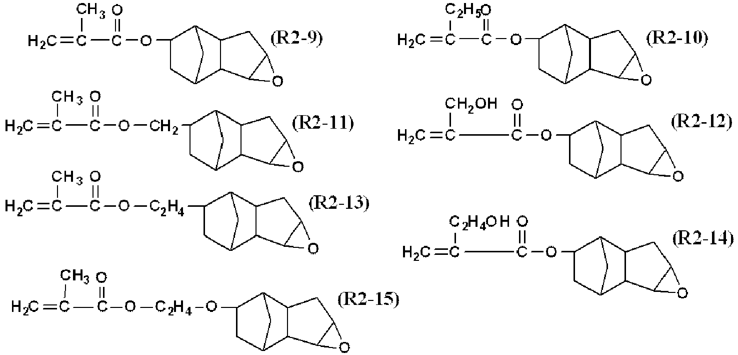
(b2) is more preferably a monomer having an oxetanyl group and a (meth)acryloyloxy group. Examples of (b2) include 3-methyl-3-methacryloyloxy methyl oxetane, 3-methyl-3-acryloyloxy methyl oxetane, 3-ethyl-3-methacryloyloxy methyl oxetane, 3-ethyl-3-acryloyloxy methyl oxetane, 3-methyl-3-methacryloyloxy ethyl oxetane, 3-methyl-3-acryloyloxy ethyl oxetane, 3-ethyl-3-methacryloyloxy ethyl oxetane, and 3-ethyl-3-acryloyloxy ethyl oxetane.
(b3) is more preferably a monomer having a tetrahydrofuryl group and a (meth)acryloyloxy group. Specific examples of (b3) include tetrahydrofurfuryl acrylate (for example, Viscoat V#150 manufactured by Osaka Organic Chemical Industry Ltd.) and tetrahydrofurfuryl methacrylate.
(b) is preferably (b1) since reliabilities such as heat resistance and chemical resistance of a color filter to be produced can be further improved, and more preferably (b1-2) since the storage stability of the colored resin composition is excellent.

Examples of (c) include
(meth)acrylic esters such as methyl(meth)acrylate, ethyl(meth)acrylate, n-butyl(meth)acrylate, sec-butyl(meth)acrylate, tert-butyl(meth)acrylate, 2-ethylhexyl(meth)acrylate, dodecyl(meth)acrylate, lauryl(meth)acrylate, stearyl(meth)acrylate, cyclopentyl(meth)acrylate, cyclohexyl(meth)acrylate, 2-methylcyclohexyl(meth)acrylate, tricyclo[5.2.1.0^{2,6}]decan-8-yl(meth)acrylate (which is referred to as "dicyclopentanyl(meth)acrylate" (common name) in the art or sometimes referred to as "tricyclodecyl(meth)acrylate"), tricyclo [5.2.1.0^{2,6}]decene-8-yl (meth)acrylate (which is referred to as "dicyclopentenyl(meth)acrylate" (common name) in the art), dicyclopentanyloxyethyl(meth)acrylate, isobornyl(meth)acrylate, adamantyl(meth)acrylate, allyl(meth)acrylate, propargyl(meth)acrylate, phenyl(meth)acrylate, naphthyl(meth)acrylate, and benzyl(meth)acrylate;
hydroxy group-containing (meth)acrylic esters such as 2-hydroxyethyl(meth)acrylate and 2-hydroxypropyl(meth)acrylate;
dicarboxylic diesters such as diethyl maleate, diethyl fumarate, and diethyl itaconate;
bicyclo unsaturated compounds such as bicyclo[2.2.1]hept-2-ene, 5-methylbicyclo[2.2.1]hept-2-ene, 5-ethylbicyclo[2.2.1]hept-2-ene, 5-hydroxybicyclo[2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo[2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo[2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene, and 5,6-bis(cyclohexyloxycarbonyl)bicyclo[2.2.1]hept-2-ene;
dicarbonylimide derivatives such as N-phenylmaleimide, N-cyclohexylmaleimide, N-benzylmaleimide, N-succinimidyl-3-maleimidobenzoate, N-succinimidyl-4-maleimidobutyrate, N-succinimidyl-6-maleimide caproate, N-succinimidyl-3-maleimide propionate, and N-(9-acridinyl)maleimide;
styrene, α-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene, and 2,3-dimethyl-1,3-butadiene.

Among these, from the viewpoint of copolymerization reactivity and heat resistance, styrene, vinyltoluene, N-phenylmaleimide, N-cyclohexylmaleimide, N-benzylmaleimide, bicyclo[2.2.1]hept-2-ene, and the like are preferable.

The ratio of the structural unit derived from each of (a) and (b) in the total structural units constituting the resin [K1] is preferably the following:
the structural unit derived from (a): 2 to 60 mol%; and
the structural unit derived from (b): 40 to 98 mol%,
and more preferably the following:
the structural unit derived from (a): 10 to 50 mol%; and
the structural unit derived from (b): 50 to 90 mol%.

When the ratio of the structural unit of the resin [K1] falls within the above-mentioned range, there is a tendency that the storage stability of the colored resin composition, the developability thereof during the formation of a colored pattern, and the solvent resistance of a color filter to be produced are excellent.

The resin [K1] can be produced with reference to the method described in, for example, a document "Experimental Method for Polymer Synthesis" (edited by Takayuki Otsu, published by Kagaku-Dojin Publishing Co., Ltd., First Edition, First Printed on March 1, 1972) and cited documents described in the document.

Specific examples the producing method of the resin [K1] include the following method: predetermined amounts of (a) and (b), a polymerization initiator, a solvent, and the like are placed in a reaction vessel, a deoxidization atmosphere is formed by, for example, substituting oxygen with nitrogen, and these are heated and kept warm during stirring. The polymerization initiator, the solvent, and the like used here are not particularly limited, and those commonly used in the art can be used. Examples of the polymerization initiator include azo compounds such as 2,2'-azobisisobutyronitrile and 2,2'-azobis(2,4-dimethylvaleronitrile, and organic peroxides such as benzoyl peroxide. The solvent is required to dissolve each monomer. Examples of the solvent include solvents described later as the solvent (E).

The obtained copolymer may be used directly in the form of a solution after reaction. Alternatively, a solution obtained by concentrating or diluting the solution after reaction may be used, or a solid (powder) taken out from the solution after reaction by a method such as reprecipitation may be used. In particular, the solution after reaction can be used directly in the preparation of the colored resin composition by using a solvent contained in the colored resin composition as the solvent for the polymerization, whereby the producing process of the colored resin composition can be simplified.

The ratio of the structural unit derived from each of (a) to (c) in the total structural units constituting the resin [K2] is preferably the following:
the structural unit derived from (a): 2 to 45 mol%;
the structural unit derived from (b): 2 to 95 mol%; and
the structural unit derived from (c): 1 to 65 mol%,
and more preferably the following:
the structural unit derived from (a): 5 to 40 mol%;
the structural unit derived from (b): 5 to 80 mol%; and
the structural unit derived from (c): 5 to 60 mol%.

When the ratio of the structural unit of the resin [K2] falls within the above-mentioned range, there is a tendency that the storage stability of the colored resin composition, the developability thereof during the formation of a colored pattern, and solvent resistance, heat resistance, and mechanical strength of a color filter to be produced are excellent.

The resin [K2] can be produced in a similar manner to the producing method of the resin [K1], for example.

The ratio of the structural unit derived from each of (a) and (c) in the total structural units constituting the resin [K3] is preferably the following:
the structural unit derived from (a): 2 to 60 mol%; and
the structural unit derived from (c): 40 to 98 mol%,
and more preferably the following:
the structural unit derived from (a): 10 to 50 mol%; and
the structural unit derived from (c): 50 to 90 mol%.

The resin [K3] can be produced in a similar manner to the producing method of the resin [K1], for example.

The resin [K4] can be produced by producing a copolymer of (a) and (c) and then adding a C2-C4 cyclic ether contained in (b) to a carboxylic acid and/or a carboxylic anhydride contained in (a).

First, the copolymer of (a) and (c) is produced in a similar manner to the producing method of the resin [K1]. In this case, the ratio of the structural unit derived from each of (a) and (c) is preferably the same ratio as that described in the resin [K3].

Next, a C2-C4 cyclic ether contained in (b) is reacted with a part of the carboxylic acid and/or the carboxylic anhydride derived from (a) in the copolymer.

Subsequent to the production of the copolymer of (a) and (c), atmosphere in the flask is replaced from a nitrogen to air, and (b), a reaction catalyst for a carboxylic acid or a carboxylic anhydride and a cyclic ether (for example, tris(dimethylaminomethyl)phenol), and a polymerization inhibitor (for example, hydroquinone) are placed in the flask, followed by reacting, for example, at 60 to 130°C for 1 to 10 hours, whereby the resin [K4] can be produced.

The amount of (b) used is preferably 5 to 80 mol, and more preferably 10 to 75 mol, relative to 100 mol of (a). When the amount of (b) used falls within the above-mentioned range, there is a tendency that the storage stability of the colored resin composition, the developability thereof during the formation of a pattern, and the balance of solvent resistance, heat resistance, mechanical strength, and sensitivity of the pattern obtained are good. Since the reactivity of the cyclic ether is high, and the unreacted (b) is less likely to remain, (b) used for the resin [K4] is preferably (b 1), and more preferably (b 1-1).

The amount of the reaction catalyst used is preferably 0.001 to 5 parts by mass relative to 100 parts by mass of the total amount of (a), (b), and (c). The amount of the polymerization inhibitor used is preferably 0.001 to 5 parts by mass relative to 100 parts by mass of the total amount of (a), (b), and (c).

Reaction conditions such as a feeding method, a reaction temperature, and time can be appropriately adjusted in consideration of a production equipment, an amount of heat generation due to polymerization, and the like. In consideration of the production equipment, the amount of heat generation due to polymerization, and the like, the feeding method and the reaction temperature can be appropriately adjusted like the polymerization conditions.

A producing method of the resin [K5] contains a step of producing a copolymer of (b) and (c) in a similar manner to the producing method of the resin [K1] as a first step. In the same manner as in the above, the obtained copolymer may be used directly in the form of a solution after reaction. Alternatively, a solution obtained by concentrating or diluting the solution after reaction may be used, or a solid (powder) taken out from the solution after reaction by a method such as reprecipitation may be used. The ratio of the structural unit derived from each of (b) and (c) relative to the total number of moles of the total structural units constituting the copolymer is preferably the following:
the structural unit derived from (b): 5 to 95 mol%; and
the structural unit derived from (c): 5 to 95 mol%,
and more preferably the following:
the structural unit derived from (b): 10 to 90 mol%; and
the structural unit derived from (c): 10 to 90 mol%.

The producing method of the resin [K5] further contains a step of reacting a carboxylic acid or a carboxylic anhydride contained in (a) with the cyclic ether derived from (b) contained in the copolymer of (b) and (c) under the same conditions as those of the producing method of the resin [K4], whereby the resin [K5] can be produced.

The amount of (a) used that is reacted with the copolymer is preferably 5 to 80 mol relative to 100 mol of (b). Since the reactivity of the cyclic ether is high, and the unreacted (b) is less likely to remain, (b) used for the resin [K5] is preferably (b1), and more preferably (b1-1).

The resin [K6] is a resin produced by further reacting a carboxylic anhydride with the resin [K5]. The carboxylic anhydride is reacted with a hydroxy group generated by the reaction between the cyclic ether and the carboxylic acid or a carboxylic anhydride.

Examples of the carboxylic anhydride include maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride. The amount of the carboxylic anhydride used is preferably 0.5 to 1 mol relative to 1 mol of the amount of (a) used.

Specific examples of the resin (B) include a resin [K1] such as a 3,4-epoxycyclohexylmethyl(meth)acrylate/(meth)acrylic acid copolymer or a 3,4-epoxytricyclo[5.2.1.0^{2,6}]decyl acrylate/(meth)acrylic acid copolymer; a resin [K2] such as a 3,4-epoxytricyclo[5.2.1.0^{2,6}]decyl acrylate/benzyl(meth)acrylate/(meth)acrylic acid copolymer, a glycidyl(meth)acrylate/benzyl(meth)acrylate/(meth)acrylic acid copolymer, a glycidyl(meth)acrylate/styrene/(meth)acrylic acid copolymer, a 3,4-epoxytricyclo[5.2.1.0^{2,6}]decyl acrylate/(meth)acrylic acid/N-cyclohexylmaleimide copolymer, a 3,4-epoxytricyclo[5.2.1.0^{2,6}]decyl acrylate/(meth)acrylic acid/N-cyclohexylmaleimide/2-hydroxyethyl(meth)acrylate copolymer, or a 3-methyl-3-(meth)acryloyloxymethyl oxetane/(meth)acrylic acid/styrene copolymer; a resin [K3] such as a benzyl(meth)acrylate/(meth)acrylic acid copolymer or a styrene/(meth)acrylic acid copolymer; a resin [K4] such as a resin produced by adding glycidyl(meth)acrylate to a benzyl(meth)acrylate/(meth)acrylic acid copolymer, a resin produced by adding glycidyl(meth)acrylate to a tricyclodecyl(meth)acrylate/styrene/(meth)acrylic acid copolymer, or a resin produced by adding glycidyl(meth)acrylate to a tricyclodecyl(meth)acrylate/benzyl(meth)acrylate/(meth)acrylic acid copolymer; a resin [K5] such as a resin produced by reacting a tricyclodecyl(meth)acrylate/glycidyl(meth)acrylate copolymer with (meth)acrylic acid, or a resin produced by reacting a tricyclodecyl(meth)acrylate/styrene/glycidyl(meth)acrylate copolymer with (meth)acrylic acid; and a resin [K6] such as a resin produced by reacting a tricyclodecyl(meth)acrylate/glycidyl(meth)acrylate copolymer with (meth)acrylic acid to produce a resin and then reacting this resin with a tetrahydrophthalic anhydride.

Among these, the resin (B) is preferably the resin [K1] and the resin [K2].

The resin (B) is preferably a copolymer having a structural unit derived from at least one selected from the group consisting of an unsaturated carboxylic acid and an unsaturated carboxylic anhydride and a structural unit having a cyclic ether structure having 2 to 4 carbon atoms and an ethylenically unsaturated bond (the resin [K1] or the resin [K2]), and more preferably the resin [K2].

The weight average molecular weight of the resin (B) in terms of polystyrene is preferably 500 to 100,000, more preferably 600 to 50,000, and further preferably 700 to 30,000. When the molecular weight falls within the above-mentioned range, there is a tendency that the hardness of the color filter is improved, that the residual film ratio is increased, that the solubility of an unexposed area by a developing solution becomes good, and that the resolution of a colored pattern is improved.

The degree of dispersion [weight average molecular weight (Mw)/number average molecular weight (Mn)] of the resin (B) is preferably 1.1 to 6, and more preferably 1.2 to 4.

The acid value of the resin (B) is preferably 50 to 170 mg-KOH/g, more preferably 60 to 150 mg-KOH/g, and further preferably 70 to 135 mg-KOH/g, in terms of solid content. The acid value is a value which is measured as an amount (mg) of potassium hydroxide required for neutralizing 1 g of the resin (B), and which can be determined by, for example, titration with an aqueous potassium hydroxide solution.

The content of the resin (B) is preferably 7 to 80% by mass, more preferably 13 to 75% by mass, further preferably 17 to 70% by mass, and further more preferably 17 to 55% by mass, relative to the whole amount of the solid content. When the content of the resin (B) falls within the above-mentioned range, there is a tendency that the colored pattern can be formed, and that the resolution of the colored pattern and the residual film ratio are improved.

### <Polymerizable Compound (C)>

The polymerizable compound (C) is a compound capable of being polymerized by the action of an active radical and/or an acid generated from the polymerization initiator (D). Examples of the polymerizable compound (C) include a compound having a polymerizable ethylenically unsaturated bond, and a (meth)acrylic acid ester compound is preferable.

Among these, the polymerizable compound (C) is preferably a polymerizable compound having three or more ethylenically unsaturated bonds. Examples of such a polymerizable compound include trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone-modified pentaerythritol tetra(meth)acrylate, and caprolactone-modified dipentaerythritol hexa(meth)acrylate.

Among these, the polymerizable compound (C) is preferably trimethylolpropane tri(meth)acrylate, dipentaerythritol penta(meth)acrylate, and dipentaerythritol hexa(meth)acrylate.

The weight average molecular weight of the polymerizable compound (C) is preferably 150 or more and 2,900 or less, and more preferably 250 or more and 1,500 or less.

The content of the polymerizable compound (C) is preferably 7 to 65% by mass, more preferably 13 to 60% by mass, and further preferably 17 to 55% by mass, relative to the whole amount of the solid content. When the content of the polymerizable compound (C) falls within the above-mentioned range, there is a tendency that the residual film ratio during the formation of the colored pattern and the chemical resistance of the color filter are improved.

### <Polymerization Initiator (D)>

The polymerization initiator (D) is not particularly limited, as long as the polymerization initiator (D) is a compound capable of generating active radicals, an acid or the like by the action of light or heat to initiate polymerization. Any known polymerization initiator can be used.

Examples of the polymerization initiator capable of generating active radicals include an alkylphenone compound, a triazine compound, an acylphosphine oxide compound, an O-acyloxime compound, and a biimidazole compound.

The O-acyloxime compound is a compound having a partial structure represented by formula (d1). Hereinafter, * represents a point of attachment.

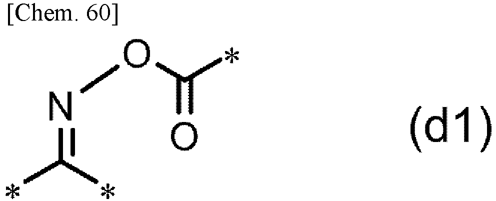

Examples of O-acyloxime compounds include N-benzoyloxy-1-(4-phenylsulfanylphenyl)butan-1 -one-2-imine, N-benzoyloxy-1-(4-phenylsulfanylphenyl)octane-1-one-2-imine, N-benzoyloxy-1-(4-phenylsulfanylphenyl)-3-cyclopentylpropan-1-one-2-imine, N acetoxy-1-[9-ethyl-6-(2-methylbenzoyl)-9H-carbazol-3-yl]ethane-1-imine, N-acetoxy-1-[9-ethyl-6-{2-methyl-4-(3,3-dimethyl-2,4-dioxacyclopentanylmethyloxy)benzoyl}-9H-carbazole-3-yl]ethane-1-imine, N-acetoxy-1-[9-ethyl-6-(2-methylbenzoyl)-9H-carbazole-3-yl]-3-cyclopentylpropane-1-imine, N-benzoyloxy-1-[9-ethyl-6-(2-methylbenzoyl)-9H-carbazole-3-yl]-3-cyclopentylpropane-1-one-2-imine, N-acetyloxy-1-[4-(2-hydroxyethyloxy)phenylsulfanylphenyl]propan-1-one-2-imine, N-acetyloxy-1-(4-phenylsulfanylphenyl)-3-cyclohexylpropan-1-one-2-imine, 2-[(acetyloxy)imino]-3-cyclohexyl-1-[4-(phenylsulfanyl)phenyl]propan-1-one. Commercial products such as Irgacure OXE01, OXE02, OXE03 (all manufactured by BASF Corporation), N-1919 (manufactured by ADEKA Corporation), PBG-314, PBG-317, PBG-326, PBG -327, PBG-329 (manufactured by Changzhou Tronly New Electronic Materials Co., Ltd.) may be used. Among them, O-acyloxime compound is preferably at least one selected from the group consisting of N-acetyloxy-1-[4-(2-hydroxyethyloxy) phenylsulfanylphenyl]propan-1-one-2-imine, N-acetyloxy-1-(4-phenylsulfanylphenyl)-3-cyclohexylpropan-1-one-2-imine, 2-[(acetyloxy)imino]-3-cyclohexyl-1-[4-(phenylsulfanyl)phenyl]propane-1-one, N-benzoyloxy-1-(4-phenylsulfanylphenyl)butan-1-on-2-imine, N-benzoyloxy-1-(4-phenylsulfanylphenyl)octane-1-on-2-imine, N-benzoyloxy-1-(4-phenylsulfanylphenyl)-3-cyclopentylpropan-1-one-2-imine, and more preferably 2-[(acetyloxy)imino]-3-cyclohexyl-1-[4-(phenylsulfanyl)phenyl]propane-1-one, N-benzoyloxy-1-(4-phenylsulfanylphenyl)octane-1-on-2-imine. There is a tendency that these O-acyloxime compounds provide a color filter having a high brightness.

The alkylphenone compound is a compound having a partial structure represented by formula (d2) or (d3). In these partial structures, the benzene ring optionally has a substituent.

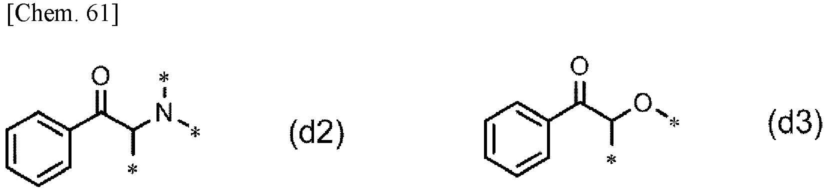

Examples of the compound having a partial structure represented by formula (d2) include 2-methyl-2-morpholino-1-(4-methylsulfanylphenyl)propane-1 -one, 2-dimethylamino-1-(4-morpholinophenyl)-2-benzylbutane-1-one, and 2-(dimethylamino)-2-[(4-methylphenyl)methyl]-1-[4-(4-morpholinyl)phenyl]butane-1-one. Commercially available products such as Irgacures 369, 907, and 379 (all manufactured by BASF Corporation) may be used.

Examples of the compound having a partial structure represented by formula (d3) include 2-hydroxy-2-methyl-1-phenylpropane-1-one, 2-hydroxy-2-methyl-1-[4-(2-hydroxyethoxy)phenyl]propane-1-one, 1-hydroxycyclohexylphenylketone, an oligomer of 2-hydroxy-2-methyl-1-(4-isopropenylphenyl)propane-1-one, α,α-diethoxyacetophenone, and benzyl dimethyl ketal.

The alkylphenone compound is preferably a compound having a partial structure represented by formula (d2) from the viewpoint of sensitivity.

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, and 2,4-bis(trichloromethyl)-6-[2-(3,4-dimethoxyphenyl)ethenyl]-1,3,5-triazine.

Examples of the acylphosphine oxide compound include 2,4,6-trimethylbenzoyldiphenylphosphine oxide. Commercially available products such as Irgacure (registered trademark) 819 (manufactured by BASF Corporation) may be used.

Examples of the biimidazole compound include 2,2'-bis(2-chlorophenyl)-4,4',5,5'-tetraphenylbiimidazole, 2,2'-bis(2,3-dichlorophenyl)-4,4',5,5'-tetraphenylbiimidazole (for example, see Japanese Patent Laid-Open No. H6-75372 and Japanese Patent Laid-Open No. H6-75373), 2,2'-bis(2-chlorophenyl)-4,4',5,5'-tetraphenyl biimidazole, 2,2'-bis(2-chlorophenyl)-4,4',5,5'-tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, see Japanese Patent Publication No. S48-38403 and Japanese Patent Laid-Open No. S62-174204), and a biimidazole compound in which a phenyl group at the 4,4'5,5' position is substituted with a carboalkoxy group (for example, see Japanese Patent Laid-Open No. H7-10913).

Furthermore, examples of the polymerization initiator (D) include benzoin compounds such as benzoin, benzoin methyl ether, benzoin ethyl ether, benzoin isopropyl ether, and benzoin isobutyl ether; benzophenone compounds such as benzophenone, methyl o-benzoylbenzoate, 4-phenylbenzophenone, 4-benzoyl-4'-methyldiphenyl sulfide, 3,3',4,4'-tetra(tert-butylperoxycarbonyl)benzophenone, and 2,4,6-trimethylbenzophenone; quinone compounds such as 9,10-phenanthrene quinone, 2-ethylanthraquinone, and camphorquinone; 10-butyl-2-chloroacridone, benzyl, methyl phenylglyoxylate, and a titanocene compound. These are preferably used in combination with a polymerization initiation aid (D1) (particularly, amines) to be described later.

Examples of a polymerization initiator that generates an acid include onium salts such as 4-hydroxyphenyldimethylsulfonium p-toluenesulfonate, 4-hydroxyphenyldimethylsulfoniumhexafluoroantimonate, 4-acetoxyphenyldimethylsulfonium p-toluenesulfonate, 4-acetoxyphenylmethylbenzylsulfoniumhexafluoroantimonate, triphenylsulfonium p-toluenesulfonate, triphenylsulfonium hexafluoroantimonate, diphenyliodonium p-toluenesulfonate, and diphenyliodoniumhexafluoroantimonate; nitrobenzyl tosylates; and benzoin tosylates.

The polymerization initiator (D) is preferably a polymerization initiator containing at least one selected from the group consisting of an alkylphenone compound, a triazine compound, an acylphosphine oxide compound, an O-acyloxime compound, and a biimidazole compound, and more preferably a polymerization initiator containing an O-acyloxime compound.

The amount of the polymerization initiator (D) is preferably 0.1 to 30 parts by mass, and more preferably 1 to 20 parts by mass, relative to 100 parts by mass of the total amount of the resin (B) and the polymerizable compound (C). When the amount of the polymerization initiator (D) falls within the above-mentioned range, there is a tendency that the sensitivity is increased and the time of exposure to light is shortened, resulting in the improvement in productivity of the color filter.

### <Polymerization Initiation Aid (D1)>

The polymerization initiation aid (D1) is a compound to be used for accelerating polymerization of a polymerizable compound after the polymerization has been started by the polymerization initiator, or a sensitizer. When the polymerization initiation aid (D1) is contained, it is usually used in combination with the polymerization initiator (D).

Examples of the polymerization initiation aid (D1) include an amine compound, an alkoxyanthracene compound, a thioxanthone compound, and a carboxylic acid compound.

Examples of the amine compound include triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, N,N-dimethylparatoluidine, 4,4'-bis(dimethylamino)benzophenone (common name: Michler's ketone), 4,4'-bis(diethylamino)benzophenone, and 4,4'-bis(ethylmethylamino)benzophenone. Among these, 4,4'-bis(diethylamino)benzophenone is preferable. Commercially available products such as EAB-F (manufactured by Hodogaya Chemical Co., Ltd.) may be used.

Examples of the alkoxyanthracene compound include 9,10-dimethoxyanthracene, 2-ethyl-9,10-dimethoxyanthracene, 9,10-diethoxyanthracene, 2-ethyl-9,10-diethoxyanthracene, 9,10-dibutoxyanthracene, and 2-ethyl-9,10-dibutoxy anthracene.

Examples of the thioxanthone compound include 2-isopropylthioxanthone, 4-isopropylthioxanthone, 2,4-diethylthioxanthone, 2,4-dichlorothioxanthone, and 1-chloro-4-propoxythioxanthone.

Examples of the carboxylic acid compound include phenylsulfanylacetic acid, methylphenylsulfanylacetic acid, ethylphenylsulfanylacetic acid, methylethylphenylsulfanylacetic acid, dimethylphenylsulfanylacetic acid, methoxyphenysulfanylacetic acid, dimethoxyphenylsulfanylacetic acid, chlorophenylsulfanylacetic acid, dichlorophenylsulfanylacetic acid, N-phenylglycine, phenoxyacetic acid, naphthylthioacetic acid, N-naphthylglycine, and naphthoxyacetic acid.

When the polymerization initiation aid (D 1) is used, the amount thereof is preferably 0.1 to 30 parts by mass, and more preferably 1 to 20 parts by mass, relative to 100 parts by mass of the total amount of the resin (B) and the polymerizable compound (C). When the amount of the polymerization initiation aid (D1) falls within the above-mentioned range, there is a tendency that the colored pattern can be formed with higher sensitivity, resulting in the improvement in productivity of the color filter.

### <Solvent (E)>

The solvent (E) is not particularly limited, and any solvent that has been used conventionally in the art can be used. Examples of the solvent (E) include an ester solvent (a solvent that contains -COO- but does not contain -O- in its molecule), an ether solvent (a solvent that contains -O- but does not contain -COO- in its molecule), an ether ester solvent (a solvent that contains -COO- and -O- in its molecule), a ketone solvent (a solvent that contains -CO- but does not contain -COO- in its molecule), an alcohol solvent (a solvent that contains OH but does not contain -O-, -CO- nor -COO- in its molecule), an aromatic hydrocarbon solvent, an amide solvent, and dimethyl sulfoxide.

Examples of the ester solvent include methyl lactate, ethyl lactate, butyl lactate, methyl 2-hydroxy isobutanoate, ethyl acetate, n-butyl acetate, isobutyl acetate, pentyl formate, isopentyl acetate, butyl propionate, isopropyl butyrate, ethyl butyrate, butyl butyrate, methyl pyruvate, ethyl pyruvate, propyl pyruvate, methyl acetoacetate, ethyl acetoacetate, cyclohexanol acetate, and γ-butyrolactone.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxy propionate, ethyl 2-ethoxypropionate, methyl 2-methoxy-2-methylpropionate, ethyl 2-ethoxy-2-methylpropionate, 3-methoxybutyl acetate, 3-methyl-3-methoxybutyl acetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, and diethylene glycol monobutyl ether acetate.

Examples of the ketone solvent include 4-hydroxy-4-methyl-2-pentanone, acetone, 2-butanone, 2-heptanone, 3-heptanone, 4-heptanone, 4-methyl-2-pentanone, cyclopentanone, cyclohexanone, and isophorone.

Examples of the alcohol solvent include methanol, ethanol, propanol, butanol, hexanol, cyclohexanol, ethylene glycol, propylene glycol, and glycerin.

Examples of the aromatic hydrocarbon solvent include benzene, toluene, xylene, and mesitylene.

Examples of the amide solvent include N,N-dimethylformamide, N,N-dimethylacetamide, and N-methylpyrrolidone.

The solvent is preferably at least one selected from the group consisting of an ether solvent, an ether ester solvent, and an amide solvent, more preferably contains an ether solvent, an ether ester solvent, and an amide solvent, and further preferably diethylene glycol methylethyl ether, propylene glycol monomethyl ether acetate, and N-methylpyrrolidone.

Among the above solvents, an organic solvent with a boiling point of 120°C to 180°C at 1 atm are preferred in terms of coating and drying properties. Propylene glycol monomethyl ether acetate, ethyl lactate, propylene glycol monomethyl ether, ethyl 3-ethoxypropionate, ethylene glycol monomethyl ether, diethylene glycol monomethyl ether, diethylene glycol monoethyl ether, 4-hydroxy-4-methyl-2-pentanone and N,N-dimethylformamide are preferred, and propylene glycol monomethyl ether acetate, propylene glycol monomethyl ether, ethyl lactate and ethyl 3-ethoxypropionate are preferred.

The content of the solvent (E) is preferably 70 to 95% by mass, and more preferably 75 to 92% by mass, relative to the whole amount of the colored resin composition. In other words, the solid content of the colored resin composition is preferably 5 to 30% by mass, and more preferably 8 to 25% by mass. When the content of the solvent (E) falls within the above-mentioned range, there is a tendency that the flatness during application becomes good and the color density of the color filter formed becomes not insufficient, resulting in the achievement of good displaying properties.

### <Leveling Agent (F)>

Examples of the leveling agent (F) include a silicone-based surfactant, a fluorine-based surfactant, and a silicone-based surfactant having a fluorine atom. These may have a polymerizable group at its side chain.

Examples of the silicone-based surfactant include a surfactant having a siloxane bond in its molecule. Specific examples thereof include Toray Silicone DC3PA, Toray Silicone SH7PA, Toray Silicone DC11PA, Toray Silicone SH21PA, Toray Silicone SH28PA, Toray Silicone SH29PA, Toray Silicone SH30PA, and Toray Silicone SH8400 (trade name; manufactured by Toray Dow Corning Co., Ltd.); KP321, KP322, KP323, KP324, KP326, KP340, and KP341 (manufactured by Shin-Etsu Chemical Co., Ltd.); and TSF400, TSF401, TSF410, TSF4300, TSF4440, TSF4445, TSF4446, TSF4452, and TSF4460 (manufactured by Momentive Performance Materials Inc.).

Examples of the fluorine-based surfactant include a surfactant having a fluorocarbon chain in its molecule. Specific examples thereof include Fluorad (registered trademark) FC430 and Fluorad FC431 (manufactured by Sumitomo 3M, Ltd.); Megafac (registered trademark) F142D, Megafac F171, Megafac F172, Megafac F173, Megafac F177, Megafac F183, Megafac F554, Megafac R30, and Megafac RS-718-K (manufactured by DIC Corporation); Eftop (registered trademark) EF301, Eftop EF303, Eftop EF351, and Eftop EF352 (manufactured by Mitsubishi Materials Electronic Chemicals Co., Ltd.); Surflon (registered trademark) S381, Surflon S382, Surflon SC101, and Surflon SC105 (manufactured by AGC Inc. (former Asahi Glass Co., Ltd.)); and E5844 (manufactured by Daikin Fine Chemical Laboratory).

Examples of the silicone-based surfactant having a fluorine atom include a surfactant having a siloxane bond and a fluorocarbon chain in its molecule. Specific examples thereof include Megafac (registered trademark) R08, Megafac BL20, Megafac F475, Megafac F477, and Megafac F443 (manufactured by DIC Corporation).

The content of the leveling agent (F) is preferably 0.001 to 0.2% by mass, more preferably 0.002 to 0.1% by mass, and further preferably 0.005 to 0.05% by mass, relative to the whole amount of the colored resin composition. This content does not include the content of the pigment dispersant. When the content of the leveling agent (F) falls within the above-mentioned range, the flatness of the color filter can be improved.

### <Other Components>

If required, the colored resin composition may contain an additive known in the art, such as a filler, other polymeric compounds, an adhesion promoter, an antioxidant, a light stabilizer, or a chain transfer agent.

### <Method for Producing Colored Resin Composition>

The colored resin composition can be prepared by, for example, mixing a colorant (A) containing an aluminum phthalocyanine pigment, a compound represented by formula (DA), a resin (B), and a solvent (E), as well as a polymerizable compound (C), a polymerization initiator (D), a leveling agent (F), a polymerization initiation aid (D1), and other components to be used if necessary.

The aluminum phthalocyanine pigment may be contained in advance in a pigment dispersion. By mixing the pigment dispersion with the remaining ingredients so as to obtain a predetermined concentration, an intended colored resin composition can be prepared.

When the colored resin composition contains a dye, the dye may be dissolved in advance in a part or the whole of the solvent (E) to prepare a solution. The solution is preferably filtered with a filter having a pore size of about 0.01 to 1 µm.

The colored resin composition after mixing is preferably filtered with a filter having a pore size of about 0.01 to 10 µm.

### [Color Filter]

Examples of the method for producing a colored pattern of a color filter from the colored resin composition of the present invention include a photolithography method, an inkjet method, and a printing method. Among these methods, a photolithography method is preferable. The photolithography method is a method in which the colored resin composition is applied onto a substrate and then dried to form a composition layer, and the composition layer is then developed by exposing the composition layer to light through a photomask. In the photolithography method, a colored coating film, which is a cured material of the composition layer, can be formed when the photomask is not used during the exposure to light and/or the composition layer is not developed. A colored pattern or a colored coating film formed like this is a color filer of the present invention.

The film thickness of the color filter (colored coating film) is, for example, 30 µm or less, preferably 20 µm or less, more preferably 6 µm or less, further preferably 3 µm or less, further more preferably 1.5 µm or less, and particularly preferably 0.5 µm or less; and preferably 0.1 µm or more, more preferably 0.2 µm or more, and further preferably 0.3 µm or more.

Examples of the substrate to be used include glass substrates such as quartz glass, borosilicate glass, alumina silicate glass, and soda lime glass of which the surface is coated with silica; resin substrates such as polycarbonate, polymethyl methacrylate, and polyethylene terephthalate; silicon; and a substrate obtained by forming an aluminum, silver, or a silver/copper/palladium alloy thin film or the like on any of the aforementioned substrates. On such a substrate, another color filter layer, a resin layer, a transistor, a circuit and the like may be formed. A substrate obtained by subjecting a silicon substrate to HMDS treatment may also be used.

The formation of each color pixel by a photolithography method can be carried out using a known or conventional device under known or conventional conditions. For example, the color pixel can be prepared in the following manner. First, a colored resin composition is applied onto a substrate, and then dried by heat-drying (prebaking) and/or drying under reduced pressure to remove volatile components such as a solvent from the composition, thereby producing a smooth composition layer.

Examples of the application method include a spin coat method, a slit coat method, and a slit-and-spin coat method.

The temperature at heat-drying is preferably 30 to 120°C, and more preferably 50 to 110°C. The time for the heating is preferably 10 seconds to 60 minutes, and more preferably 30 seconds to 30 minutes. When drying under reduced pressure is carried out, the drying procedure is preferably carried out at a temperature range of 20 to 25°C under a pressure of 50 to 150 Pa. The film thickness of the composition layer is not particularly limited, and may be selected appropriately depending on the desired film thickness of the color filter.

Next, the composition layer is exposed to light through a photomask for forming a desired colored pattern. The pattern on the photomask is not particularly limited, and a pattern suitable for the intended application is used.

A light source to be used for the exposure to light is preferably a light source capable of generating light having a wavelength of 250 to 450 nm. For example, light having a wavelength of shorter than 350 nm may be cut with a filter capable of cutting light having this wavelength region, or light having a wavelength of around 436 nm, around 408 nm, or around 365 nm may be extracted selectively with a band-pass filter capable of extracting light having those wavelength regions.

Specific examples of the light source include a mercury lamp, a light-emitting diode, a metal halide lamp, and a halogen lamp. A reduction projection exposure apparatus such as a mask aligner and a stepper, or a proximity exposure apparatus is preferably used because these apparatuses are capable of emitting a parallel light beam uniformly over the whole area of the exposed surface or accurately aligning the photomask to the substrate.

A colored pattern is formed on the substrate by bringing the exposed composition layer into contact with a developing solution to develop the composition layer. By developing, an unexposed area in the composition layer is dissolved in the developing solution and therefore removed. The developing solution is preferably an aqueous solution of an alkaline compound such as potassium hydroxide, sodium hydrogen carbonate, sodium carbonate, or tetramethylammonium hydroxide. The concentration of the alkaline compound in the aqueous solution is preferably 0.01 to 10% by mass, and more preferably 0.03 to 5% by mass. The developing solution may further contain a surfactant. The developing method may be any of a paddle method, a dipping method, a spray method, and the like. Furthermore, during the developing process, the substrate may be inclined at any angle.

After the developing process, the resultant product is preferably washed with water.

Furthermore, the resultant colored pattern is preferably subjected to post-baking. The temperature for the post-baking is preferably 80 to 250°C, and more preferably 100 to 245°C. The time for the post-baking is preferably 1 to 120 minutes, and more preferably 2 to 30 minutes.

The colored pattern and the colored coating film thus produced are useful as a color filter. The color filter is useful as a color filter used for a display devices such as a liquid crystal display device or an organic EL device; an electronic paper; a solid-state image sensor; and the like.

The present application claims benefit of priority based on Japanese Patent No. 2020-150532 filed on September 8, 2020. The entire content of the specification of Japanese Patent No. 2020-150532 filed on September 8, 2020 is incorporated herein by reference.

### EXAMPLES

Hereinafter, the present invention will be described in more detail with reference to Examples. However, of course, the present invention is not limited to the following Examples, and various design variations made in accordance with the purports described hereinbefore and hereinafter are also included in the technical scope of the present invention. In the Examples, the terms "%" and "parts" that represent a content or an amount used are based on mass unless otherwise specified.

The structures of compounds were confirmed by mass spectrometry (MALDI-TOF MS; JMS-S3000 manufactured by JEOL Ltd.).

### <MALDI Conditions>

Matrix: DCTB (trans-2-[3-(4-tert-butylphenyl)-2-methyl-2-propenylidene] malononitrile)
Solvent: THF (containing stabilizer)
Ionization aid: none

### <Synthesis of Colorant>

### [Colorant Synthesis Example 1]

A compound represented by formula (1) was obtained by the synthesis method described in Japanese Laid-Open Patent Publication No. 2016-75837.

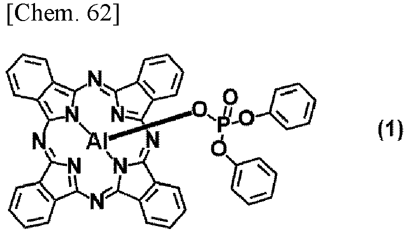

### [Colorant Synthesis Example 2]

A compound represented by formula (2) was obtained by the synthesis method described in Supporting Information of "Synthesis of Nitrogen-Containing Furanose Sugar Nucleotides for Use as Enzymatic Probes" (Org. Lett. 2014, 16, 1, 212-215), Ryan B. Snitynsky et al.

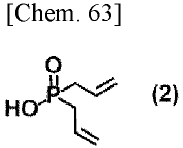

Subsequently, 1.0 part of a compound represented by formula (3) (manufactured by Tokyo Chemical Industry Co., Ltd.), 0.34 parts of the compound represented by formula (2), and 5.0 parts of N-methylpyrrolidone (NMP) (manufactured by FUJIFILM Wako Pure Chemical Corporation) were mixed at room temperature, the temperature of the mixture was raised to 120°C, and the mixture was stirred for 6 hours. The reaction solution was cooled to room temperature, and then 50 parts of ion-exchanged water was added. The resulting precipitate was obtained as the residue of suction filtration, washed with 50 parts of ion-exchanged water, and then dried under reduced pressure while being heated at 60°C to obtain 1.18 parts of a compound represented by formula (4).

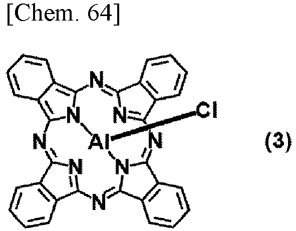

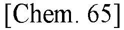

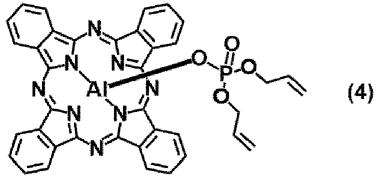

Identification of compound represented by formula (4)
(Mass spectrometry) Ionization mode = MALDI-TOF⁻:
m/z = 716.3
Exact Mass: 716.2

### [Colorant Synthesis Example 3]

In the synthesis method for the compound represented by formula (2) in Colorant Synthesis Example 2, the alcohol used was changed to 3-butene-1-ol to obtain a compound represented by formula (5).

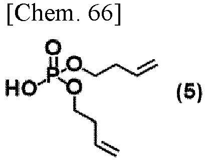

Subsequently, 1.0 part of a compound represented by formula (3) (manufactured by Tokyo Chemical Industry Co., Ltd.), 0.39 parts of the compound represented by formula (5), and 5.0 parts of NMP were mixed at room temperature, the temperature of the mixture was raised to 120°C, and the mixture was stirred for 6 hours. The reaction solution was cooled to room temperature, and then 50 parts of ion-exchanged water was added. The resulting precipitate was obtained as the residue of suction filtration, washed with 50 parts of ion-exchanged water, and then dried under reduced pressure while being heated at 60°C to obtain 1.24 parts of a compound represented by formula (6).

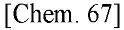

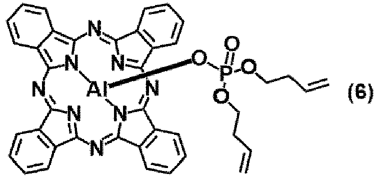

Identification of compound represented by formula (6)
(Mass spectrometry) Ionization mode = MALDI-TOF⁻:
m/z = 744.4
Exact Mass: 744.2

### [Colorant Synthesis Example 4]

In the synthesis of another colorant, 1.5 parts of aluminum chloride (manufactured by FUJIFILM Wako Pure Chemical Corporation), 6.2 parts of 4-tert-butylphthalonitrile (manufactured by Tokyo Chemical Industry Co., Ltd.), 5.1 parts of 1,8-diazabicyclo[5.4.0]-7-undecene (manufactured by Tokyo Chemical Industry Co., Ltd.), and 11 parts of 1-pentanol (manufactured by FUJIFILM Wako Pure Chemical Corporation) were mixed at room temperature, the temperature of the mixture was raised to 160°C, and the mixture was stirred for 13 hours. The reaction solution was cooled to room temperature, and then 63 parts of ethyl acetate was added. The resulting precipitate was obtained as the residue of suction filtration, washed with 89 parts of ion-exchanged water, and then dried under reduced pressure at 60°C to obtain 3.4 parts of a compound represented by formula (7).

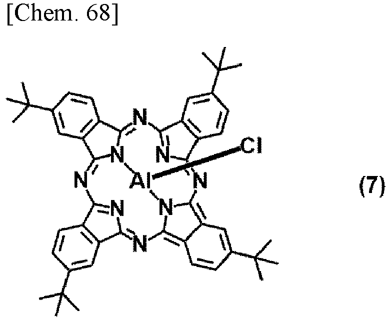

Identification of compound represented by formula (7)
(Mass spectrometry) Ionization mode = MALDI-TOF⁻:
m/z = 798.5
Exact Mass: 798.4

Subsequently, 1.1 parts of the compound represented by formula (7), 0.25 parts of a compound represented by formula (8) ("API-9" manufactured by KATAYAMA CHEMICAL INDUSTRIES Co., Ltd.), and 5.5 parts of NMP were mixed at room temperature, the temperature of the mixture was raised to 120°C, and the mixture was stirred for 7 hours. The reaction solution was cooled to room temperature, and then 28 parts of ion-exchanged water was added. The resulting precipitate was obtained as the residue of suction filtration, washed with 11 parts of methanol, and then dried under reduced pressure at 60°C to obtain 1.2 parts of a compound represented by formula (9).

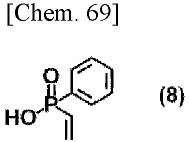

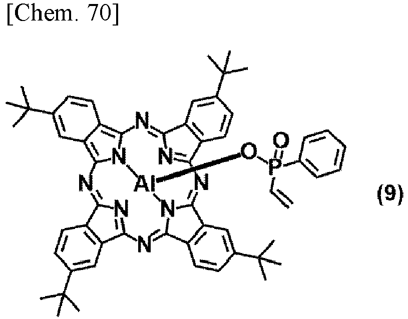

Identification of compound represented by formula (9)
(Mass spectrometry) Ionization mode = MALDI-TOF⁻:
m/z = 930.6
Exact Mass: 930.4

### <Synthesis of resin>

### [Resin Synthesis Example 1]

An appropriate amount of nitrogen was caused to flow into a flask equipped with a reflux cooler, a dropping funnel, and a stirrer, to replace the atmosphere of the flask with a nitrogen atmosphere, and 340 parts of propylene glycol monomethyl ether acetate was added and heated to 80°C while being stirred. Next, a mixed solution of 57 parts of acrylic acid, 54 parts of a mixture of 3,4-epoxy tricyclo[5.2.1.0^{2,6}]decan-8-yl acrylate and 3,4-epoxy tricyclo[5.2.1.0^{2,6}]decan-9-yl acrylate (content ratio was 1:1 in mole ratio), 239 parts of benzyl methacrylate, and 73 parts of propylene glycol monomethyl ether acetate was dropped over 5 hours. Meanwhile, a solution of 40 parts of a polymerization initiator, 2,2-azobis(2,4-dimethylvaleronitrile), in 197 parts of propylene glycol monomethyl ether acetate was dropped over 6 hours. After the drop of the polymerization initiator-containing solution was completed, the solution was kept at 80°C for 3 hours, and then cooled to room temperature to obtain a copolymer (resin (B-1)) solution having a solid content of 36.8% by weight and having a viscosity of 137 mPa·s as measured with a type B viscometer (23°C). The weight-average molecular weight in terms of polystyrene of the produced copolymer was 1.0×10³, the degree of dispersion thereof was 1.97, and the acid value in terms of solid content thereof was 111 mg-KOH/g. The resin (B-1) had the following structural units.

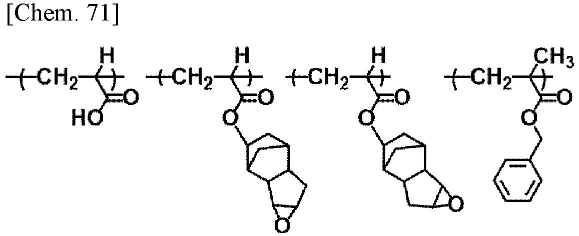

### <Preparation of Dispersion>

### [Dispersion Preparation Example 1]

In the preparation of a dispersion, 5 parts of the compound represented by formula (1), 2 parts of a dispersant (BYKLPN-6919 manufactured by BYK) (in terms of solid content), 2 parts of the resin (B-1) (in terms of solid content), 1 part of a mixture of the compound represented by formula (da-1) and the compound represented by formula (da-2) (content ratio was 5:1 in mole ratio), and 90 parts of propylene glycol monomethyl ether acetate were mixed, 300 parts of 0.2 **µm** zirconia beads were added, and the mixture was shaken for 30 minutes using a paint conditioner (manufactured by LAU). Then, the zirconia beads were removed by filtration to obtain a dispersion (A-1).

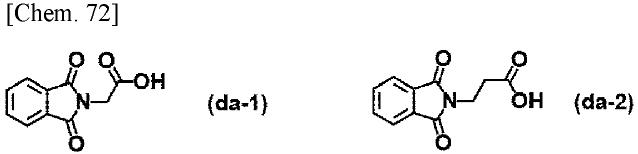

### [Dispersion Preparation Examples 2 to 9]

Dispersions (A-2) to (A-9) were obtained in the same manner as Dispersion Preparation Example 1, except that each component was changed as shown in Table 36.

**[Table 36]**

| | **Dispersion (A-1)** | **Dispersion (A-2)** | **Dispersion (A-3)** | **Dispersion (A-4)** | **Dispersion (A-5)** | **Dispersion (A-6)** | **Dispersion (A-7)** | **Dispersion (A-8)** | **Dispersion (A-9)** |
|---|---|---|---|---|---|---|---|---|---|
| **Compound represented by formula (1)** | **5** | **5** | **5** | **5** | **5** | | | | **5** |
| **Compound represented by formula (4)** | | | | | | **5** | | | |
| **Compound represented by formula (6)** | | | | | | | **5** | | |
| **Compound represented by formula (9)** | | | | | | | | **5** | |
| **Dispersant (BYKLPN-6919)*¹** | **2** | **2** | **2** | **2** | **2** | **4** | **4** | **4** | **2** |
| **Resin (B-1)*¹** | **2** | **2** | **2** | **2** | **2** | **4** | **4** | **4** | **2** |
| **Mixture of compound represented by formula (da-1) and compound represented by formula (da-2)** | **1** | **2** | **3** | **4** | **5** | **5** | **5** | **5** | |
| **Propylene glycol monomethyl ether acetate** | **90** | **89** | **88** | **87** | **86** | **82** | **82** | **82** | **91** |

| | | | | | | | | | |
|---|---|---|---|---|---|---|---|---|---|
| ^{∗}1: in terms of solid content | | | | | | | | | |

### [Dispersion Preparation Examples 10 to 15]

Dispersions (A-10) to (A-15) were obtained in the same manner as Dispersion Preparation Example 1, except that each component was changed as shown in Table 37.

**[Table 37]**

| | **Dispersion (A-10)** | **Dispersion (A-11)** | **Dispersion (A-12)** | **Dispersion (A-13)** | **Dispersion (A-14)** | **Dispersion (A-15)** |
|---|---|---|---|---|---|---|
| **Compound represented by formula (1)** | **5** | **5** | **5** | **5** | **5** | **5** |
| **Dispersant (BYKLPN-23591)*¹** | **2** | **2** | **2** | **2** | **2** | **2** |
| **Resin (B-1)*¹** | **2** | **2** | **2** | **2** | **2** | **2** |
| **Compound represented by formula (da-1)** | **1** | **2** | | | | |
| **Compound represented by formula (da-2)** | | | **1** | **2** | **3** | |
| **Propylene glycol monomethyl ether acetate** | **90** | **89** | **90** | **89** | **88** | **91** |

| | | | | | | |
|---|---|---|---|---|---|---|
| ^{∗}1: in terms of solid content | | | | | | |

### <Preparation of Colored Resin Composition>

### [Colored Resin Composition 1]

A colored resin composition 1 was obtained by mixing the following components.

| | |
|---|---|
| Dispersion (A-1) | 360 parts |
| Resin (B-1) (in terms of solid content) | 44.9 parts |
| Polymerizable compound (C-1): dipentaerythritol polyacrylate: trade name A-9550, SHIN-NAKAMURA CHEMICAL Co., Ltd. | 17.4 parts |
| Polymerizable compound (C-2): trimethylolpropane triacrylate, trade name A-TMPT, SHIN-NAKAMURA CHEMICAL Co., Ltd. | 17.4 parts |
| Polymerization initiator (D): 2-[(acetyloxy)imino]-3-cyclohexyl-1-[4-(phenylsulfanyl)phenyl]propan-1-one, trade name PBG-327, O-acyloxime compound, manufactured by Changzhou Tronly New Electronic Materials Co., Ltd. | 4.34 parts |
| Solvent (E): propylene glycol monomethyl ether acetate | 556 parts |
| Leveling agent (F): polyether-modified silicone oil, trade name Toray Silicone SH8400, manufactured by Dow Corning Toray Co., Ltd. | 0.1 parts |

### [Colored Resin Compositions 2 to 8, Comparative Colored Resin Composition 1]

Colored resin compositions 2 to 8 and a comparative colored resin composition 1 were obtained in the same manner as the colored resin composition 1, except that each component was changed as shown in Table 38.

**[Table 38]**

| | **Colored resin composition 1** | **Colored resin composition 2** | **Colored resin composition 3** | **Colored resin composition 4** | **Colored resin composition 5** | **Colored resin composition 6** | **Colored resin composition 7** | **Colored resin composition 8** | **Comparative colored resin composition 1** |
|---|---|---|---|---|---|---|---|---|---|
| **Dispersion (A-1)** | **360** | | | | | | | | |
| **Dispersion (A-2)** | | **360** | | | | | | | |
| **Dispersion (A-3)** | | | **360** | | | | | | |
| **Dispersion (A-4)** | | | | **360** | | | | | |
| **Dispersion (A-5)** | | | | | **360** | | | | |
| **Dispersion (A-6)** | | | | | | **360** | | | |
| **Dispersion (A-7)** | | | | | | | **360** | | |
| **Dispersion (A-8)** | | | | | | | | **360** | |
| **Dispersion (A-9)** | | | | | | | | | **360** |
| **Resin (B-1)^{*1}** | **44.9** | **42.8** | **40.8** | **38.7** | **36.6** | **25.3** | **25.3** | **25.3** | **46.9** |
| **Polymerizable compound (C-1)** | **17.4** | **16.7** | **16.0** | **15.3** | **14.6** | **13.2** | **13.2** | **13.2** | **18.0** |
| **Polymerizable compound (C-2)** | **17.4** | **16.7** | **16.0** | **15.3** | **14.6** | **13.2** | **13.2** | **13.2** | **18.0** |
| **Polymerization initiator (D)** | **4.34** | **4.17** | **4.00** | **3.83** | **3.65** | **3.31** | **3.31** | **3.31** | **4.50** |
| **Solvent (E)** | **556** | **560** | **563** | **567** | **570** | **585** | **585** | **585** | **552** |
| **Leveling agent (F)** | **0.1** | **0.1** | **0.1** | **0.1** | **0.1** | **0.1** | **0.1** | **0.1** | **0.1** |
| **Evaluation of foreign matter in coating film** | **∘** | **∘** | **∘** | **∘** | **∘** | **∘** | **∘** | **∘** | **×** |

| | | | | | | | | | |
|---|---|---|---|---|---|---|---|---|---|
| ^{∗}1: in terms of solid content | | | | | | | | | |

### [Colored Resin Compositions 9 to 13, Comparative Colored Resin Composition 2]

Colored resin compositions 9 to 13 and a comparative colored resin composition 2 were obtained in the same manner as the colored resin composition 1, except that each component was changed as shown in Table 39.

**[Table 39]**

| | **Colored resin composition 9** | **Colored resin composition 10** | **Colored resin composition 11** | **Colored resin composition 12** | **Colored resin composition 13** | **Comparative colored resin composition 2** |
|---|---|---|---|---|---|---|
| **Dispersion (A-10)** | **360** | | | | | |
| **Dispersion (A-11)** | | **360** | | | | |
| **Dispersion (A-12)** | | | **360** | | | |
| **Dispersion (A-13)** | | | | **360** | | |
| **Dispersion (A-14)** | | | | | **360** | |
| **Dispersion (A-15)** | | | | | | **360** |
| **Resin (B-1)*¹** | **44.9** | **42.8** | **44.9** | **42.8** | **40.8** | **46.9** |
| **Polymerizable compound (C-1)** | **17.4** | **16.7** | **17.4** | **16.7** | **16.0** | **18.0** |
| **Polymerizable compound (C-2)** | **17.4** | **16.7** | **17.4** | **16.7** | **16.0** | **18.0** |
| **Polymerization initiator (D)** | **4.34** | **4.17** | **4.34** | **4.17** | **4.00** | **4.51** |
| **Solvent (E)** | **556** | **560** | **556** | **560** | **563** | **552** |
| **Leveling agent (F)** | **0.07** | **0.07** | **0.07** | **0.07** | **0.07** | **0.07** |
| **Evaluation of foreign matter in coating film** | **∘** | **∘** | **∘** | **∘** | **∘** | **×** |
| **Adhesion evaluation** | **∘** | **∘** | **∘** | **∘** | **∘** | **×** |

| | | | | | | |
|---|---|---|---|---|---|---|
| ^{∗}1: in terms of solid content | | | | | | |

### <Evaluation of Foreign Matter in Coating Film>

### [Formation of Colored Coating Film]

The colored resin compositions prepared as the colored resin compositions 1 to 8 and 9 to 13 and the comparative colored resin compositions 1 and 2 were each applied onto a 5 cm square glass substrate (Eagle 2000; manufactured by Corning Incorporated) by a spin-coating method, and then pre-baked at 90°C for 2 minutes to form a colored composition layer. After cooling, the colored composition layer was irradiated with light using an exposure machine (TME-150RSK; manufactured by TOPCON CORPORATION) at an exposure dose of 60 mJ/cm² (365 nm standard) under an air atmosphere. Then, the colored composition layer was post-baked at 230°C for 5 minutes to obtain a colored coating film.

### [Observation of Coating Film Properties]

For the obtained colored coating film on the glass substrate, the presence or absence of foreign matter (coarse particles) in the colored coating film was checked using a laser microscope (LEXT OLS4100; manufactured by Olympus Corporation).
∘: No foreign matter was observed.
×: Foreign matter was observed.

As shown in Tables 38 and 39, no foreign matter was observed in the colored coating films of the colored resin compositions 1 to 8 and 9 to 13. On the other hand, many foreign matters were observed in the colored coating films of the comparative colored resin compositions 1 and 2.

### <Adhesion Evaluation>

### [Formation of dot pattern]

The colored resin compositions prepared as the colored resin compositions 9 to 13 and the comparative colored resin composition 2 were each applied onto a 4-inch silicon wafer (manufactured by Rokko Electronics Co., Ltd.) by a spin-coating method, and then pre-baked at 90°C for 2 minutes to form a colored composition layer. After cooling, the colored composition layer was irradiated with light using an exposure machine (NSR-2205i11D; manufactured by NIKON CORPORATION, NA = 0.63, σ = 0.60) at an exposure dose of 400 mJ/cm² (365 nm standard) under an air atmosphere. For the light irradiation, an exposure mask was placed between an irradiation light source and the substrate, and the colored composition layer was irradiated such that a 0.9 µm dot pattern (pitch: 1.8 µm) was formed thereon. Then, the colored composition layer was developed and then post-baked at 230°C for 5 minutes to obtain a colored coating film.

### [Confirmation of adhesion]

For the obtained colored coating film on the glass substrate, the dot pattern was observed using a laser microscope (LEXT OLS4100; manufactured by Olympus Corporation). The higher the adhesion between the substrate and the colored coating film is, the more easily the dot pattern remains on the substrate, and the lower the adhesion is, the more easily the dot pattern is peeled off from the substrate.
∘: A 0.9 µm dot pattern was formed and was not peeled.
Δ: A 0.9 µm dot pattern was formed, but peeling was observed in some parts.
×: The entire 0.9 µm dot pattern was peeled off from the substrate.

In the comparative colored resin composition 2, the entire 0.9 µm dot pattern was peeled off from the substrate (evaluation: ×). On the other hand, in the colored resin compositions 9 to 13, a 0.9 µm dot pattern was formed and was not peeled (evaluation: ∘). From comparison between the comparative colored resin composition 2 and the colored resin compositions 9 to 13, it is found that, when the amount of the compound represented by formula (DA) relative to 100 parts by mass of the aluminum phthalocyanine pigment is preferably not less than 1 part by mass (more preferably not less than 10 parts by mass and further preferably not less than 15 parts by mass), a colored coating film having higher adhesion to a substrate is formed.

## Claims

1. A colored resin composition comprising a colorant, a compound represented by formula (DA), a resin, and a solvent, wherein the colorant comprises an aluminum phthalocyanine pigment. 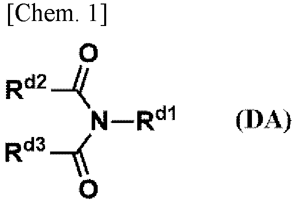 [In formula (DA),
R^{d1} represents a hydrocarbon group having 1 to 12 carbon atoms and optionally having a substituent. When the hydrocarbon group has 2 to 12 carbon atoms and the hydrocarbon group has -CH₂-, -CH₂- may be substituted with -O-, -S- or -CO-.
R^{d2} and R^{d3} each independently represent a hydrogen atom or a hydrocarbon group having 1 to 12 carbon atoms and optionally having a substituent, or R^{d2} and R^{d3} are combined to form a ring together with -CO-NR^{d1}-CO-.]

2. The colored resin composition according to claim 1, wherein the aluminum phthalocyanine pigment is a compound represented by formula (Xa) or formula (Xb). 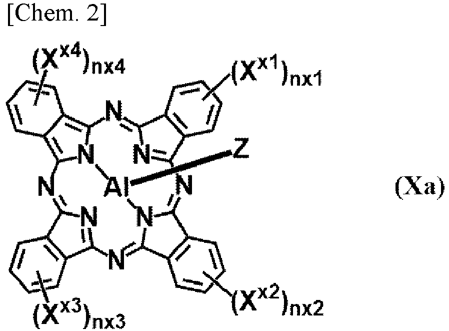 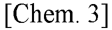 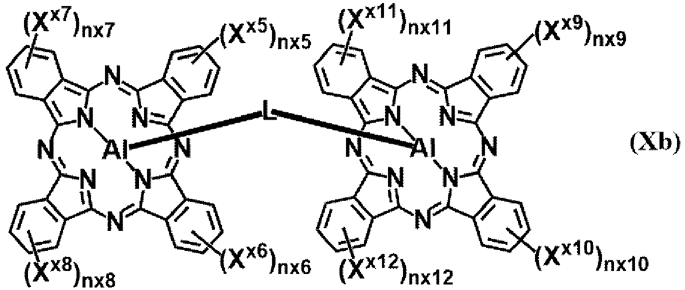
[In formula (Xa),
Z represents a hydroxy group, a chlorine atom, -OP(=O)R^{a1}R^{a2}, or -O-SiR^{a3}R^{a4}R^{a5}.
R^{a1} to R^{a5} each independently represent a hydrogen atom, a hydroxy group, a hydrocarbon group having 1 to 21 carbon atoms and optionally having a substituent, and any two of R^{a1} and R^{a2} or R^{a3} to R^{a5} may be combined with each other to form a ring. When the hydrocarbon group has 2 to 21 carbon atoms and the hydrocarbon group has -CH₂-, -CH₂- may be substituted with -O-, -S- or -CO-.
X^{x1} to X^{x4} each independently represent -R^{x4}, -OR^{x4}, -SR^{x4}, a halogen atom, a nitro group, or a sulfamoyl group optionally having a substituent.
R^{x4} represents a hydrocarbon group having 1 to 20 carbon atoms and optionally having a substituent, and when the hydrocarbon group has 2 to 21 carbon atoms and the hydrocarbon group has -CH₂-, -CH₂- may be substituted with -O-, -S- or -CO-.
nx1 to nx4 independently represent an integer from 0 to 4.
In formula (Xb),
L represents -O-SiR^{a6}R^{a7}-O-, -O-SiR^{a8}R^{a9}-O- SiR^{a10}R^{a11}-O-, or -O-P(=O)R^{a12}-O-.
R^{a6} to R^{a12} each independently represent a hydrogen atom, a hydroxy group, a hydrocarbon group having 1 to 21 carbon atoms and optionally having a substituent, and R^{a6} and R^{a7}, R^{a8} and R^{a9}, or R^{a10} and R^{a11} may be combined with each other to form a ring. When the hydrocarbon group has 2 to 21 carbon atoms and the hydrocarbon group has -CH₂-, -CH₂- may be substituted with -O-, -S- or -CO-.
X^{x5} to X^{x12} each independently represent -R^{x5}, -OR^{x5}, -SR^{x5}, a halogen atom, a nitro group, or a sulfamoyl group optionally having a substituent.
R^{x5} represents a hydrocarbon group having 1 to 20 carbon atoms and optionally having a substituent.
nx5 to nx12 each independently represent an integer from 0 to 4.]

3. The colored resin composition according to claim 2, wherein the compound represented by formula (Xa) is a compound represented by formula (XI) and the compound represented by formula (Xb) is a compound represented by formula (XII). 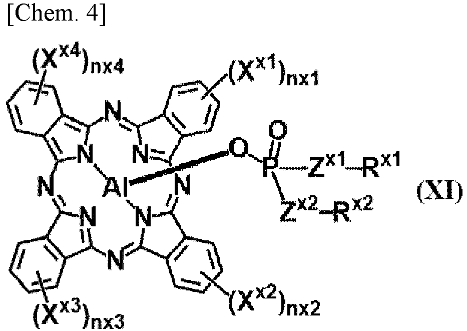 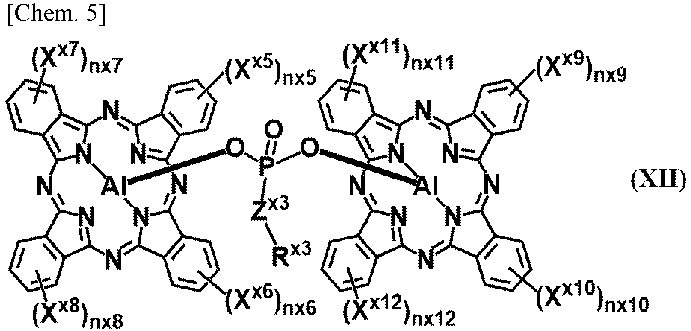
[In formula (XI),
R^{x1} represents an unsaturated hydrocarbon group having 2 to 20 carbon atoms and optionally having a substituent or an aromatic hydrocarbon group having 6 to 20 carbon atoms and optionally having a substituent, and R^{x2} represents a hydrogen atom, a hydrocarbon group having 1 to 20 carbon atoms and optionally having a substituent or a single bond linking Z^{x2} and R^{x1}.
Z^{x1} and Z^{x2} each independently represent a single bond or an oxygen atom.
X^{x1} to X^{x4} and nx1 to nx4 are the same as above.
In formula (XII),
R^{x3} represents an unsaturated hydrocarbon group having 2 to 20 carbon atoms and optionally having a substituent or an aromatic hydrocarbon group having 6 to 20 carbon atoms and optionally having a substituent.
Z^{x3} represents a single bond or an oxygen atom.
X^{x5} to X^{x12} and nx5 to nx12 are the same as above.]

4. The colored resin composition according to claim 1, wherein the aluminum phthalocyanine pigment is a compound represented by formula (YI) or formula (YII). 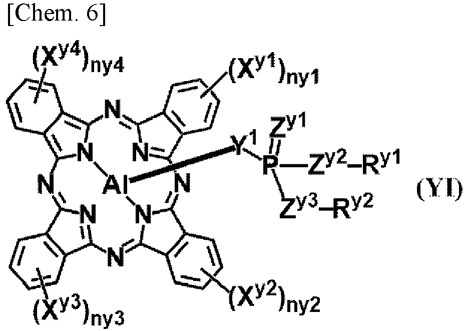 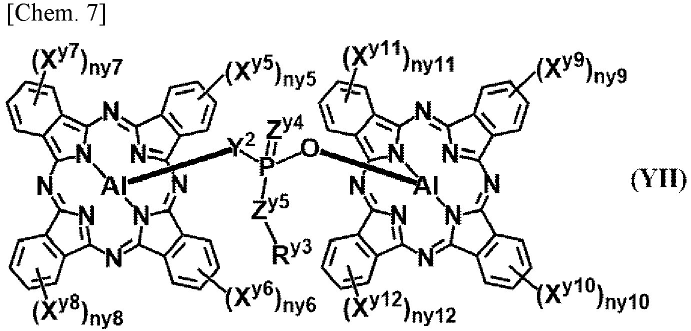
[In formula (YI),
R^{y1} represents a hydrogen atom or a hydrocarbon group having from 1 to 20 carbon atoms and optionally having a substituent.
R^{y2} represents a hydrogen atom, a hydrocarbon group having 1 to 20 carbon atoms and optionally having a substituent, or a single bond linking Z^{y3} and R^{y1}.
Y¹ and Z^{y1} each independently represent an oxygen atom or a sulfur atom.
Z^{y2} and Z^{y3} each independently represent a single bond, an oxygen atom or a sulfur atom.
At least one of Y¹, Z^{y1}, Z^{y2} and Z^{y3} represents a sulfur atom.
X^{y1} to X^{y4} each independently represent -R^{y4}, -OR^{y4}, -SR^{y4}, a halogen atom, a nitro group or a sulfamoyl group optionally having a substituent.
R^{y4} represents a hydrocarbon group having 1 to 20 carbon atoms and optionally having a substituent.
ny1 to ny4 each independently represent an integer from 0 to 4.
In formula (YII),
R^{y3} represents a hydrogen atom or a hydrocarbon group having 1 to 20 carbon atoms and optionally having a substituent.
Y² and Z^{y4} each independently represent an oxygen atom or a sulfur atom.
Z^{y5} represents a single bond, an oxygen atom or a sulfur atom.
At least one of Y², Z^{y4} and Z^{y5} represents a sulfur atom.
X^{y5} to X^{y12} independently represent -R^{y5}, -OR^{y5}, -SR^{y5}, a halogen atom, a nitro group or a sulfamoyl group optionally having a substituent.
R^{y5} represents a hydrocarbon group having 1 to 20 carbon atoms and optionally having a substituent.
ny5 to ny12 each independently represent an integer from 0 to 4.]

5. The colored resin composition according to any one of claims 1 to 4 further comprising a polymerizable compound and a polymerization initiator.

6. A color filter formed from the colored resin composition according to any one of claims 1 to 5.

7. A display device comprising the color filter according to claim 6.

8. A solid-state image sensor comprising the color filter according to claim 6.
